# EUROPEAN PATENT SPECIFICATION

(11) **EP 2 434 343 B1**
(45) Date of publication and mention of the grant of the patent: **15.05.2019**
(21) Application number: 11183085.7
(22) Date of filing: 28.09.2011
(51) Int. Cl.: G03F 7/004, G03F 7/039, G03F 7/20

(54) **Resist composition, resist film therefrom and method of forming pattern therewith**
Resistzusammensetzung, Resistschicht daraus und Verfahren zur Strukturformung damit
Composition de photoréserve, film de photoréserve correspondant et procédé de formation d'un motif

(30) Priority: 28.09.2010 JP 2010216956; 27.09.2011 JP 2011210645
(43) Date of publication of application: 28.03.2012
(73) Proprietor: Fujifilm Corporation, Minato-ku Tokyo 106-8620 (JP)
(72) Inventor: Yamamoto, Kei, Shizuoka-ken 106-8620 (JP); Iizuka, Yusuke, Shizuoka-ken 106-8620 (JP); Shibuya, Akinori, Shizuoka-ken 106-8620 (JP); Yamaguchi, Shuhei, Shizuoka-ken 106-8620 (JP)
(74) Representative: Hoffmann Eitle

(56) References cited:
- EP-A1- 2 088 466
- EP-A1- 2 615 497
- WO-A1-2010/035894
- WO-A1-2010/035909
- JP-A- 2010 039 145
- TW-A- 201 033 732
- US-A1- 2009 263 742

## Description

The present invention relates to a resist composition, a resist film therefrom and a method of forming a pattern using the composition. More particularly, the present invention relates to a resist composition that finds application in, for example, a semiconductor production process for an IC or the like, a circuit board production process for a liquid crystal, a thermal head or the like and other photofabrication lithography processes, and also to a resist film from the composition and a method of forming a pattern using the composition..

The shortening of the wavelength of an exposure light source and the realization of high numerical apertures (high NA) for projector lenses have been advanced in accordance with the miniaturization of semiconductor elements. It is heretofore known to, for achieving the enhancement of resolving power by further wavelength shortening, employ a method in which the space between a projector lens and a sample is filled with a liquid of high refractive index (hereinafter also referred to as an "immersion liquid"), generally called a liquid-immersion method. The liquid-immersion method is effective in all pattern shapes. Further, this method can be combined with a super-resolution technology, such as a phase shift method or a modified illumination method, now under study.

Since the development of the resist for a KrF excimer laser (248 nm), it has been of common practice to, in order to compensate for any sensitivity deterioration caused by light absorption, employ an image forming method through chemical amplification as a resist image forming method. Brief description of a positive image forming method through chemical amplification is given below by way of example. Upon exposure to light, an acid generator is decomposed in exposed areas to thereby generate an acid. At the bake after the exposure (Post-Exposure Bake: PEB), the generated acid is used as a reaction catalyst so that an alkali-insoluble group is converted to an alkali-soluble group. Thereafter, alkali development is carried out to thereby remove the exposed areas. Thus, the relevant image forming method is provided.

The resist for an ArF excimer laser (193 nm) utilizing this chemical amplification mechanism is now becoming mainstream. In this connection, when the exposure is performed by means of a scan-type liquid-immersion exposure machine, the exposure speed is decreased in the event that the immersion liquid fails to move while tracking a moving lens. Thus, an adverse influence thereof on productivity is concerned.

When the immersion liquid is, for example, water, it is preferred for the resist film to be hydrophobic from the viewpoint of superiority in water tracking properties. When the hydrophobicity of the resist film is poor, water tracking is unsatisfactory resulting in the occurrence of defects known as watermark defects.

On the other hand, the scan speed of the liquid-immersion exposure machine is becoming higher than the conventional speed in order to attain an increase of device productivity, so that the problem of unsatisfactory water tracking is anticipated. Therefore, an improvement in the watermark defect performance is required.

Further, when the exposure is carried out using the liquid-immersion exposure machine, a resist pattern realizing a high resolution of 0.1 µm or less is required. In particular, from the viewpoint of attaining a favorable pattern transfer by dry etching, it is needed for the shape of the resist pattern to be rectangular. Now, the demand for a favorable pattern transfer by dry etching is increasing in accordance with the miniaturization of pattern dimension in recent years, so that an improvement in the rectangularity of the shape of the resist pattern is required.

Patent reference 1 discloses that the immersion-liquid water tracking properties and line edge roughness are enhanced by adding a specified resin containing a fluorine/silicon atom.

Patent reference 2 discloses that a filtering operation is carried out using a filter provided with a filtration membrane of nylon in the production of a positive resist composition comprising an acid-decomposable resin with a specified structure, a photoacid generator and a solvent.

Patent reference 3 discloses a chemically amplified photoresist composition comprising an acid-decomposable resin with a specified structure and a photoacid generator with a specified structure.

Patent reference 4 discloses a radiation-sensitive resin composition comprising a resin containing an acid-dissociative group with a specified structure, a radiation-sensitive acid generator and a solvent.

Patent reference 5 discloses a radiation-sensitive composition comprising a compound with a specified structure in which an acid-dissociative group is contained and a radiation-sensitive acid generator.

Patent reference 6 discloses a positive resist composition comprising a specified compound that when exposed to actinic rays or radiation, generates a sulfonic acid having an ester structure and containing a fluorine atom and an acid-decomposable resin whose glass transition temperature is 150°C or below.

Patent reference 7 discloses a composition comprising a compound that when exposed to actinic rays or radiation, generates an acid with a specified structure and an acid-decomposable resin containing a repeating unit with a specified structure.

Patent reference 8 discloses a positive resist composition for liquid-immersion exposure comprising an acid-decomposable resin, a photoacid generator, a hydrophobic resin and a mixed solvent in which a solvent with a specified structure is contained in an amount of 3 to 20 mass%.

However, the current situation is that finding an appropriate combination of employed resin, photoacid generator, liquid-immersion additive (hydrophobic resin), solvent, etc. from the viewpoint of the overall performance as a resist is extremely difficult.

TW-A-201 033 732 relates to an actinic ray-sensitive or radiation-sensitive resin composition, capable of forming a resist pattern improved in the elution of a generated acid, line edge roughness, development defects and generation of scum.

US-A-2009/263742 relates to a chemically amplified positive resist composition.

JP-A-2010-039145 discloses a positive resist composition which comprises a compound which generates a specific sulfonic acid having a fluorine atom and an ester bond upon irradiation with actinic rays or radiation. The composition further comprises a first resin whose solubility in an alkali developer increases under the action of an acid, and a resin having a fluorine and/or a silicon atom.

WO-A-2010/035909 discloses a positive photosensitive composition comprising a resin (A) having repeating units represented by defined general formulae and whose solubility in an alkali developer is increased by the action of an acid, a compound (B) which generates an acid upon irradiation with actinic rays or radiation, and a solvent.

EP-A-2615497, prior art pursuant to Article 54(3) EPC, discloses a radiation-sensitive resin composition comprising a polymer that changes in polarity and decreases in solubility in an organic solvent due to an acid.

### [Citation List]

### [Patent Literature]

[Patent reference 1] Jpn. Pat. Appln. KOKAI Publication No. (hereinafter referred to as JP-A-) 2007-304545,
[Patent reference 2] JP-A-2009-244425,
[Patent reference 3] JP-A-2010-134445,
[Patent reference 4] JP-A-2010-066631,
[Patent reference 5] JP-A-2010-128432,
[Patent reference 6] JP-A-2010-039146,
[Patent reference 7] JP-A-2010-138330, and
[Patent reference 8] JP-A-2010-102329.

It is an object of the present invention to provide a resist composition capable of realizing not only the reduction of watermark defects but also the formation of a resist pattern of favorable shape. It is another object of the present invention to provide a resist film produced from the composition and a method of forming a pattern using the composition.

According to a first aspect, the present invention provides a resist composition comprising:
(A) a resin that decomposes when acted on by an acid to thereby increase its solubility in an alkali developer, wherein the resin has a repeating unit with an acid-decomposable group according to General Formula (AI) below;
(B) a compound according to General Formulae (I) or (II) below that generates an acid when exposed to actinic rays or radiation, the compound having a fluorine content of 0.15 or less when calculated from (total mass of all fluorine atoms contained)/(total mass of all atoms contained);
(C) a resin containing at least either a fluorine atom or a silicon atom; and
(D) a mixed solvent comprising 5 to 20 mass %, based on the mixed solvent, of a solvent exhibiting a normal boiling point of 200°C or higher; 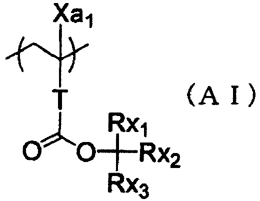
   wherein Xa₁ represents a hydrogen atom, an optionally substituted methyl group, or a group represented by -CH₂-R₉;
   Rg represents a hydroxyl group or a monovalent organic group;
   T represents a single bond or a bivalent connecting group;
   each of Rx₁ to Rx₃ independently represents a linear or branched alkyl group or a monocyclic or polycyclic cycloalkyl group, provided that at least two of Rx₁ to Rx₃ are bonded together to form a monocyclic cycloalkyl group having 5 or 6 carbon atoms; 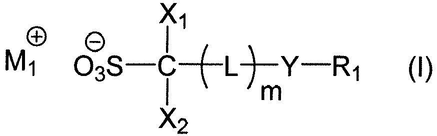
   wherein X₁ and X₂ each independently represents a fluorine atom or a fluoroalkyl group;
   each L independently represents a bivalent connecting group;
   m is an integer of 0 or greater;
   Y represents -CO-, -COO-, -OCO-, -CON(R₂)-, -O-, -S-, -SO-, -SO₂-, -OSO₂-, -SO₂O- or a combination of two or more of these;
   R₁ and R₂ each independently represents a hydrogen atom, an alkyl group or a group with a cyclic structure, provided that R₁ and R₂ are not both hydrogen atoms, and provided that R₁ and R₂ may be bonded to each other to form a ring, and
   M₁⁺ represents a cation; and 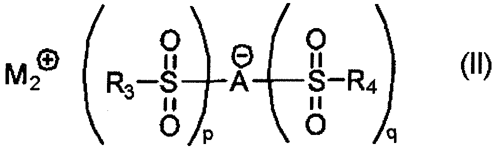
   wherein A represents a nitrogen atom or a carbon atom, provided that when A is a nitrogen atom, p+q=2, p is 1 or 2, and q is 0 or 1, and provided that when A is a carbon atom, p+q=3, p is an integer of 1 to 3, and q is an integer of 0 to 2;
   R₃ represents a monovalent organic group containing a fluorine atom, the monovalent organic group exhibiting a fluorine content of 0.35 or below when calculated from (total mass of all fluorine atoms contained) / (total mass of all atoms contained), provided that when p≥ 2 a plurality of R₃s may be identical to or different from each other, and provided that in that instance, a plurality of R₃s may be bonded together to form a ring, and provided that when a plurality of R₃s are bonded together to form a ring, the above fluorine content refers to a value calculated with respect to a bivalent group constructing the ring;
   R₄ represents a group containing an electron withdrawing group, provided that when q=2, two R₄s may be identical to or different from each other;
   when q≥ 1, R₃ and R₄ may be bonded together to form a ring, provided that in that instance, the above fluorine content refers to a value calculated with respect to a bivalent group constructing the ring formed by R₃ and R₄; and
   M₂⁺ represents a cation.

Preferably Y is -CON(R₂)- in General Formula (I).

Preferably the mixed solvent (D) contains a solvent according to any of General Formulae (S1) to (S3) below as the solvent exhibiting a normal boiling point of 200°C or higher, 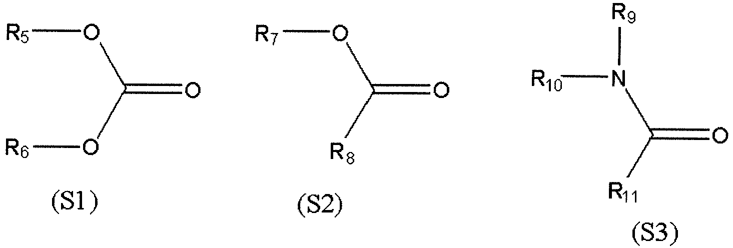 wherein R₅ to R₁₁ each independently represents an alkyl group, a cycloalkyl group or an aryl group, provided that R₅ and R₆, R₇ and R₈, and R₁₀ and R₁₁ may be bonded together to form a ring.

Preferably the resin (C) contains a repeating unit containing a group that when acted on by an alkali developer, is decomposed to thereby increase its solubility in the alkali developer.

Preferably the resin (C) contains a repeating unit containing a partial structure according to General Formula (KY-0): 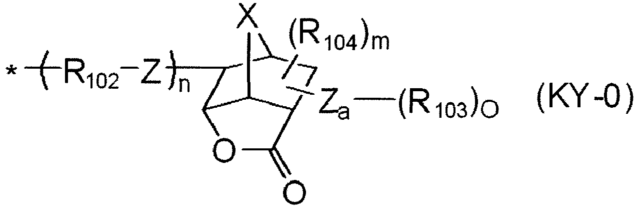
wherein each R₁₀₂ independently represents an alkylene group or a cycloalkylene group;
each R₁₀₃ independently represents a hydrocarbon group whose hydrogen atoms on constituent carbons are partially or entirely replaced with fluorine atoms;
each R₁₀₄ independently represents a halogen atom, a cyano group, a hydroxyl group, an amido group, an alkyl group, a cycloalkyl group, an alkoxy group, a phenyl group, an acyl group, an alkoxycarbonyl group or any of the groups of the formula R-C(=O)- or R-C(=O)O- in which R is an alkyl group or a cycloalkyl group, provided that when m≥ 2, two or more R₁₀₄s may be bonded together to form a ring;
X represents an alkylene group, a cycloalkylene group, an oxygen atom or a sulfur atom;
Z and Za each independently represents a single bond, an ether bond, an ester bond, an amido bond, a urethane bond or a urea bond, provided that when n≥ 2, a plurality of Zs may be identical to or different from each other;
* represents a point of attachment to the principal chain or a side chain of the resin (C);
o is an integer of 1 to 7;
m is an integer of 0 to 7; and
n is an integer of 0 to 5.

Preferably the resin (A) contains a repeating unit with a lactone structure substituted with a cyano group.

Preferably the cation M₁⁺ or M₂⁺ in compound (B) is represented by General Formula (ZI-4): 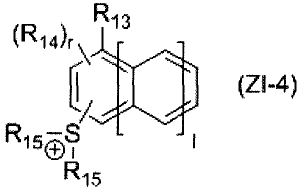
wherein R₁₃ represents a hydrogen atom, a fluorine atom, a hydroxyl group, an alkyl group, a cycloalkyl group, an alkoxy group, an alkoxycarbonyl group or a group with a cycloalkyl skeleton of a single ring or multiple rings;
each R₁₄ independently represents an alkyl group, a cycloalkyl group, an alkoxy group, an alkoxycarbonyl group, an alkylcarbonyl group, an alkylsulfonyl group, a cycloalkylsulfonyl group or a group with a cycloalkyl skeleton of a single ring or multiple rings;
each R₁₅ independently represents an alkyl group, a cycloalkyl group or a naphthyl group, provided that the two R₁₅s may be bonded to each other to thereby form a ring;
1 is an integer of 0 to 2; and
r is an integer of 0 to 8.

According to a second aspect, the present invention provides a resist film formed from the composition of the above first aspect.

According to a third aspect, the present invention provides a pattern-forming method comprising forming the composition according to the above first aspect into a film, exposing the film to light, and developing the exposed film.

Preferably the exposure is performed through an immersion liquid.

According to a fourth aspect, the present invention provides a process for manufacturing an electronic device, wherein the process comprises the pattern-forming method in accordance with the above third aspect.

The present invention has made it feasible to provide a resist composition capable of realizing not only the reduction of watermark defects but also the formation of a resist pattern of favorable shape and also to provide a resist film produced from the composition and a method of forming a pattern using the composition.

Embodiments of the present invention will be described in detail below.

Herein, the groups and atomic groups for which no statement is made as to substitution or nonsubstitution are to be interpreted as including those containing no substituents and also those containing substituents. For example, the "alkyl groups" for which no statement is made as to substitution or nonsubstitution are to be interpreted as including not only the alkyl groups containing no substituents (unsubstituted alkyl groups) but also the alkyl groups containing substituents (substituted alkyl groups).

Further, the term "actinic rays" or "radiation" means, for example, brightline spectra from a mercury lamp, far ultraviolet represented by an excimer laser, extreme ultraviolet (EUV), X-rays and electron beams (EB). Herein, the term "light" means actinic rays or radiation. The term "exposure to light" unless otherwise specified means not only irradiation with light, such as light from a mercury lamp, far ultraviolet, X-rays or EUV light, but also lithography using particle beams, such as electron beams and ion beams.

The resist composition of the present invention comprises (A) a resin that when acted on by an acid, is decomposed to thereby increase its solubility in an alkali developer (hereinafter also referred to as an acid-decomposable resin), (B) a compound that when exposed to actinic rays or radiation, generates an acid (hereinafter also referred to as a photoacid generator), (C) a resin containing at least either a fluorine atom or a silicon atom (hereinafter also referred to as a hydrophobic resin), and (D) a solvent.

In this resist composition, as will be described in detail below, a mixed solvent containing a solvent exhibiting a normal boiling point of 200 °C or higher is used as the solvent. The inventors have found that the uneven distribution of the hydrophobic resin in the surface is enhanced by employing this formulation. Namely, the inventors have found that the hydrophobicity of the film formed from the resist composition is enhanced by employing this formulation, thereby attaining the reduction of watermark defects.

However, as a result of further studies, it has become apparent that when the above solvent is used in combination with common photoacid generators, the pattern shape is rounded to thereby cause the formation of a rectangular pattern to be difficult. Namely, in that instance, it has become apparent that simultaneously realizing the reduction of watermark defects and the formation of a rectangular pattern is difficult.

Therefore, the inventors have conducted extensive and intensive studies to resolve this problem. As a result, it has been found that this problem is attributed to an excessive generation of acid in the vicinity of the surface of the film caused by the same uneven distribution of the photoacid generator in the surface of the film as occurring with respect to the hydrophobic resin. As a result of further studies, the inventors have found that simultaneously realizing the reduction of watermark defects and the formation of a rectangular pattern can be attained by using the above solvent in combination with the photoacid generator with a specified structure to be described in detail hereinafter.

The above components (A) to (D) will be described in sequence below.

### (A) Acid-decomposable resin

The resist composition of the present invention contains an acid-decomposable resin (hereinafter also
referred to as "resin (A)").

In the resin (A), a group that is decomposed by the action of an acid to thereby produce an alkali-soluble group (hereinafter also referred to as "acid-decomposable group") is introduced in the principal chain or side chain, or both the principal chain and the side chain, of the resin.

The resin (A) is preferably insoluble or hardly soluble in an alkali developer.

The acid-decomposable group has a structure in which a carboxyl group is protected by a group removable by degradation upon the action of acid.

The repeating unit with an acid-decomposable group has the following general formula (AI). 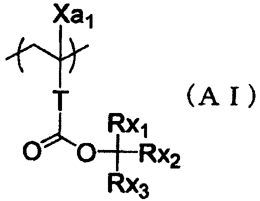 wherein:
Xa₁ represents a hydrogen atom, an optionally substituted methyl group, or a group represented by -CH₂-R₉. R₉ represents a hydroxyl group or a monovalent organic group. R₉ preferably represents an alkyl or an acyl group having 5 or less carbon atoms, more preferably an alkyl group having 3 or less carbon atoms, and further more preferably a methyl group. Xa₁ preferably represents a hydrogen atom, a methyl group, a trifluoromethyl group or a hydroxymethyl group;
T represents a single bond or a bivalent connecting group;
each of Rx₁ to Rx₃ independently represents a linear or branched alkyl group or a monocyclic or polycyclic cycloalkyl group, provided that at least two of Rx₁ to Rx₃ are bonded together to form a monocyclic cycloalkyl group having 5 or 6 carbon atoms.

As the bivalent connecting group represented by T, there can be mentioned, for example, an alkylene group, a group of the formula -(COO-Rt)- or a group of the formula -(O-Rt)-. In the formulae, Rt represents an alkylene group or a cycloalkylene group.

T is preferably a single bond or a group of the formula -(COO-Rt)-. Rt is preferably an alkylene group having 1 to 5 carbon atoms, more preferably a -CH₂- group or -(CH₂)₃-group.

The alkyl group represented by each of Rx₁ to Rx₃ is preferably one having 1 to 4 carbon atoms, such as a methyl group, an ethyl group, an n-propyl group, an isopropyl group, an n-butyl group, an isobutyl group or a t-butyl group.

The cycloalkyl group represented by each of Rx₁ to Rx₃ is preferably a monocyclic cycloalkyl group, such as a cyclopentyl group or a cyclohexyl group, or a polycyclic cycloalkyl group, such as a norbornyl group, a tetracyclodecanyl group, a tetracyclododecanyl group or an adamantyl group.

The cycloalkyl group formed by at least two of Rx₁ to Rx₃ is a monocyclic cycloalkyl group having 5 or 6 carbon atoms.

In an especially preferred mode, Rx₁ is a methyl group or an ethyl group, and Rx₂ and Rx₃ are bonded to each other to thereby form any of the above-mentioned cycloalkyl groups.

One or more substituents may further be introduced in each of the groups above. As the substituents, there can be mentioned, for example, an alkyl group (preferably having 1 to 4 carbon atoms), a halogen atom, a hydroxy group, an alkoxy group (preferably having 1 to 4 carbon atoms), a carboxyl group, an alkoxycarbonyl group (preferably having 2 to 6 carbon atoms). Preferably, each of the substituents has 8 or less carbon atoms.

The content of the repeating unit containing a acid-decomposable group based on all the repeating units of the resin is preferably in the range of 20 to 70 mol%, and more preferably 30 to 50 mol%.

Preferred examples of the repeating unit containing
an acid-decomposable group will be shown below, which however in no way limit the scope of the present invention.

In the specific examples, Rx represents a hydrogen atom, CH₃, CF₃, or CH₂OH. Rxa represents an alkyl group having 1 to 4 carbon atoms. Z or each of Zs independently represents a substituent containing a polar group. P represents 0 or positive integer.

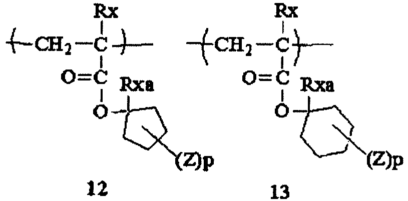

It is more preferred for the acid-decomposable resin to contain, as the repeating units of general formula (AI), any of the repeating units of general formula (I) below.

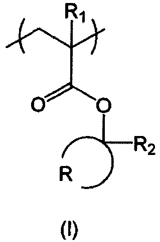

In formula (I), R₁ represents a hydrogen atom, an optionally substituted methyl group or any of the groups of the formula -CH₂-R₉. R₉ represents a monovalent organic group.

R₂ represents an alkyl group or a cycloalkyl group.

R₁ preferably represents a hydrogen atom, a methyl group, a trifluoromethyl group or a hydroxymethyl group.

The alkyl group represented by R₂ may be linear or branched, and one or more substituents may be introduced therein.

The cycloalkyl group represented by R₂ may be monocyclic or polycyclic, and a substituent may be introduced therein.

R₂ preferably represents an alkyl group, more preferably an alkyl group having 1 to 10 carbon atoms, further more preferably 1 to 5 carbon atoms. As examples thereof, there can be mentioned a methyl group and an ethyl group.

R represents an atomic group required for forming a monocyclic cycloalkyl group having 5 or 6 carbon atoms.

As the repeating units of general formula (I), there can be mentioned, for example, those of general formula (I-a) below.

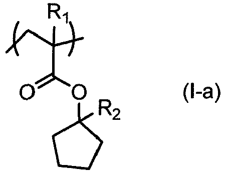

In the formula, R₁ and R₂ have the same meaning as in general formula (I).

It is more preferred for the acid-decomposable resin to be a resin containing, as the repeating units of general formula (AI), at least repeating units of general formula (I). In another form, it is more preferred for the acid-decomposable resin to be a resin containing, as the repeating units of general formula (AI), at least two types selected from among the repeating units of general formula (I).

When the resin (A) contains a plurality of acid-decomposable repeating units, the following combinations are preferred. In the following formulae, R each independently represents a hydrogen atom or a methyl group.

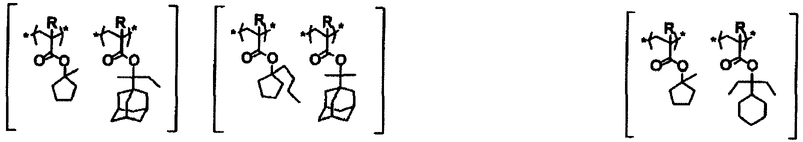

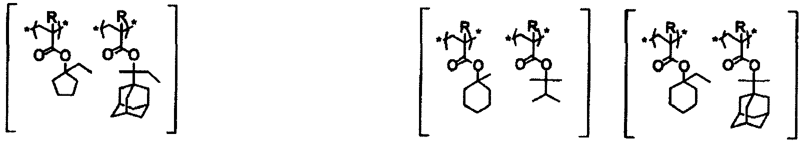

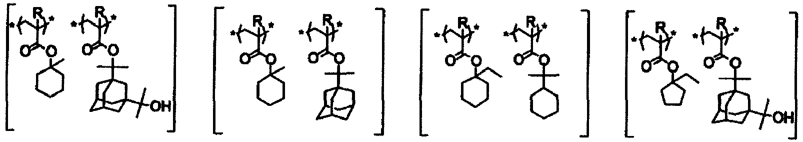

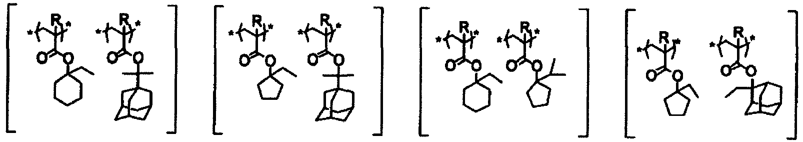

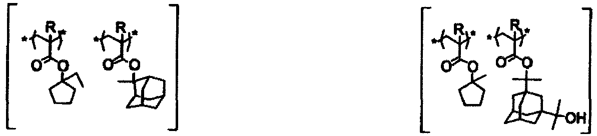

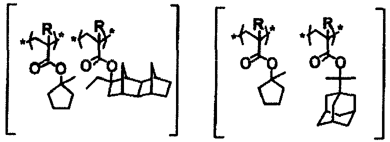

The resin (A) preferably contains a repeating unit having a lactone structure represented by general formula (III) below. 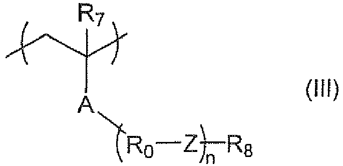 In formula (III),
A represents an ester bond (-COO-) or an amido bond (-CONH-).
Ro, each independently in the presence of two or more groups, represents an alkylene group, a cycloalkylene group or a combination thereof.
Z, each independently in the presence of two or more groups, represents an ether bond, an ester bond, an amido bond, a urethane bond
(a group represented by 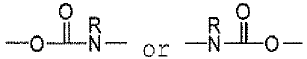 ), or a urea bond
(a group represented by

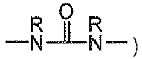

Each of Rs independently represents a hydrogen atom, an alkyl group, cycloalkyl group or an aryl group.

R₈ represents a monovalent organic group with a lactone structure.

n represents the number of repetitions of the structure of the formula -R₀-Z- and is an integer of 1 to 5.

R₇ represents a hydrogen atom, a halogen atom or an alkyl group.

Each of the alkylene group and cycloalkylene group represented by R₀ may have a substituent.

Z preferably represents an ether bond or an ester bond, most preferably an ester bond.

The alkyl group represented by R₇ is preferably an alkyl group having 1 to 4 carbon atoms, more preferably a methyl group or an ethyl group and most preferably a methyl group. The alkyl group represented by R₇ may be substituted. As substituents, there can be mentioned, for example, a halogen atom such as a fluorine atom, a chlorine atom or a bromine atom, a mercapto group, a hydroxyl group, an alkoxy group such as a methoxy group, an ethoxy group, an isopropoxy group, a t-butoxy group or a benzyloxy group, an acyl group such as an acetyl group or a propionyl group, an acetoxy group and the like. R₇ is preferably a hydrogen atom, a methyl group, a trifluoromethyl group or a hydroxymethyl group.

The alkylene group represented by R₀ is preferably a chain alkylene group having 1 to 10 carbon atoms, more preferably 1 to 5 carbon atoms, for example, a methylene group, an ethylene group, a propylene group or the like. The cycloalkylene group is preferably a cycloalkylene group having 3 to 20 carbon atoms. As such, there can be mentioned, for example, cyclohexylene, cyclopentylene, norbornylene, adamantylene or the like. The chain alkylene groups are preferred from the viewpoint of the exertion of the effect of the present invention. A methylene group is most preferred.

The monovalent organic group with a lactone structure represented by R₈ is not limited as long as the lactone structure is contained. As particular examples thereof, there can be mentioned the lactone structures of general formulae (LC1-1) to (LC1-17) to be described hereinafter. Of these, the structures of general formula (LC1-4) are most preferred. In general formulae (LC1-1) to (LC1-17), n₂ is more preferably 2 or less.

R₈ preferably represents a monovalent organic group with an unsubstituted lactone structure or a monovalent organic group with a lactone structure substituted with a methyl group, a cyano group or an alkoxycarbonyl group. More preferably, R₈ represents a monovalent organic group with a lactone structure substituted with a cyano group (cyanolactone) .

Specific examples of the repeating units having a group with a lactone structure represented by general formula (III) will be shown below, which however in no way limit the scope of the present invention.

In the specific examples, R represents a hydrogen atom, an optionally substituted alkyl group or a halogen atom. R is preferably a hydrogen atom, a methyl group, a hydroxymethyl group or an acetoxymethyl group.

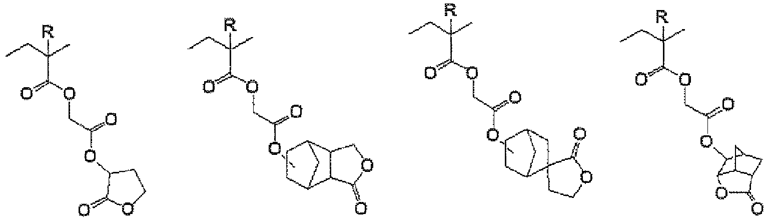

The repeating units having a lactone structure are preferably those of general formula (III-1) below. 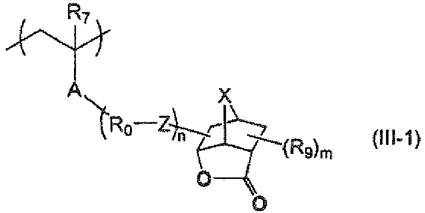 In general formula (III-1),
R₇, A, R₀, Z and n are as defined in general formula (III) above.
R₉, when m ≥ 2 each of Rb's independently, represents an alkyl group, a cycloalkyl group, an alkoxycarbonyl group, a cyano group, a hydroxyl group or an alkoxy group. When m ≥ 2, two or more R₉' s may be bonded to each other to thereby form a ring.
X represents an alkylene group, an oxygen atom or a sulfur atom.

In the formula, m is the number of substituents, being an integer of 0 to 5; and preferably 0 or 1.

The alkyl group represented by Rg is preferably an alkyl group having 1 to 4 carbon atoms, more preferably a methyl group or an ethyl group, and most preferably a methyl group. As the cycloalkyl group, there can be mentioned, for example, a cyclopropyl group, a cyclobutyl group, a cyclopentyl group or a cyclohexyl group. As the alkoxycarbonyl group, there can be mentioned, for example, a methoxycarbonyl group, an ethoxycarbonyl group, an n-butoxycarbonyl group or a t-butoxycarbonyl group. As the alkoxy group, there can be mentioned, for example, a methoxy group, an ethoxy group, a propoxy group, isopropoxy group or a butoxy group. These groups may have one or more substituents. As such substituents, there can be mentioned, for example, a hydroxyl group; an alkoxy group such as a methoxy group or an ethoxy group; a cyano group; and a halogen atom such as a fluorine atom. More preferably, Rg is a methyl group, a cyano group or an alkoxycarbonyl group, further more preferably a cyano group.

As the alkylene group represented by X, there can be mentioned, for example, a methylene group or an ethylene group. X is preferably an oxygen atom or a methylene group, more preferably a methylene group.

When m ≥ 1, it is preferred for the substitution with at least one R₉ to take place at the α- or β-position of the carbonyl group of the lactone. The substitution with R₉ at the α-position of the carbonyl group of the lactone is especially preferred.

Specific examples of the repeating units having a group with a lactone structure represented by formula (III-1) will be shown below, which however in no way limit the scope of the present invention. In the specific examples, R represents a hydrogen atom, an optionally substituted alkyl group or a halogen atom. R is preferably a hydrogen atom, a methyl group, a hydroxymethyl group or an acetoxymethyl group.

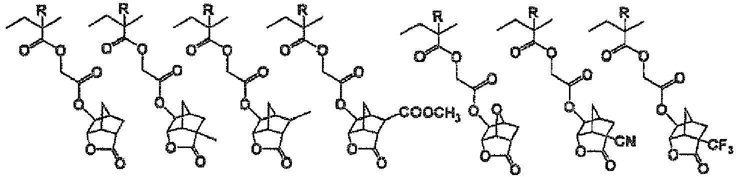

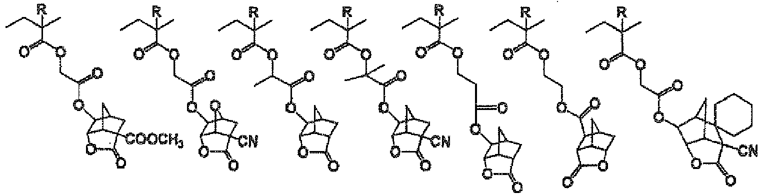

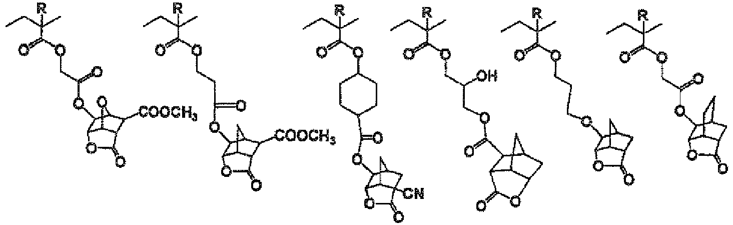

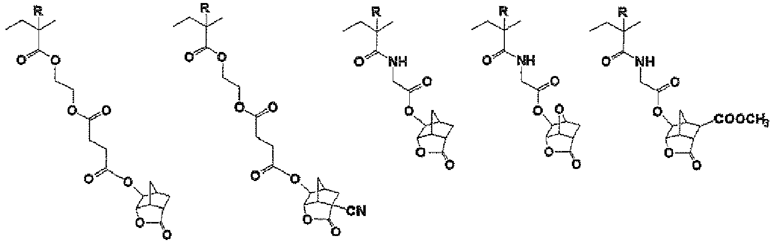

The content of any of the repeating units of general formula (III), the total content when two or more types thereof are contained, is preferably in the range of 15 to 60 mol%, more preferably 20 to 60 mol% and further more preferably 30 to 50 mol%, based on all the repeating units of the resin (A).

The resin (A) may contain a repeating unit containing a lactone group besides the units of general formula (III) .

Any lactone groups can be employed as long as a lactone structure is possessed therein. However, lactone structures of a 5 to 7-membered ring are preferred, and in particular, those resulting from condensation of lactone structures of a 5 to 7-membered ring with other cyclic structures effected in a fashion to form a bicyclo structure or spiro structure are preferred. The possession of repeating units having a lactone structure represented by any of the following general formulae (LC1-1) to (LC1-17) is more preferred. The lactone structures may be directly bonded to the principal chain of the resin. Preferred lactone structures are those of formulae (LC1-1), (LC1-4), (LC1-5), (LC1-6), (LC1-13), (LC1-14) and (LC1-17). The use of these specified lactone structures would ensure improvement in the LWR and development defect.

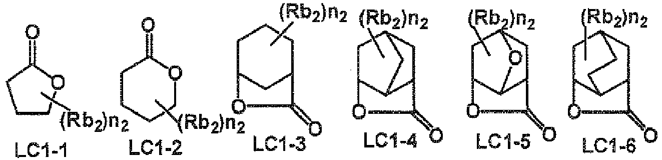

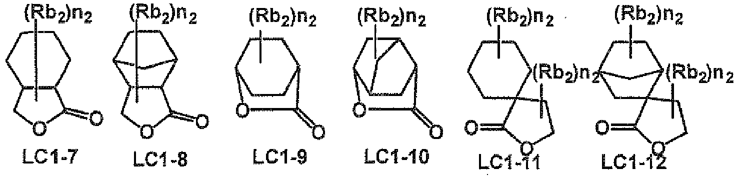

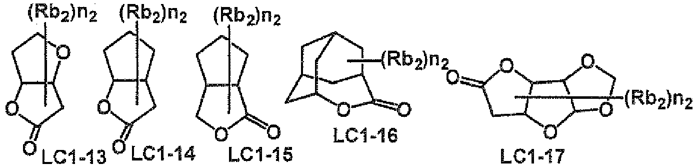

The presence of a substituent (Rb₂) on the portion of the lactone structure is optional. As a preferred substituent (Rb₂), there can be mentioned an alkyl group having 1 to 8 carbon atoms, a cycloalkyl group having 4 to 7 carbon atoms, an alkoxy group having 1 to 8 carbon atoms, an alkoxycarbonyl group having 1 to 8 carbon atoms, a carboxyl group, a halogen atom, a hydroxyl group, a cyano group, an acid-decomposable group or the like. Of these, an alkyl group having 1 to 4 carbon atoms, a cyano group and an acid-decomposable group are more preferred. In the formulae, n₂ is an integer of 0 to 4. When n₂ is 2 or greater, the plurality of present substituents (Rb₂) may be identical to or different from each other. Further, the plurality of present substituents (Rb₂) may be bonded to each other to thereby form a ring.

As the repeating units containing a lactone structure besides the units of general formula (III), a repeating unit represented by general formula (AII') below can be exemplified. 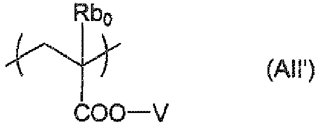 In general formula (AII'),
Rb₀ represents a hydrogen atom, a halogen atom or an alkyl group having 1 to 4 carbon atoms. As preferred substituents that may be introduced in the alkyl group represented by Rb₀, there can be mentioned a hydroxyl group and a halogen atom. As the halogen atom, there can be mentioned a fluorine atom, a chlorine atom, a bromine atom or an iodine atom. Preferably, Rb₀ represents a hydrogen atom, a methyl group, a hydroxymethyl group, or a trifluoromethyl group, and more preferably a hydrogen atom or a methyl group.
V represents any of the groups of the general formulae (LC1-1) to (LC1-17).

Specific examples of repeating unit containing a lactone structure besides the units of general formula (III) will be shown below, which in no way limit the scope of the present invention.

In the formulae, Rx represents H, CH₃, CH₂OH, or CF₃.

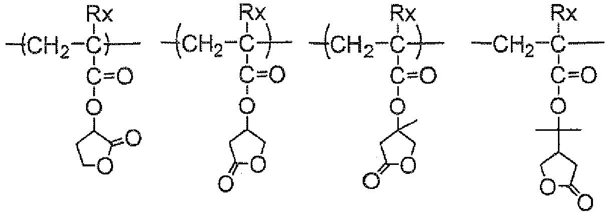

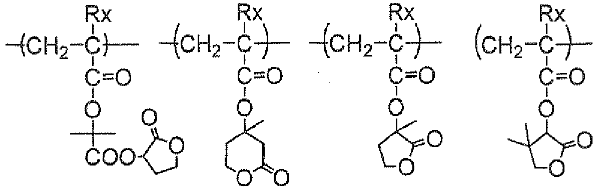

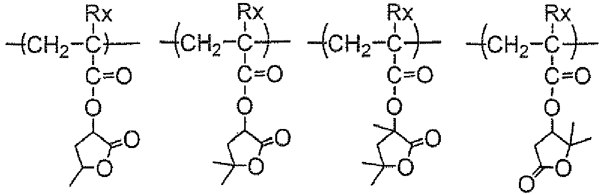

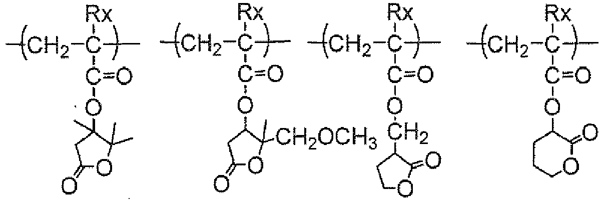

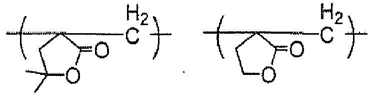

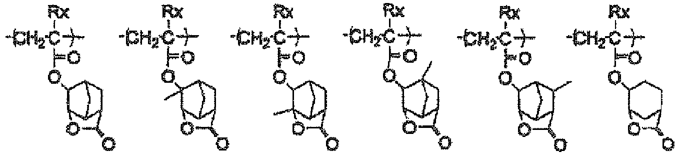

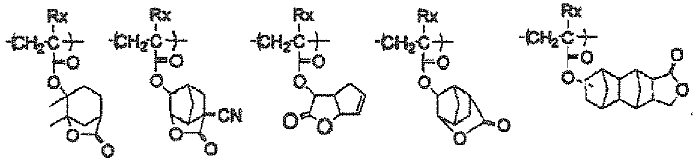

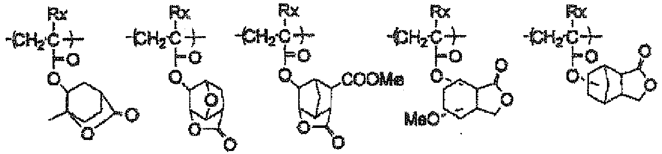

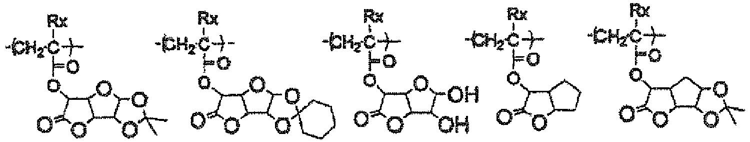

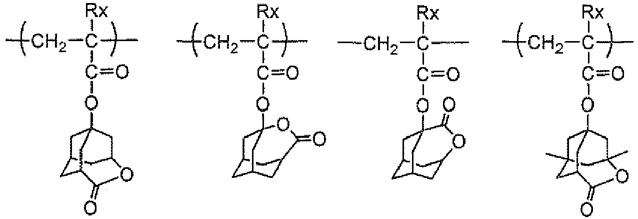

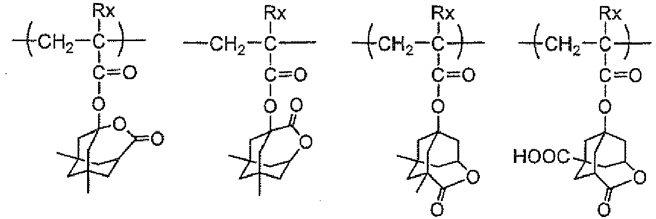

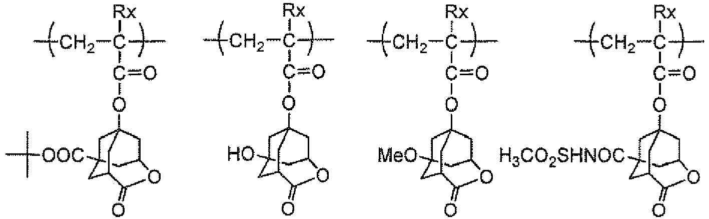

As especially preferred repeating units each containing a lactone group other than the units of general formula (III), there can be mentioned the following repeating units. Favorable pattern profile and iso/dense bias can be realized by selecting most appropriate lactone groups.

In the formulae, Rx represents H, CH₃, CH₂OH, or CF₃.

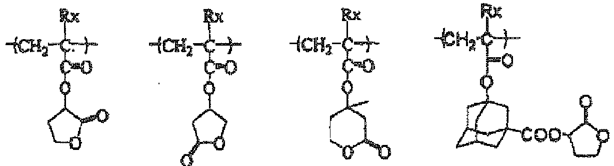

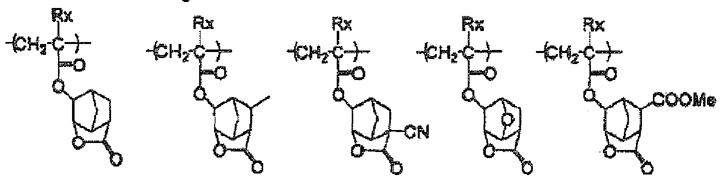

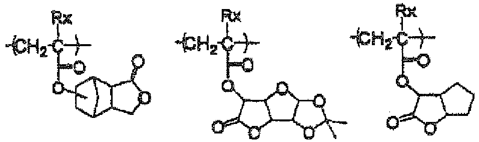

The repeating unit having a lactone group is generally present in the form of optical isomers. Any of the optical isomers may be used. It is both appropriate to use a single type of optical isomer alone and to use a plurality of optical isomers in the form of a mixture. When a single type of optical isomer is mainly used, the optical purity thereof is preferably 90%ee or higher, more preferably 95%ee or higher.

The content of repeating unit containing a lactone group other than the repeating units of general formula (III), the total content when two or more types thereof are contained, is preferably in the range of 15 to 60 mol%, more preferably 20 to 50 mol% and further more preferably 30 to 50 mol%, based on all the repeating units of the resin.

In order to enhance the effect of the present invention, two or more types of lactone repeating units selected from among those of general formula (III) can be used in combination. When such a combinational use is conducted, it is preferred to select two or more from among the lactone repeating units of general formula (III) in which n is 1 and use them in combination.

The resin (A) may further contain a repeating unit containing a hydroxy group or a cyano group other than repeating units represented by general formulae (AI) and (III). The containment of this repeating unit would realize enhancements of adhesion to substrate and developer affinity. The repeating unit containing a hydroxy group or a cyano group is preferably a repeating unit having an alicyclic hydrocarbon structure substituted with a hydroxy group or a cyano group. Further, the repeating unit containing a hydroxy group or a cyano group is preferably free from the acid-decomposable group. In the alicyclic hydrocarbon structure substituted with a hydroxy group or a cyano group, the alicyclic hydrocarbon structure preferably consists of an adamantyl group, a diamantyl group or a norbornane group. As preferred alicyclic hydrocarbon structures substituted with a hydroxy group or a cyano group, the partial structures represented by the following general formulae (VIIa) to (VIId) can be exemplified. 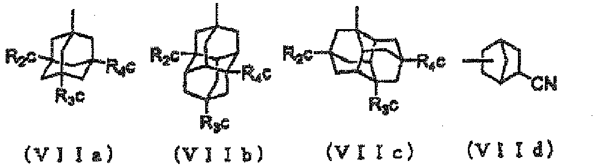 In the general formulae (VIIa) to (VIIc),
each of R₂c to R₄c independently represents a hydrogen atom, a hydroxy group or a cyano group, with the proviso that at least one of the R₂c to R₄c represents a hydroxy group or a cyano group. Preferably, one or two of the R₂c to R₄c are hydroxy groups and the remainder is a hydrogen atom. In the general formula (VIIa), more preferably, two of the R₂c to R₄c are hydroxy groups and the remainder is a hydrogen atom.

As the repeating units having any of the partial structures represented by the general formulae (VIIa) to (VIId), those of the following general formulae (AIIa) to (AIId) can be exemplified. 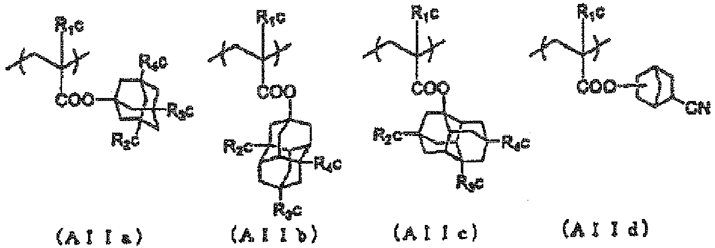 In general formulae (AIIa) to (AIId),
R₁c represents a hydrogen atom, a methyl group, a trifluoromethyl group or a hydroxymethyl group.
R₂c to R₄c have the same meaning as those of the general formulae (VIIa) to (VIIc).

The content of the repeating unit containing a hydroxyl group or a cyano group based on all the repeating units of the resin (A) is preferably in the range of 5 to 40 mol%, more preferably 5 to 30 mol% and further more preferably 10 to 25 mol%.

Specific examples of the repeating units containing a hydroxyl group or a cyano group will be shown below, which however in no way limit the scope of the present invention.

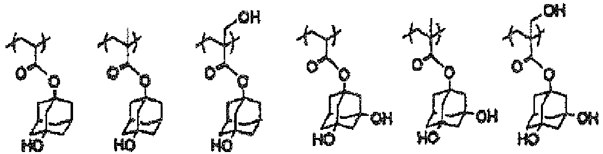

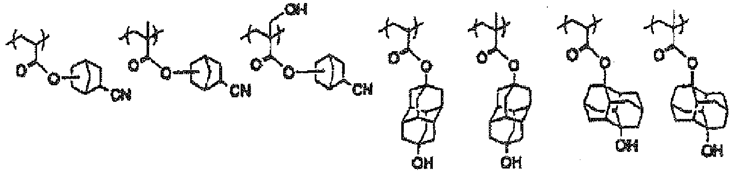

The resin for use in the composition of the present invention may contain a repeating unit containing an alkali-soluble group. As the alkali-soluble group, there can be mentioned a phenolic hydroxyl group, a carboxyl group, a sulfonamido group, a sulfonylimido group, a bisulfonylimido group or an aliphatic alcohol substituted at its α-position with an electron withdrawing group (for example, a hexafluoroisopropanol group). It is more preferred to contain a repeating unit containing a carboxyl group. The incorporation of the repeating unit containing an alkali-soluble group increases the resolution in contact hole usage. The repeating unit containing an alkali-soluble group is preferably any of a repeating unit wherein the alkali-soluble group is directly bonded to the principal chain of a resin such as a repeating unit of acrylic acid or methacrylic acid, a repeating unit wherein the alkali-soluble group is bonded via a connecting group to the principal chain of a resin and a repeating unit wherein the alkali-soluble group is introduced in a terminal of a polymer chain by the use of a chain transfer agent or polymerization initiator having the alkali-soluble group in the stage of polymerization. The connecting group may have a mono- or polycyclohydrocarbon structure. The repeating unit of acrylic acid or methacrylic acid is especially preferred.

The content of the repeating unit containing an alkali-soluble group based on all the repeating units of the resin is preferably in the range of 0 to 20 mol%, more preferably 3 to 15 mol% and further more preferably 2 to 10 mol%.

Specific examples of the repeating units containing an alkali-soluble group will be shown below, which however in no way limit the scope of the present invention.

In the specific examples, Rx represents H, CH₃, CH₂OH, or CF₃.

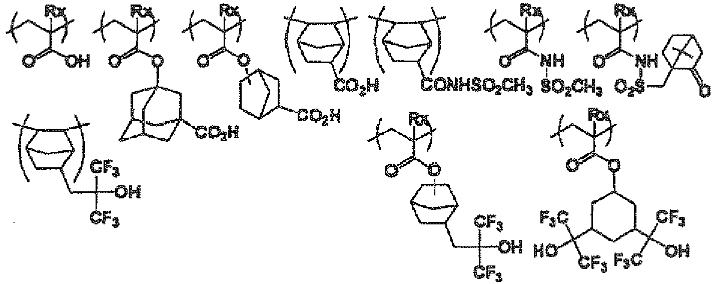

The resin (A) may further contain a repeating unit having an alicyclic hydrocarbon structure containing no polar group, which repeating unit exhibits no acid decomposability. As the repeating unit, there can be mentioned, for example, any of those of general formula (IV) below.

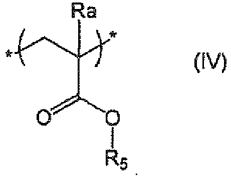

In the general formula (IV), R₅ represents a hydrocarbon group having at least one cyclic structure in which neither a hydroxyl group nor a cyano group is contained.

Ra represents a hydrogen atom, an alkyl group or a group of the formula -CH₂-O-Ra₂ in which Ra₂ represents a hydrogen atom, an alkyl group or an acyl group. Ra is preferably a hydrogen atom, a methyl group, a hydroxymethyl group or a trifluoromethyl group, further preferably a hydrogen atom or a methyl group.

The cyclic structures contained in R₅ include a monocyclic hydrocarbon group and a polycyclic hydrocarbon group. As the monocyclic hydrocarbon group, a cycloalkyl group having 3 to 12 carbon atoms and a cycloalkenyl group having 3 to 12 carbon atoms can be exemplified. Preferably, the monocyclic hydrocarbon group is a monocyclic hydrocarbon group having 3 to 7 carbon atoms. As such, a cyclopentyl group and a cyclohexyl group can be exemplified.

The polycyclic hydrocarbon groups include ring-assembly hydrocarbon groups and crosslinked-ring hydrocarbon groups.

As the ring-assembly hydrocarbon groups, for example, a bicyclohexyl group and a perhydronaphthalenyl group can be exemplified.

As the crosslinked-ring hydrocarbon rings, there can be mentioned, for example, bicyclic hydrocarbon rings, such as pinane, bornane, norpinane, norbornane and bicyclooctane rings (e.g., bicyclo[2.2.2]octane ring or bicyclo[3.2.1]octane ring); tricyclic hydrocarbon rings, such as homobledane, adamantane, tricyclo[5.2.1.0^{2,6}]decane and tricyclo[4.3.1.1^{2,5}]undecane rings; and tetracyclic hydrocarbon rings, such as tetracyclo[4.4.0.1^{2,5}.1^{7,10}]dodecane and perhydro-1,4-methano-5,8-methanonaphthalene rings.

Further, the crosslinked-ring hydrocarbon rings include condensed-ring hydrocarbon rings, for example, condensed rings resulting from condensation of multiple 5-to 8-membered cycloalkane rings, such as perhydronaphthalene (decalin), perhydroanthracene, perhydrophenanthrene, perhydroacenaphthene, perhydrofluorene, perhydroindene and perhydrophenalene rings.

As preferred crosslinked-ring hydrocarbon rings, there can be mentioned a norbornyl group, an adamantyl group, a bicyclooctanyl group, a tricyclo[5.2.1.0^{2,6}]decanyl group and the like. As more preferred crosslinked-ring hydrocarbon rings, there can be mentioned a norbornyl group and an adamantyl group.

These alicyclic hydrocarbon groups may have one or more substituents. As preferred substituents, a halogen atom, an alkyl group, a hydroxyl group protected by a protective group, and an amino group protected by a protective group can be exemplified. The halogen atom is preferably a bromine, chlorine or fluorine atom. The alkyl group is preferably a methyl, ethyl, butyl or t-butyl group. The alkyl group may further have one or more substituents. As the optional substituent, a halogen atom, an alkyl group, a hydroxyl group protected by a protective group, and an amino group protected by a protective group can be exemplified.

As the protective group, an alkyl group, a cycloalkyl group, an aralkyl group, a substituted methyl group, a substituted ethyl group, an alkoxycarbonyl group and an aralkyloxycarbonyl group can be exemplified. Preferred alkyl groups include alkyl groups having 1 to 4 carbon atoms. Preferred substituted methyl groups include methoxymethyl, methoxythiomethyl, benzyloxymethyl, t-butoxymethyl and 2-methoxyethoxymethyl groups. Preferred substituted ethyl groups include 1-ethoxyethyl and 1-methyl-1-methoxyethyl groups. Preferred acyl groups include aliphatic acyl groups having 1 to 6 carbon atoms, such as formyl, acetyl, propionyl, butyryl, isobutyryl, valeryl and pivaloyl groups. Preferred alkoxycarbonyl groups include alkoxycarbonyl groups having 1 to 4 carbon atoms and the like.

The content of the repeating unit having an alicyclic hydrocarbon structure containing no polar group, which repeating unit exhibits no acid decomposability, based on all the repeating units of the resin (A) is preferably in the range of 0 to 40 mol%, more preferably 1 to 20 mol%.

Specific examples of the repeating unit having an alicyclic hydrocarbon structure containing no polar group, which repeating unit exhibits no acid decomposability will be shown below, which however in no way limit the scope of the present invention. In the formulae, Ra represents H, CH₃, CH₂OH or CF₃.

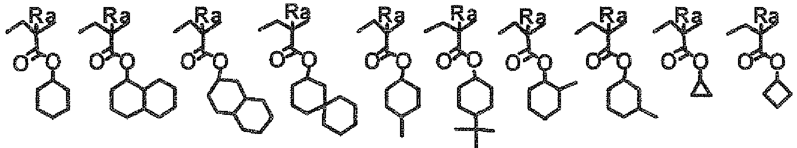

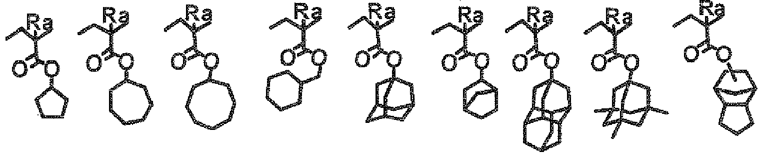

Various repeating structural units other than those mentioned hereinbefore can be introduced in the resin (A) in order to regulate the dry etching resistance, standard developer adaptability, adherence to substrates, resist profile, and generally required properties for resist, such as resolving power, heat resistance, sensitivity, and the like.

As such other repeating structural units, those corresponding to the following monomers can be exemplified, which however are nonlimiting.

Such other repeating structural units would permit fine regulation of the properties required to have by the resin for use in the composition of the present invention, especially, (1) solubility in applied solvents, (2) film forming easiness (glass transition temperature), (3) alkali developability, (4) film thinning (selection of hydrophilicity/hydrophobicity and alkali soluble group), (5) adhesion of unexposed areas to substrate, and (6) dry etching resistance, etc.

As the above-mentioned monomers, compounds having an unsaturated bond capable of addition polymerization, selected from among acrylic esters, methacrylic esters, acrylamides, methacrylamides, allyl compounds, vinyl ethers, vinyl esters and the like can be exemplified.

The monomers are not limited to the above, and unsaturated compounds capable of addition polymerization that are copolymerizable with the monomers corresponding to the above various repeating structural units can be used in the copolymerization.

The molar ratios of individual repeating structural units contained in the resin (A) for use in the composition of the present invention are appropriately determined from the viewpoint of regulation of not only the resist dry etching resistance but also the standard developer adaptability, substrate adhesion, resist profile and generally required properties of resists such as resolving power, heat resistance and sensitivity.

When the composition of the present invention is used in ArF exposure, it is preferred for the resin (A) to contain no aromatic group from the viewpoint of transparency to ArF light. It is especially preferred for the acid-decomposable resin to contain an alicyclic hydrocarbon structure of a single ring or multiple rings.

Further, it is preferred for the resin (A) to contain neither a fluorine atom nor a silicon atom from the viewpoint of compatibility with the resin (B).

Preferred resin (A) is that whose repeating units consisting of (meth)acrylate repeating units. In that instance, use can be made of any of a resin wherein all the repeating units consist of methacrylate repeating units, a resin wherein all the repeating units consist of acrylate repeating units and a resin wherein all the repeating units consist of methacrylate repeating units and acrylate repeating units. However, it is preferred for the acrylate repeating units to account for 50 mol% or less of all the repeating units. Further, a copolymer containing 20 to 50 mol% of (meth)acrylate repeating unit having an acid-decomposable group; 20 to 50 mol% of (meth)acrylate repeating unit having a lactone structure; 5 to 30 mol% of (meth)acrylate repeating unit containing a hydroxy group or a cyano group; and 0 to 20 mol% of other (meth) acrylate repeating units is also preferred.

In the event of exposing the composition of the present invention to KrF excimer laser beams, electron beams, X-rays or high-energy light rays of wavelength 50 nm or less (EUV, etc.), it is preferred for the resin (A) to further have hydroxystyrene repeating units. More preferably, the resin has hydroxystyrene repeating units, hydroxystyrene repeating units protected by an acid-decomposable group and acid-decomposable repeating units of a (meth)acrylic acid tertiary alkyl ester, etc.

As preferred hydroxystyrene repeating units having an acid-decomposable group, there can be mentioned, for example, repeating units derived from t-butoxycarbonyloxystyrene, a 1-alkoxyethoxystyrene and a (meth)acrylic acid tertiary alkyl ester. Repeating units derived from a 2-alkyl-2-adamantyl (meth)acrylate and a dialkyl(1-adamantyl)methyl (meth)acrylate are more preferred.

The resin (A) of the present invention can be synthesized by conventional techniques (for example, radical polymerization). As general synthetic methods, there can be mentioned, for example, a batch polymerization method in which a monomer species and an initiator are dissolved in a solvent and heated so as to accomplish polymerization and a dropping polymerization method in which a solution of monomer species and initiator is added by dropping to a heated solvent over a period of 1 to 10 hours. The dropping polymerization method is preferred. As a reaction solvent, there can be mentioned, for example, an ether, such as tetrahydrofuran, 1,4-dioxane or diisopropyl ether; a ketone, such as methyl ethyl ketone or methyl isobutyl ketone; an ester solvent, such as ethyl acetate; an amide solvent, such as dimethylformamide or dimethylacetamide; or the solvent capable of dissolving the composition of the present invention, such as propylene glycol monomethyl ether acetate, propylene glycol monomethyl ether or cyclohexanone, to be described hereinafter. It is preferred to perform the polymerization with the use of the same solvent as employed in the actinic-ray- or radiation-sensitive resin composition of the present invention. This would inhibit any particle generation during storage.

The polymerization reaction is preferably carried out in an atmosphere of inert gas, such as nitrogen or argon. The polymerization is initiated by the use of a commercially available radical initiator (azo initiator, peroxide, etc.) as a polymerization initiator. Among the radical initiators, an azo initiator is preferred. An azo initiator having an ester group, a cyano group or a carboxyl group is especially preferred. As preferred initiators, there can be mentioned azobisisobutyronitrile, azobisdimethylvaleronitrile, dimethyl 2,2'-azobis(2-methylpropionate) and the like. According to necessity, a supplementation of initiator or divided addition thereof may be effected. After the completion of the reaction, the reaction mixture is poured into a solvent. The desired polymer is recovered by a method for powder or solid recovery, etc. The concentration during the reaction is in the range of 5 to 50 mass%, preferably 10 to 30 mass%. The reaction temperature is generally in the range of 10 to 150°C, preferably 30 to 120°C and more preferably 60 to 100°C.

Further, the operation of dissolving a synthesized resin in a solvent to thereby obtain a solution and heating the solution at about 30 to 90°C for about 30 minutes to 4 hours as described in, for example, JP-A-2009-037108 may be added in order to inhibit any aggregation, etc. of the resin after the preparation of the composition.

The weight average molecular weight of the resin (A) in terms of polystyrene molecular weight as measured by GPC is preferably in the range of 1000 to 200,000, more preferably 2000 to 20,000, still more preferably 3000 to 15,000 and further preferably 5000 to 13,000. The regulation of the weight average molecular weight to 1000 to 200,000 would prevent deteriorations of heat resistance and dry etching resistance and also prevent deterioration of developability and increase of viscosity leading to poor film forming property.

Use is made of the resin whose dispersity (molecular weight distribution) is usually in the range of 1 to 3, preferably 1 to 2.6, more preferably 1 to 2 and most preferably 1.4 to 2.0. The lower the molecular weight distribution, the more excellent the resolving power and resist profile and the smoother the side wall of the resist pattern to thereby attain an excellence in roughness.

The resin (A) of the present invention may either be used individually or in combination.

In the present invention, the content ratio of the resin (A) based on the total solid content of the whole composition is preferably in the range of 30 to 99 mass%, and more preferably 60 to 95 mass%.

### (B) Photoacid generator

The resist composition of the present invention contains any of the compounds of general formulae (I) and (II) below as the photoacid generator. 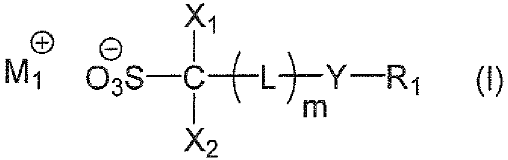 In general formula (I),
each of X₁ and X₂ independently represents a fluorine atom or a fluoroalkyl group.
L, when m≥2 each independently, represents a bivalent connecting group.
In the formula, m is an integer of 0 or greater,
Y represents -CO-, -COO-, -OCO-, -CON(R₂)-, -O-, -S-, -SO-, -SO₂-, -OSO₂-, -SO₂O- or a combination of two or more of these.

Each of R₁ and R₂ independently represents a hydrogen atom, an alkyl group or a group with a cyclic structure, provided that R₁ and R₂ are in no event simultaneously hydrogen atoms, and provided that R₁ and R₂ may be bonded to each other to thereby form a ring.

M₁⁺ represents a cation. 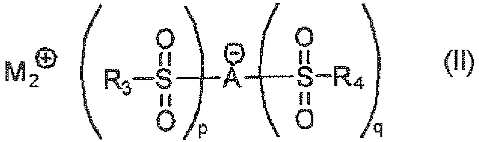 In general formula (II),
A represents a nitrogen atom or a carbon atom, provided that when A is a nitrogen atom, p+q=2, p is 1 or 2, and q is 0 or 1, and provided that when A is a carbon atom, p+q=3, p is an integer of 1 to 3, and q is an integer of 0 to 2.
R₃ represents a monovalent organic group containing a fluorine atom, the monovalent organic group exhibiting a fluorine content 0.35 or below, the fluorine content expressed by formula: (total mass of all fluorine atoms contained)/(total mass of all atoms contained), provided that when p≥2 a plurality of R₃s may be identical to or different from each other, and provided that in that instance, a plurality of R₃s may be bonded to each other to thereby form a ring, and provided that when a plurality of R₃s are bonded to each other to thereby form a ring, the above fluorine content refers to a value calculated with respect to a bivalent group constructing the ring.
R₄ represents a group containing an electron withdrawing group, provided that when q=2, two R₄s may be identical to or different from each other.
When q≥1, R₃ and R₄ may be bonded to each other to thereby form a ring, provided that in that instance, the above fluorine content refers to a value calculated with respect to a bivalent group constructing the ring formed by R₃ and R₄.
M₂⁺ represents a cation.

First, the compounds of general formula (I) will be described.

The fluoroalkyl group represented by X₁ or X₂ preferably has 1 to 6 carbon atoms, more preferably 1 to 4 carbon atoms. It is preferred for the fluoroalkyl group represented by X₁ or X₂ to be a perfluoroalkyl group.

Preferably, X₁ and X₂ are each a fluorine atom or a perfluoroalkyl group.

As particular examples of X₁ and X₂, there can be mentioned a fluorine atom, CF₃, C₂F₅, C₃F₇, C₄F₉, C₅F₁₁, C₆F₁₃, C₇F₁₅, C₈F₁₇, CH₂CF₃, CH₂CH₂CF₃, CH₂C₂F₅, CH₂CH₂C₂F₅, CH₂C₃F₇, CH₂CH₂C₃F₇, CH₂C₄F₉ and CH₂CH₂C₄F₉. Of these, a fluorine atom and CF₃ are preferred. It is especially preferred for both of X₁ and X₂ to be a fluorine atom.

The bivalent connecting group represented by L is not particularly limited. As examples thereof, there can be mentioned -COO-, -OCO-, -CO-, -O-, -S-, -SO-, -SO₂-, an alkylene group, a cycloalkylene group and an alkenylene group. Of these, -COO-, -OCO-, -CO-, -O-, -SO₂- and an alkylene group are preferred. -COO-, -OCO-, -SO₂- and an alkenylene group are more preferred. The alkenylene group represented by L may be in the form of a linear or branched chain. The alkylene group, cycloalkylene group and alkenylene group may be substituted with a fluorine atom, etc.

In the formula, m is preferably in the range of 0 to 10, more preferably 0 to 8 and further more preferably 0 to 4.

Y is preferably -CO-, -COO- or -OCO-.

Also, Y is preferably expressed by the formula -CON(R₂)-. Namely, it is also preferred for the compounds of general formula (I) to be expressed by general formula (I-AM) below.

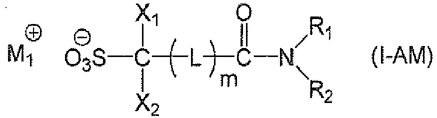

In general formula (I-AM), the characters have the same meaning as in general formula (I).

Each of R₁ and R₂ independently represents a hydrogen atom, an alkyl group or a group with a cyclic structure.

The alkyl group may be in the form of a linear or branched chain and preferably has 1 to 10 carbon atoms, more preferably 1 to 7 carbon atoms. As particular examples of the alkyl groups represented by R₁ and R₂, there can be mentioned a methyl group, an ethyl group, an n-propyl group, an n-butyl group, an n-pentyl group, an n-hexyl group, an n-heptyl group, an n-octyl group, an n-dodecyl group, a 2-ethylhexyl group, an isopropyl group, a sec-butyl group, a t-butyl group, an isoamyl group and the like. Of these, a methyl group, an ethyl group, an n-propyl group, an isopropyl group, an n-butyl group, a sec-butyl group and a t-butyl group are preferred.

A substituent may be introduced in the alkyl group. As the substituent, there can be mentioned a hydroxyl group; a halogen atom (fluorine, chlorine, bromine or iodine); a nitro group; a cyano group; an amido group; a sulfonamido group; an alkoxy group, such as a methoxy group, an ethoxy group, a hydroxyethoxy group, a propoxy group, a hydroxypropoxy group or a butoxy group; an alkoxycarbonyl group, such as a methoxycarbonyl group or an ethoxycarbonyl group; an acyl group, such as a formyl group, an acetyl group or a benzoyl group; an acyloxy group, such as an acetoxy group or a butyryloxy group; a carboxyl group; or the like.

As the group with a cyclic structure represented by R₁ or R₂, there can be mentioned a group with a monocyclic structure (preferably 3 to 12 carbon atoms) or a group with a polycyclic structure (preferably 4 to 25 carbon atoms) .

As the group with a monocyclic structure, there can be mentioned a monocyclic hydrocarbon group, a monocyclic heterocyclic group, an alkyl group containing at least either of these, or the like.

As the monocyclic hydrocarbon group, there can be mentioned a monocyclic alkyl group or a monocyclic aryl group.

The monocyclic alkyl group preferably has 3 to 10 carbon atoms. Particular examples of the monocyclic alkyl groups include a cyclopropyl group, a cyclobutyl group, a cyclopentyl group, a cyclohexyl group, a cycloheptyl group, a cyclooctyl group, a cyclododecanyl group, a cyclopentenyl group, a cyclohexenyl group, a cyclooctadienyl group and the like. A cyclopropyl group, a cyclopentyl group, a cyclohexyl group and a cyclooctyl group are especially preferred.

As the monocyclic aryl group, there can be mentioned a substituted or unsubstituted phenyl group.

The monocyclic heterocyclic groups include a saturated heterocyclic group and an unsaturated heterocyclic group, and preferably each has 5 to 10 carbon atoms. As the saturated heterocyclic group, there can be mentioned a 1-piperidyl group, a 4-piperidyl group, a 4-morpholinyl group, a 1,3-dioxoran-2-ylmethyl group, an azepan-2-on-1-yl group or the like. As the unsaturated heterocyclic group, there can be mentioned a pyrrole group, a furan group, a thiophene group or the like.

As a preferred alkyl group containing at least either a monocyclic hydrocarbon group or a monocyclic heterocyclic group, there can be mentioned an alkyl group having 1 to 5 carbon atoms (preferably 1 to 3 carbon atoms) whose arbitrary hydrogen atom is replaced by at least either a monocyclic hydrocarbon group or a monocyclic heterocyclic group (for example, an alkyl group substituted with a monocyclic hydrocarbon group or a monocyclic heterocyclic group, such as a cyclopentylmethyl group, a cyclohexylmethyl group or a cyclooctylmethyl group).

As the group with a polycyclic structure, there can be mentioned (i) a polycyclic hydrocarbon group, (ii) a polycyclic heterocyclic group, (iii) a group composed of two or more groups selected from among monocyclic hydrocarbon groups and monocyclic heterocyclic groups, (iv) an alkyl group containing two or more groups selected from among monocyclic hydrocarbon groups and monocyclic heterocyclic groups, (v) an alkyl group containing a polycyclic hydrocarbon group or a polycyclic heterocyclic group, or the like.

The polycyclic hydrocarbon group and monocyclic hydrocarbon group may be aliphatic or aromatic groups. An alicyclic hydrocarbon group is especially preferred.

In particular, the polycyclic hydrocarbon group preferably has 10 to 20 carbon atoms. Particular examples of the polycyclic hydrocarbon groups include a bicyclo[4.3.0]nonanyl group, a naphthalenyl group, a decahydronaphthalenyl group, a 1,2,3,4-tetrahydronaphthalenyl group, a tricyclo[5.2.1.0(2,6)]decanyl group, a bornyl group, an isobornyl group, a norbornyl group, an adamantyl group, a noradamantyl group, a 1,7,7-trimethyltricyclo[2.2.1.0^{2,6}]heptanyl group, a 3,7,7-trimethylbicyclo[4.1.0]heptanyl and the like. A norbornyl group, an adamantyl group and a noradamantyl group are especially preferred.

The polycyclic heterocyclic group preferably has 10 to 20 carbon atoms. Particular examples of the polycyclic heterocyclic groups include an indole group, a carbazole group and the like.

As the monocyclic hydrocarbon groups and monocyclic heterocyclic groups that are contained in the group composed of two or more groups selected from among monocyclic hydrocarbon groups and monocyclic heterocyclic groups and the alkyl group containing two or more groups selected from among monocyclic hydrocarbon groups and monocyclic heterocyclic groups, there can be mentioned those set forth above.

As a preferred alkyl group containing two or more groups selected from among monocyclic hydrocarbon groups and monocyclic heterocyclic groups, there can be mentioned an alkyl group having 1 to 5 carbon atoms (preferably 1 to 3 carbon atoms) whose arbitrary two or more hydrogen atoms are replaced by groups selected from among monocyclic hydrocarbon groups and monocyclic heterocyclic groups.

The alkyl group containing a polycyclic hydrocarbon group or a polycyclic heterocyclic group is preferably an alkyl group substituted with any of the above polycyclic hydrocarbon groups. For example, there can be mentioned an alkyl group substituted with a polycyclic hydrocarbon group or a polycyclic heterocyclic group, such as an adamantylmethyl group, a norbornylmethyl group or a decahydronaphthylmethyl group.

R₁ and R₂ may be bonded to each other to thereby form a ring. The ring may have a monocyclic structure or a polycyclic structure. The ring structures formed by R₁ and R₂ include a monocyclic structure, such as a piperidine ring, and a polycyclic structure, such as a decahydroquinoline ring or a decahydroisoquinoline ring.

A substituent may further be introduced in the group with a cyclic structure represented by R₁ or R₂ and the ring formed by the mutual bonding of R₁ and R₂. As such a further substituent, there can be mentioned a hydroxyl group; a halogen atom (a fluorine atom, a chlorine atom, a bromine atom, an iodine atom, etc.); a nitro group; a cyano group; an amido group; a sulfonamido group; an alkyl group, such as a methyl group, an ethyl group, a propyl group, an n-butyl group, a sec-butyl group, a hexyl group, a 2-ethylhexyl group or an octyl group; an alkoxy group, such as a methoxy group, an ethoxy group, a hydroxyethoxy group, a propoxy group, a hydroxypropoxy group or a butoxy group; an alkoxycarbonyl group, such as a methoxycarbonyl group or an ethoxycarbonyl group; an acyl group, such as a formyl group, an acetyl group or a benzoyl group; an acyloxy group, such as an acetoxy group or a butyryloxy group; or a carboxyl group.

Preferably, R₁ and R₂ are bonded to each other to thereby form a ring, or R₁ is an alkyl group having 5 or more carbon atoms or a group with a cyclic structure (preferably 5 or more carbon atoms). More preferably, R₁ and R₂ are bonded to each other to thereby form a ring, or R₁ is a group with a cyclic structure (preferably 5 or more carbon atoms). Further more preferably, R₁ and R₂ are bonded to each other to thereby form a polycycle, or R₁ is a group with a polycyclic structure. When R₁ is a group with a cyclic structure, R₂ is also preferably a group with a cyclic structure.

Preferred examples of the anion moieties of the compounds of general formula (I) are set forth below as the structures of corresponding acids. In the particular examples, each of X₁ and X₂ independently represents a fluorine atom or a perfluoroalkyl group having 1 to 6 carbon atoms.

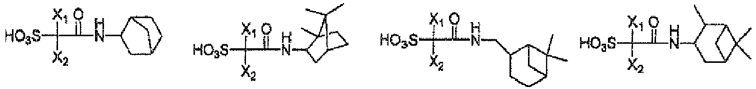

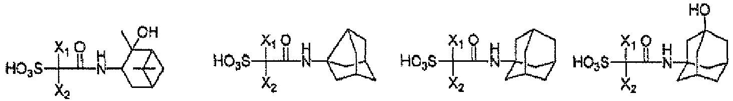

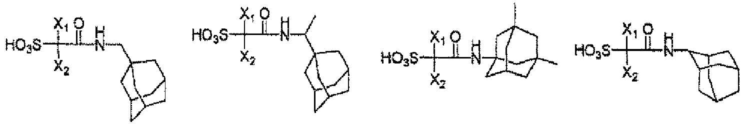

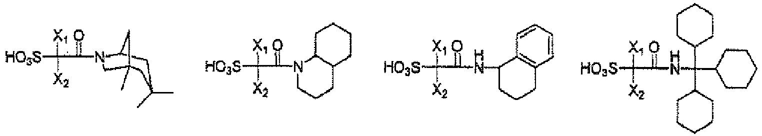

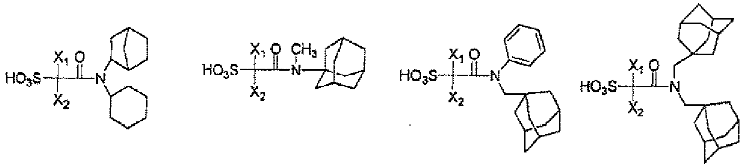

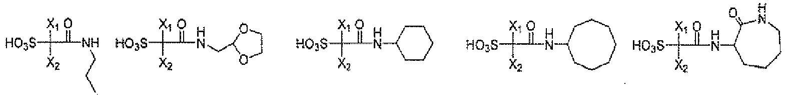

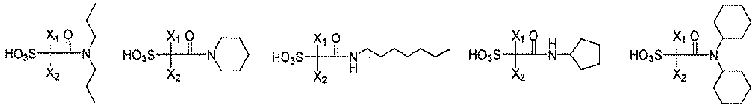

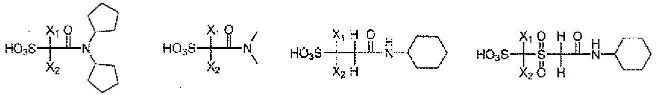

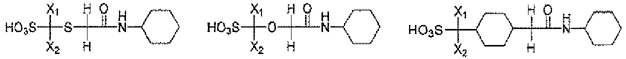

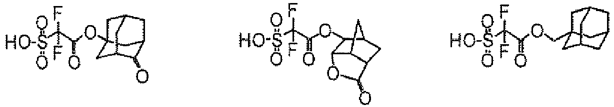

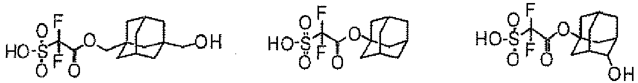

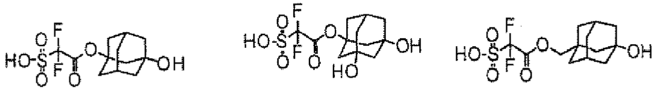

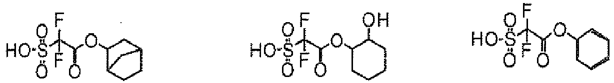

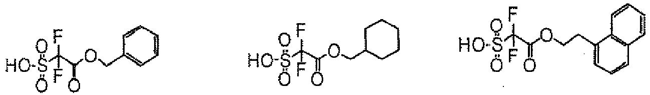

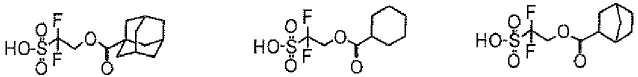

The cation represented by M₁⁺ is preferably any of those of general formulae (ZI) and (ZII) below. 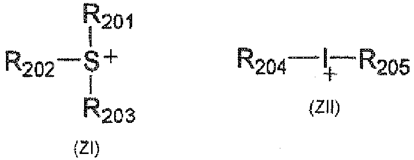 In general formula (ZI),
each of R₂₀₁, R₂₀₂ and R₂₀₃ independently represents an organic group. The number of carbon atoms of the organic group represented by R₂₀₁, R₂₀₂ and R₂₀₃ is generally in the range of 1 to 30, preferably 1 to 20. Two of R₂₀₁ to R₂₀₃ may be bonded with each other to thereby form a ring structure, and the ring within the same may contain an oxygen atom, a sulfur atom, an ester bond, an amido bond or a carbonyl group. As the group formed by bonding of two of R₂₀₁ to R₂₀₃, there can be mentioned an alkylene group (for example, a butylene group or a pentylene group).

As the organic groups represented by R₂₀₁, R₂₀₂ and R₂₀₃, there can be mentioned, for example, cations corresponding to the following cations (ZI-1), (ZI-2), (ZI-3) and (ZI-4).

Appropriate use may be made of cations with two or more of the structures of general formula (ZI). For example, use may be made of cations having a structure wherein at least one of R₂₀₁ to R₂₀₃ of a cation of general formula (ZI) is bonded with at least one of R₂₀₁ to R₂₀₃ of another cation of general formula (ZI).

As cations represented by general formula (ZI) components, there can be mentioned the following cations (ZI-1), (ZI-2), (ZI-3) and (ZI-4).

The cations (ZI-1) are cations of general formula (ZI) wherein at least one of R₂₀₁ to R₂₀₃ is an aryl group. Namely, cations (ZI-1) are arylsulfonium cations.

In the arylsulfonium cations, all of the R₂₀₁ to R₂₀₃ may be aryl groups. It is also appropriate that the R₂₀₁ to R₂₀₃ are partially an aryl group and the remainder is an alkyl group or a cycloalkyl group.

As the arylsulfonium cations, there can be mentioned, for example, a triarylsulfonium cation, a diarylalkylsulfonium cation, an aryldialkylsulfonium cation, a diarylcycloalkylsulfonium cation and an aryldicycloalkylsulfonium cation.

The aryl group of the arylsulfonium cations is preferably a phenyl group or a naphthyl group, more preferably a phenyl group. The aryl group may be one having a heterocyclic structure containing an oxygen atom, nitrogen atom, sulfur atom or the like. As the aryl group having a heterocyclic structure, there can be mentioned, for example, a pyrrole residue, a furan residue, a thiophene residue, an indole residue, a benzofuran residue, a benzothiophene residue or the like. When the arylsulfonium cation has two or more aryl groups, the two or more aryl groups may be identical to or different from each other.

The alkyl group or cycloalkyl group contained in the arylsulfonium cation according to necessity is preferably a linear or branched alkyl group having 1 to 15 carbon atoms or a cycloalkyl group having 3 to 15 carbon atoms. As such, there can be mentioned, for example, a methyl group, an ethyl group, a propyl group, an n-butyl group, a sec-butyl group, a t-butyl group, a cyclopropyl group, a cyclobutyl group, a cyclohexyl group or the like.

The aryl group, alkyl group or cycloalkyl group represented by R₂₀₁ to R₂₀₃ may have as its substituent an alkyl group (for example, 1 to 15 carbon atoms), a cycloalkyl group (for example, 3 to 15 carbon atoms), an aryl group (for example, 6 to 14 carbon atoms), an alkoxy group (for example, 1 to 15 carbon atoms), a halogen atom, a hydroxyl group or a phenylthio group. Preferred substituents are a linear or branched alkyl group having 1 to 12 carbon atoms, a cycloalkyl group having 3 to 12 carbon atoms and a linear, branched or cyclic alkoxy group having 1 to 12 carbon atoms. More preferred substituents are an alkyl group having 1 to 4 carbon atoms and an alkoxy group having 1 to 4 carbon atoms. The substituents may be contained in any one of the three R₂₀₁ to R₂₀₃, or alternatively may be contained in all three of R₂₀₁ to R₂₀₃. When R₂₀₁ to R₂₀₃ represent a phenyl group, the substituent preferably lies at the p-position of the phenyl group.

Now, the cations (ZI-2) will be described.

The cations (ZI-2) are cations of formula (ZI) wherein each of R₂₀₁ to R₂₀₃ independently represents an organic group having no aromatic ring. The aromatic rings include an aromatic ring having a heteroatom.

The organic group having no aromatic ring represented by R₂₀₁ to R₂₀₃ generally has 1 to 30 carbon atoms, preferably 1 to 20 carbon atoms.

Preferably, each of R₂₀₁ to R₂₀₃ independently represents an alkyl group, a cycloalkyl group, an allyl group or a vinyl group. More preferred groups are a linear or branched 2-oxoalkyl group, a 2-oxocycloalkyl group and an alkoxycarbonylmethyl group. Especially preferred is a linear or branched 2-oxoalkyl group.

As preferred alkyl groups and cycloalkyl groups represented by R₂₀₁ to R₂₀₃, there can be mentioned a linear or branched alkyl group having 1 to 10 carbon atoms (for example, a methyl group, an ethyl group, a propyl group, a butyl group or a pentyl group) and a cycloalkyl group having 3 to 10 carbon atoms (for example, a cyclopentyl group, a cyclohexyl group or a norbornyl group). As more preferred alkyl groups, there can be mentioned a 2-oxoalkyl group and an alkoxycarbonylmethyl group. As more preferred cycloalkyl group, there can be mentioned a 2-oxocycloalkyl group.

The 2-oxoalkyl group may be linear or branched. A group having >C=O at the 2-position of the alkyl group is preferred.

The 2-oxocycloalkyl group is preferably a group having >C=O at the 2-position of the cycloalkyl group.

As preferred alkoxy groups of the alkoxycarbonylmethyl group, there can be mentioned alkoxy groups having 1 to 5 carbon atoms (for example, a methoxy group, an ethoxy group, a propoxy group, a butoxy group or a pentoxy group).

The R₂₀₁ to R₂₀₃ may be further substituted with a halogen atom, an alkoxy group (for example, 1 to 5 carbon atoms), a hydroxyl group, a cyano group or a nitro group.

The cations (ZI-3) are those represented by the following general formula (ZI-3) which have a phenacylsulfonium salt structure. 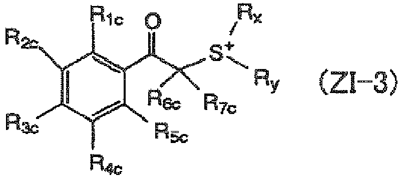 In general formula (ZI-3),
each of R_{1c} to R_{5c} independently represents a hydrogen atom, an alkyl group, a cycloalkyl group, an alkoxy group, a halogen atom or a phenylthio group.

Each of R_{6c} and R_{7c} independently represents a hydrogen atom, an alkyl group, a cycloalkyl group, halogen atom, a cyano group or an aryl group.

Each of Rₓ and R_{y} independently represents an alkyl group, a cycloalkyl group, a 2-oxoalkyl group, a 2-oxocycloalkyl group, an alkoxycarbonylalkyl group, an allyl group or a vinyl group.

Any two or more of R_{1c} to R_{5c}, and R_{6c} and R_{7c}, and Rₓ and R_{y} may be bonded with each other to thereby form a ring structure. This ring structure may contain an oxygen atom, a sulfur atom, an ester bond or an amido bond. As the group formed by bonding of any two or more of R_{1c} to R_{5c}, and R_{6c} and R_{7c}, and Rₓ and R_{y}, there can be mentioned a butylene group, a pentylene group or the like.

The alkyl group represented by R_{1c} to R_{7c} may be linear or branched. As such, there can be mentioned, for example, an alkyl group having 1 to 20 carbon atoms, preferably a linear or branched alkyl group having 1 to 12 carbon atoms (for example, a methyl group, an ethyl group, a linear or branched propyl group, a linear or branched butyl group or a linear or branched pentyl group). As the cycloalkyl group, there can be mentioned, for example, a cycloalkyl group having 3 to 8 carbon atoms (for example, a cyclopentyl group or a cyclohexyl group).

The alkoxy group represented by R_{1c} to R_{5c} may be linear, or branched, or cyclic. As such, there can be mentioned, for example, an alkoxy group having 1 to 10 carbon atoms, preferably a linear or branched alkoxy group having 1 to 5 carbon atoms (for example, a methoxy group, an ethoxy group, a linear or branched propoxy group, a linear or branched butoxy group or a linear or branched pentoxy group) and a cycloalkoxy group having 3 to 8 carbon atoms (for example, a cyclopentyloxy group or a cyclohexyloxy group).

Preferably, any one of R_{1c} to R_{5c} is a linear or branched alkyl group, a cycloalkyl group or a linear, branched or cyclic alkoxy group. More preferably, the sum of carbon atoms of R_{1c} to R_{5c} is in the range of 2 to 15. Accordingly, there can be attained an enhancement of solvent solubility and inhibition of particle generation during storage.

Each of the aryl groups represented by R_{6c} and R_{7c} preferably has 5 to 15 carbon atoms. As such, there can be mentioned, for example, a phenyl group or a naphthyl group.

When R_{6c} and R_{7c} are bonded to each other to thereby form a ring, the group formed by the bonding of R_{6c} and R_{7c} is preferably an alkylene group having 2 to 10 carbon atoms. As such, there can be mentioned, for example, an ethylene group, a propylene group, a butylene group, a pentylene group, a hexylene group or the like. Further, the ring formed by the bonding of R_{6c} and R_{7c} may have a heteroatom, such as an oxygen atom, in the ring.

As the alkyl groups and cycloalkyl groups represented by Rₓ and R_{y}, there can be mentioned the same alkyl groups and cycloalkyl groups as set forth above with respect to R_{1c} to R_{7c}.

As the 2-oxoalkyl group and 2-oxocycloalkyl group, there can be mentioned the alkyl group and cycloalkyl group represented by R_{1c} to R_{7c} having >C=O at the 2-position thereof.

With respect to the alkoxy group of the alkoxycarbonylalkyl group, there can be mentioned the same alkoxy groups as mentioned above with respect to R_{1c} to R_{5c}. As the alkyl group thereof, there can be mentioned, for example, an alkyl group having 1 to 12 carbon atoms, preferably a linear alkyl group having 1 to 5 carbon atoms (e.g., a methyl group or an ethyl group).

The allyl groups are not particularly limited. However, preferred use is made of an unsubstituted allyl group or an allyl group substituted with a cycloalkyl group of a single ring or multiple rings.

The vinyl groups are not particularly limited. However, preferred use is made of an unsubstituted vinyl group or a vinyl group substituted with a cycloalkyl group of a single ring or multiple rings.

As the ring structure that may be formed by the mutual bonding of Rₓ and R_{y}, there can be mentioned a 5-membered or 6-membered ring, especially preferably a 5-membered ring (namely, a tetrahydrothiophene ring), formed by bivalent Rₓ and R_{y} (for example, a methylene group, an ethylene group, a propylene group or the like) in cooperation with the sulfur atom of general formula (ZI-3).

Each of Rₓ and R_{y} is preferably an alkyl group or cycloalkyl group having preferably 4 or more carbon atoms. The alkyl group or cycloalkyl group has more preferably 6 or more carbon atoms and still more preferably 8 or more carbon atoms.

Specific examples of the cations (ZI-3) will be shown below.

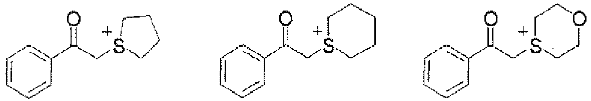

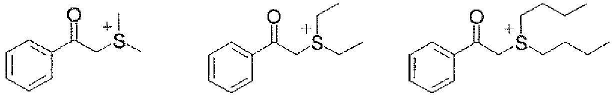

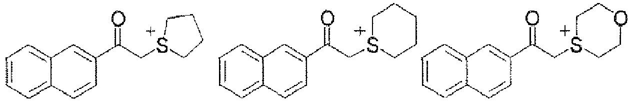

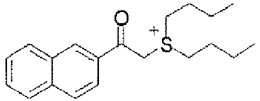

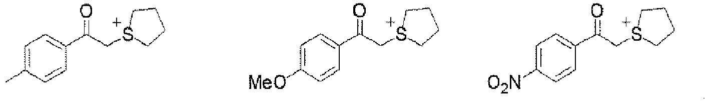

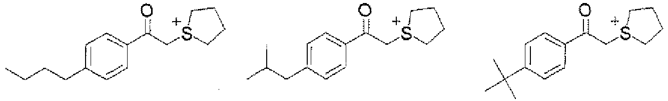

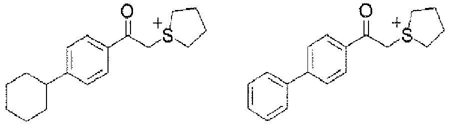

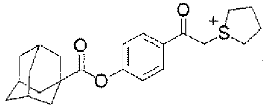

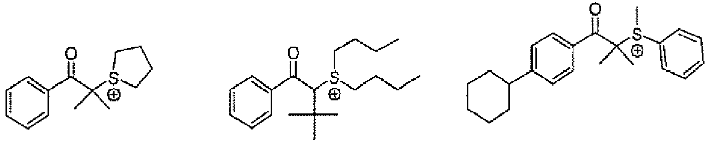

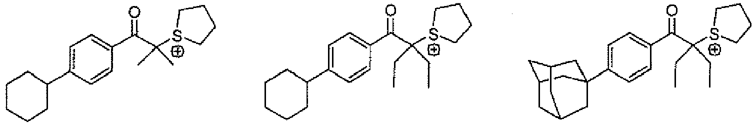

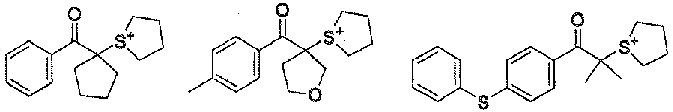

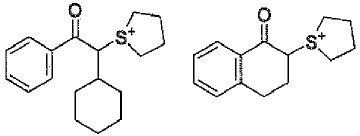

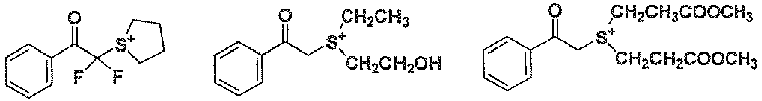

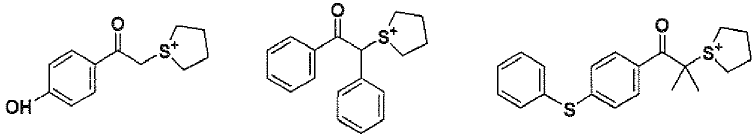

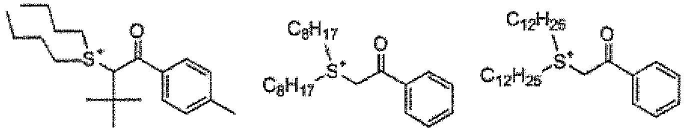

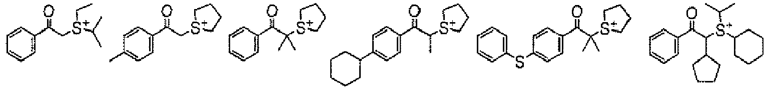

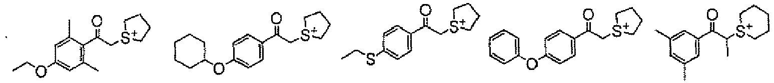

The cations (ZI-4) are those of general formula (ZI-4) below. 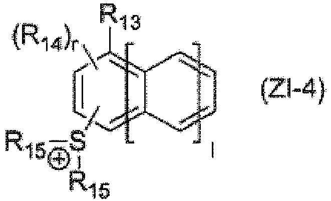 In general formula (ZI-4),
R₁₃ represents any of a hydrogen atom, a fluorine atom, a hydroxyl group, an alkyl group, a cycloalkyl group, an alkoxy group, an alkoxycarbonyl group and a group with a cycloalkyl skeleton of a single ring or multiple rings. These groups may have substituents.
R₁₄, each independently in the instance of R₁₄s, represents any of an alkyl group, a cycloalkyl group, an alkoxy group, an alkoxycarbonyl group, an alkylcarbonyl group, an alkylsulfonyl group, a cycloalkylsulfonyl group and a group with a cycloalkyl skeleton of a single ring or multiple rings. These groups may have substituents.
Each of R₁₅s independently represents an alkyl group, a cycloalkyl group or a naphthyl group, provided that the two R₁₅s may be bonded to each other to thereby form a ring. These groups may have substituents.

In the formula, 1 is an integer of 0 to 2, and
r is an integer of 0 to 8.
In general formula (ZI-4), the alkyl groups represented by R₁₃, R₁₄ and R₁₅ may be linear or branched and preferably each have 1 to 10 carbon atoms. As such, there can be mentioned a methyl group, an ethyl group, an n-propyl group, an i-propyl group, an n-butyl group, a 2-methylpropyl group, a 1-methylpropyl group, a t-butyl group, an n-pentyl group, a neopentyl group, an n-hexyl group, an n-heptyl group, an n-octyl group, a 2-ethylhexyl group, an n-nonyl group, an n-decyl group and the like. Of these alkyl groups, a methyl group, an ethyl group, an n-butyl group, a t-butyl group and the like are preferred.

As the cycloalkyl groups represented by R₁₃, R₁₄ and R₁₅, there can be mentioned cyclopropyl, cyclobutyl, cyclopentyl, cyclohexyl, cycloheptyl, cyclooctyl, cyclododecanyl, cyclopentenyl, cyclohexenyl, cyclooctadienyl, norbornyl, tricyclodecanyl, tetracyclodecanyl, adamantyl and the like. Cyclopropyl, cyclopentyl, cyclohexyl and cyclooctyl are especially preferred.

The alkoxy groups represented by R₁₃ and R₁₄ may be linear or branched and preferably each have 1 to 10 carbon atoms. As such, there can be mentioned, for example, a methoxy group, an ethoxy group, an n-propoxy group, an i-propoxy group, an n-butoxy group, a 2-methylpropoxy group, a 1-methylpropoxy group, a t-butoxy group, an n-pentyloxy group, a neopentyloxy group, an n-hexyloxy group, an n-heptyloxy group, an n-octyloxy group, a 2-ethylhexyloxy group, an n-nonyloxy group, an n-decyloxy group and the like. Of these alkoxy groups, a methoxy group, an ethoxy group, an n-propoxy group, an n-butoxy group and the like are preferred.

The alkoxycarbonyl group represented by R₁₃ and R₁₄ may be linear or branched and preferably has 2 to 11 carbon atoms. As such, there can be mentioned, for example, a methoxycarbonyl group, an ethoxycarbonyl group, an n-propoxycarbonyl group, an i-propoxycarbonyl group, an n-butoxycarbonyl group, a 2-methylpropoxycarbonyl group, a 1-methylpropoxycarbonyl group, a t-butoxycarbonyl group, an n-pentyloxycarbonyl group, a neopentyloxycarbonyl group, an n-hexyloxycarbonyl group, an n-heptyloxycarbonyl group, an n-octyloxycarbonyl group, a 2-ethylhexyloxycarbonyl group, an n-nonyloxycarbonyl group, an n-decyloxycarbonyl group and the like. Of these alkoxycarbonyl groups, a methoxycarbonyl group, an ethoxycarbonyl group, an n-butoxycarbonyl group and the like are preferred.

As the groups with a cycloalkyl skeleton of a single ring or multiple rings represented by R₁₃ and R₁₄, there can be mentioned, for example, a cycloalkyloxy group of a single ring or multiple rings and an alkoxy group with a cycloalkyl group of a single ring or multiple rings. These groups may further have substituents.

With respect to each of the cycloalkyloxy groups of a single ring or multiple rings represented by R₁₃ and R₁₄, the sum of carbon atoms thereof is preferably 7 or greater, more preferably in the range of 7 to 15. Further, having a cycloalkyl skeleton of a single ring is preferred. The cycloalkyloxy group of a single ring of which the sum of carbon atoms is 7 or greater is one composed of a cycloalkyloxy group, such as a cyclopropyloxy group, a cyclobutyloxy group, a cyclopentyloxy group, a cyclohexyloxy group, a cycloheptyloxy group, a cyclooctyloxy group or a cyclododecanyloxy group, optionally having a substituent selected from among an alkyl group such as methyl, ethyl, propyl, butyl, pentyl, hexyl, heptyl, octyl, dodecyl, 2-ethylhexyl, isopropyl, sec-butyl, t-butyl or isoamyl, a hydroxyl group, a halogen atom (fluorine, chlorine, bromine or iodine), a nitro group, a cyano group, an amido group, a sulfonamido group, an alkoxy group such as methoxy, ethoxy, hydroxyethoxy, propoxy, hydroxypropoxy or butoxy, an alkoxycarbonyl group such as methoxycarbonyl or ethoxycarbonyl, an acyl group such as formyl, acetyl or benzoyl, an acyloxy group such as acetoxy or butyryloxy, a carboxyl group and the like, provided that the sum of carbon atoms thereof, including those of any optional substituent introduced in the cycloalkyl group, is 7 or greater.

As the cycloalkyloxy group of multiple rings of which the sum of carbon atoms is 7 or greater, there can be mentioned a norbornyloxy group, a tricyclodecanyloxy group, a tetracyclodecanyloxy group, an adamantyloxy group or the like.

With respect to each of the alkyloxy groups having a cycloalkyl skeleton of a single ring or multiple rings represented by R₁₃ and R₁₄, the sum of carbon atoms thereof is preferably 7 or greater, more preferably in the range of 7 to 15. Further, the alkoxy group having a cycloalkyl skeleton of a single ring is preferred. The alkoxy group having a cycloalkyl skeleton of a single ring of which the sum of carbon atoms is 7 or greater is one composed of an alkoxy group, such as methoxy, ethoxy, propoxy, butoxy, pentyloxy, hexyloxy, heptoxy, octyloxy, dodecyloxy, 2-ethylhexyloxy, isopropoxy, sec-butoxy, t-butoxy or isoamyloxy, substituted with the above optionally substituted cycloalkyl group of a single ring, provided that the sum of carbon atoms thereof, including those of the substituents, is 7 or greater. For example, there can be mentioned a cyclohexylmethoxy group, a cyclopentylethoxy group, a cyclohexylethoxy group or the like. A cyclohexylmethoxy group is preferred.

As the alkoxy group having a cycloalkyl skeleton of multiple rings of which the sum of carbon atoms is 7 or greater, there can be mentioned a norbornylmethoxy group, a norbornylethoxy group, a tricyclodecanylmethoxy group, a tricyclodecanylethoxy group, a tetracyclodecanylmethoxy group, a tetracyclodecanylethoxy group, an adamantylmethoxy group, an adamantylethoxy group and the like. Of these, a norbornylmethoxy group, a norbornylethoxy group and the like are preferred.

With respect to the alkyl group of the alkylcarbonyl group represented by R₁₄, there can be mentioned the same specific examples as mentioned above with respect to the alkyl groups represented by R₁₃ to R₁₅.

The alkylsulfonyl and cycloalkylsulfonyl groups represented by R₁₄ may be linear, branched or cyclic and preferably each have 1 to 10 carbon atoms. As such, there can be mentioned, for example, a methanesulfonyl group, an ethanesulfonyl group, an n-propanesulfonyl group, an n-butanesulfonyl group, a tert-butanesulfonyl group, an n-pentanesulfonyl group, a neopentanesulfonyl group, an n-hexanesulfonyl group, an n-heptanesulfonyl group, an n-octanesulfonyl group, a 2-ethylhexanesulfonyl group, an n-nonanesulfonyl group, an n-decanesulfonyl group, a cyclopentanesulfonyl group, a cyclohexanesulfonyl group and the like. Of these alkylsulfonyl and cycloalkylsulfonyl groups, a methanesulfonyl group, an ethanesulfonyl group, an n-propanesulfonyl group, an n-butanesulfonyl group, a cyclopentanesulfonyl group, a cyclohexanesulfonyl group and the like are preferred.

Each of the groups may have a substituent. As such a substituent, there can be mentioned, for example, a halogen atom (e.g., a fluorine atom), a hydroxyl group, a carboxyl group, a cyano group, a nitro group, an alkoxy group, an alkoxyalkyl group, an alkoxycarbonyl group, an alkoxycarbonyloxy group or the like.

As the alkoxy group, there can be mentioned, for example, a linear, branched or cyclic alkoxy group having 1 to 20 carbon atoms, such as a methoxy group, an ethoxy group, an n-propoxy group, an i-propoxy group, an n-butoxy group, a 2-methylpropoxy group, a 1-methylpropoxy group, a t-butoxy group, a cyclopentyloxy group or a cyclohexyloxy group.

As the alkoxyalkyl group, there can be mentioned, for example, a linear, branched or cyclic alkoxyalkyl group having 2 to 21 carbon atoms, such as a methoxymethyl group, an ethoxymethyl group, a 1-methoxyethyl group, a 2-methoxyethyl group, a 1-ethoxyethyl group or a 2-ethoxyethyl group.

As the alkoxycarbonyl group, there can be mentioned, for example, a linear, branched or cyclic alkoxycarbonyl group having 2 to 21 carbon atoms, such as a methoxycarbonyl group, an ethoxycarbonyl group, an n-propoxycarbonyl group, an i-propoxycarbonyl group, an n-butoxycarbonyl group, a 2-methylpropoxycarbonyl group, a 1-methylpropoxycarbonyl group, a t-butoxycarbonyl group, a cyclopentyloxycarbonyl group or a cyclohexyloxycarbonyl group.

As the alkoxycarbonyloxy group, there can be mentioned, for example, a linear, branched or cyclic alkoxycarbonyloxy group having 2 to 21 carbon atoms, such as a methoxycarbonyloxy group, an ethoxycarbonyloxy group, an n-propoxycarbonyloxy group, an i-propoxycarbonyloxy group, an n-butoxycarbonyloxy group, a t-butoxycarbonyloxy group, a cyclopentyloxycarbonyloxy group or a cyclohexyloxycarbonyloxy group.

The cyclic structure that may be formed by the bonding of the two R₁₅s to each other is preferably a 5- or 6-membered ring, especially a 5-membered ring (namely, a tetrahydrothiophene ring) formed by two bivalent R₁₅s in cooperation with the sulfur atom of general formula (ZI-4) . The cyclic structure may condense with an aryl group or a cycloalkyl group. The bivalent R₁₅s may have substituents. As such substituents, there can be mentioned, for example, a hydroxyl group, a carboxyl group, a cyano group, a nitro group, an alkoxy group, an alkoxyalkyl group, an alkoxycarbonyl group, an alkoxycarbonyloxy group and the like as mentioned above. It is especially preferred for the R₁₅ of general formula (ZI-4) to be a methyl group, an ethyl group, the above-mentioned bivalent group allowing two R₁₅s to be bonded to each other so as to form a tetrahydrothiophene ring structure in cooperation with the sulfur atom of the general formula (ZI-4), or the like.

Each of R₁₃ and R₁₄ may have a substituent. As such a substituent, there can be mentioned, for example, a hydroxyl group, an alkoxy group, an alkoxycarbonyl group, a halogen atom (especially, a fluorine atom) or the like.

In the formula, 1 is preferably 0 or 1, more preferably 1, and r is preferably 0 to 2.

Specific examples of the cations (ZI-4) will be shown below.

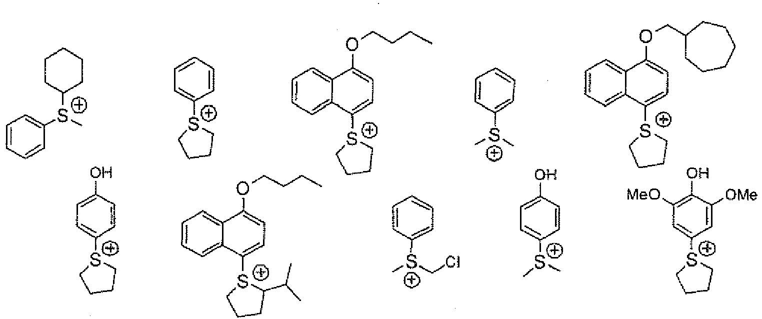

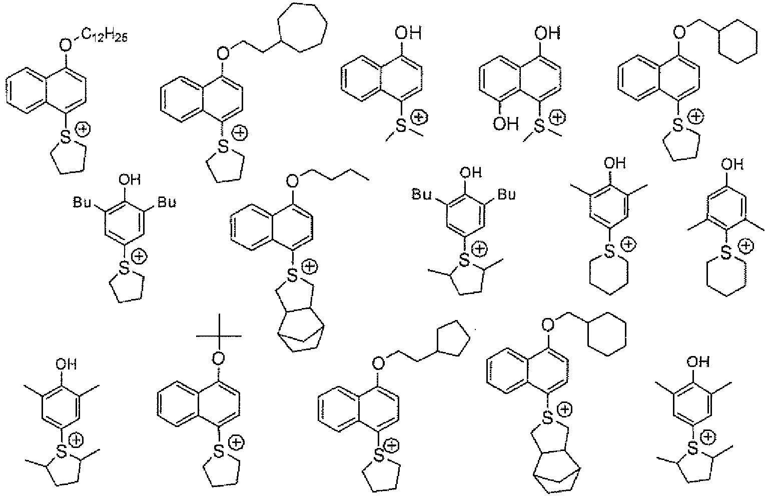

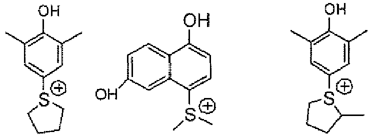

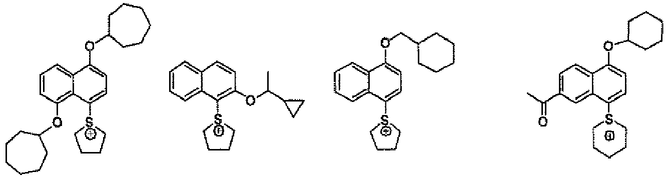

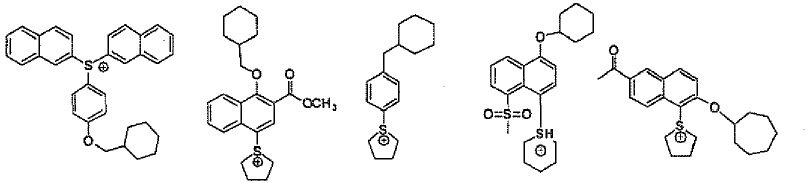

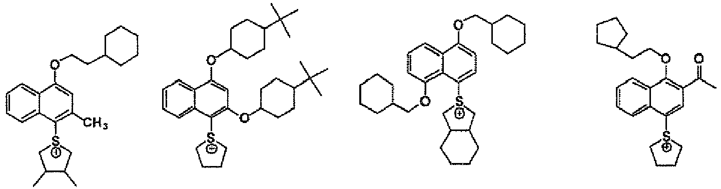

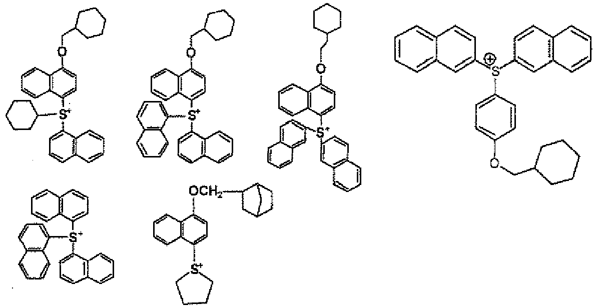

Now, general formula (ZII) above will be described.

In general formula (ZII), each of R₂₀₄ and R₂₀₅ independently represents an aryl group, an alkyl group or a cycloalkyl group.

The aryl group represented by R₂₀₄ and R₂₀₅ is preferably a phenyl group or a naphthyl group, more preferably a phenyl group. The aryl group represented by R₂₀₄ and R₂₀₅ may be one having a heterocyclic structure containing an oxygen atom, nitrogen atom, sulfur atom or the like. As the heterocyclic structure, there can be mentioned, for example, a pyrrole, a furan, a thiophene, an indole, a benzofuran, a benzothiophene or the like.

As preferred alkyl groups and cycloalkyl groups represented by R₂₀₄ and R₂₀₅, there can be mentioned a linear or branched alkyl group having 1 to 10 carbon atoms (for example, a methyl group, an ethyl group, a propyl group, a butyl group or a pentyl group) and a cycloalkyl group having 3 to 10 carbon atoms (for example, a cyclopentyl group, a cyclohexyl group or a norbornyl group).

The aryl group, alkyl group and cycloalkyl group represented by R₂₀₄ and R₂₀₅ may have a substituent. As a possible substituent on the aryl group, alkyl group and cycloalkyl group represented by R₂₀₄ and R₂₀₅, there can be mentioned, for example, an alkyl group (for example, 1 to 15 carbon atoms), a cycloalkyl group (for example, 3 to 15 carbon atoms), an aryl group (for example, 6 to 15 carbon atoms), an alkoxy group (for example, 1 to 15 carbon atoms), a halogen atom, a hydroxyl group, a phenylthio group or the like.

Specific examples of general formula (I) will be shown below.

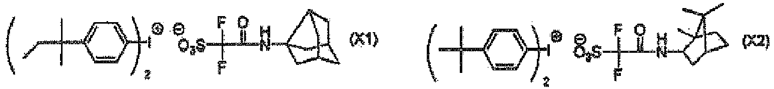

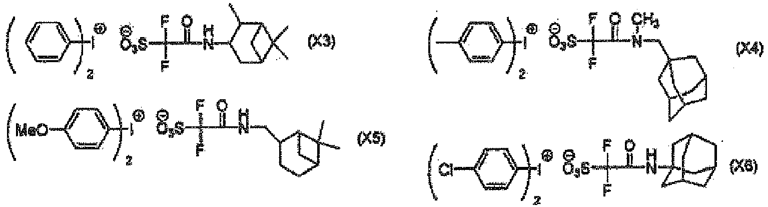

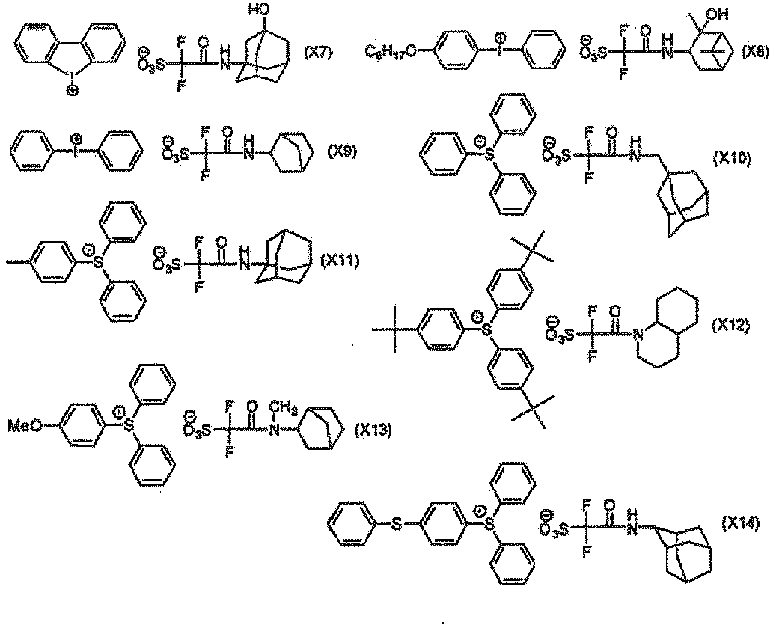

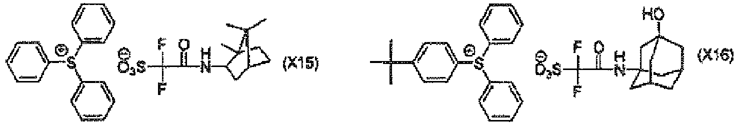

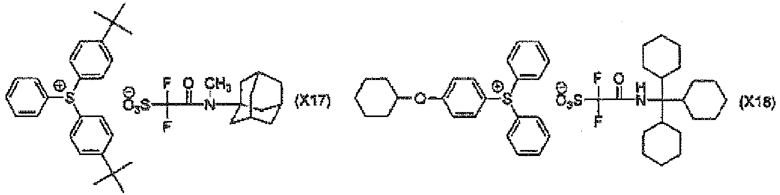

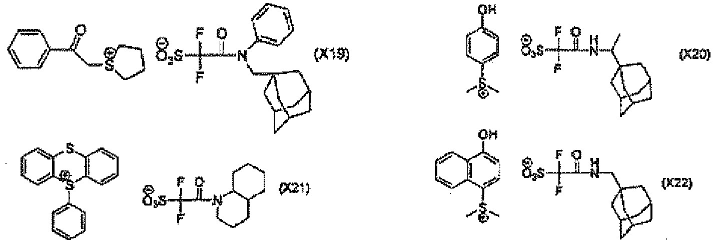

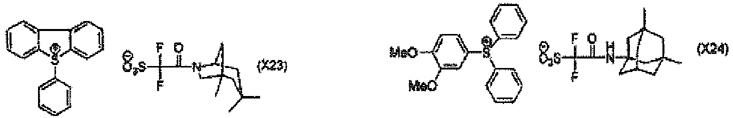

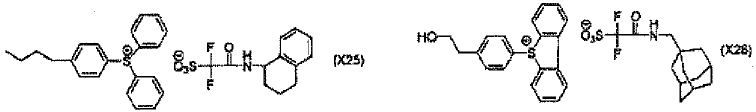

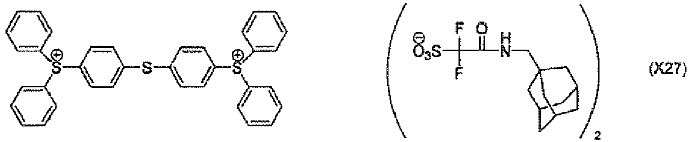

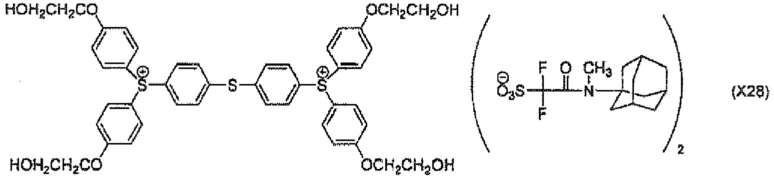

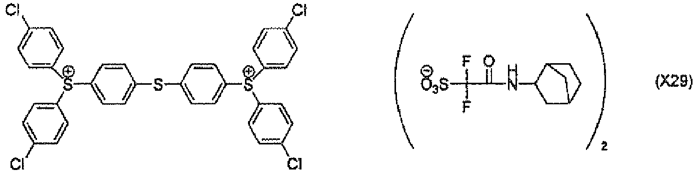

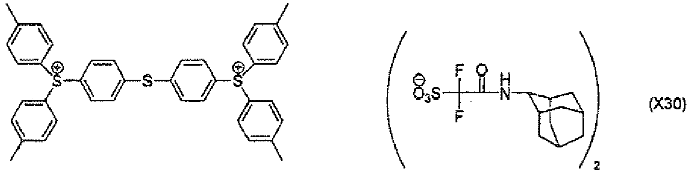

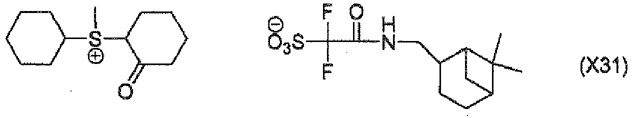

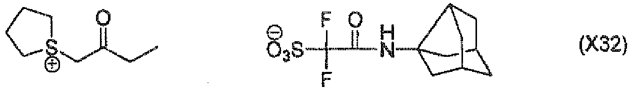

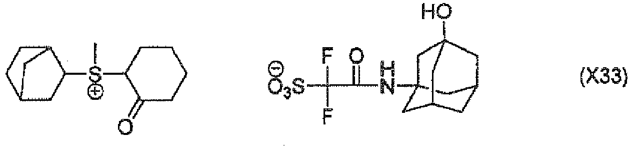

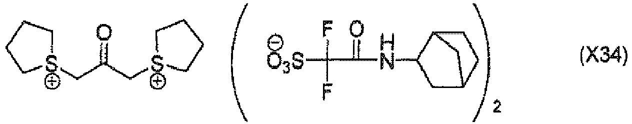

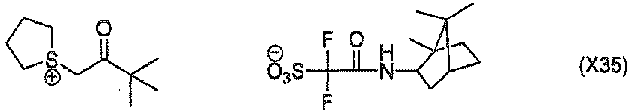

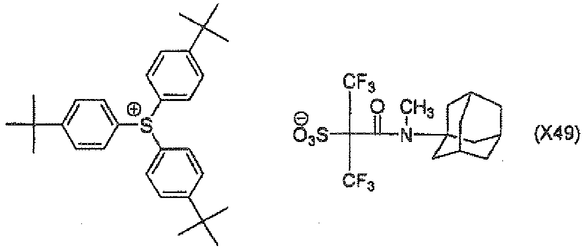

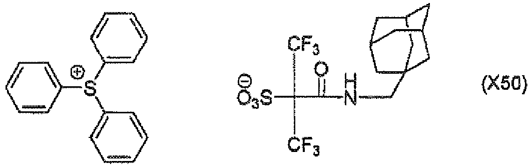

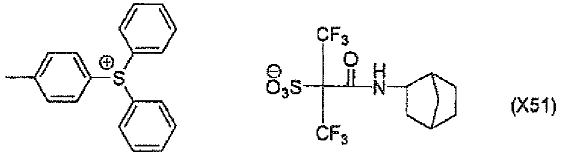

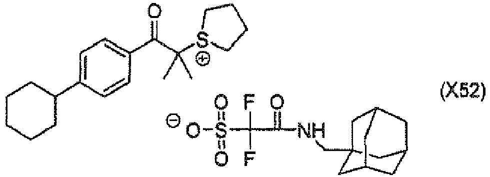

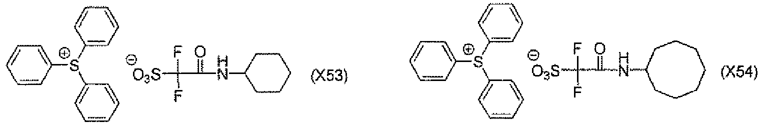

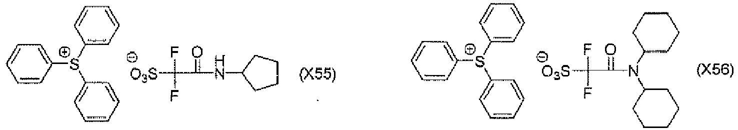

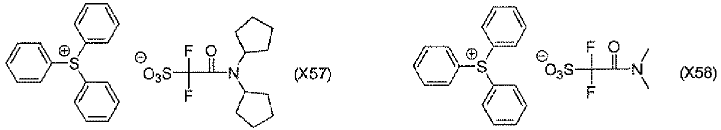

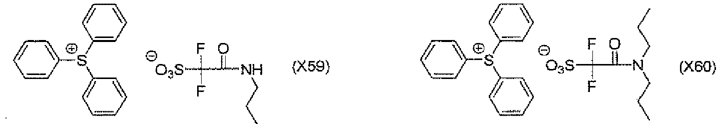

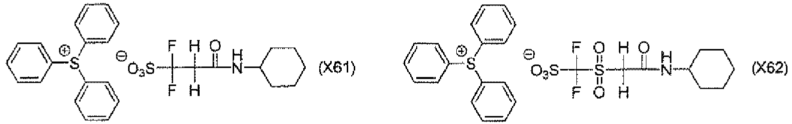

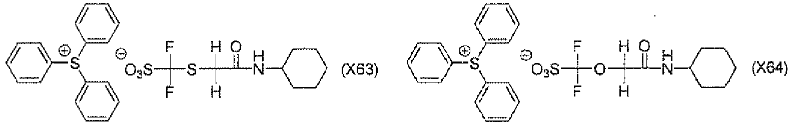

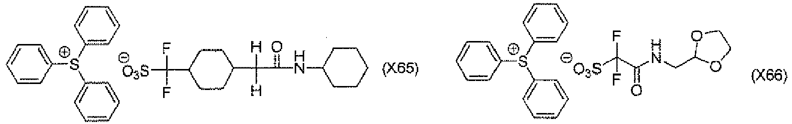

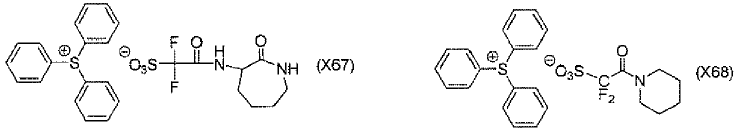

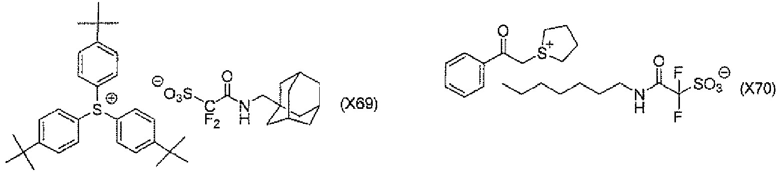

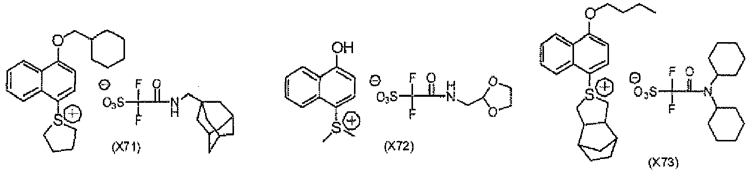

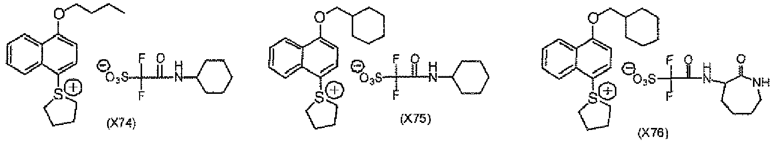

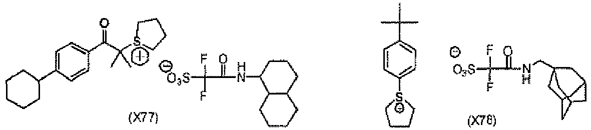

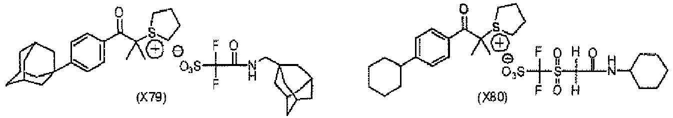

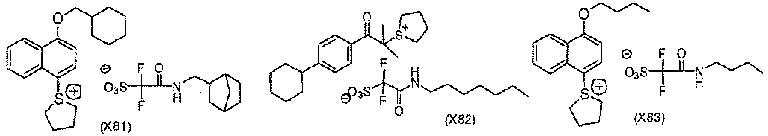

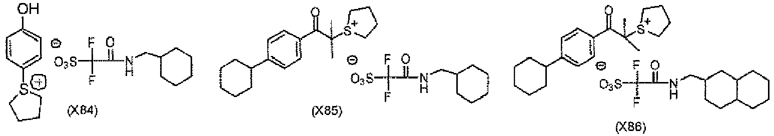

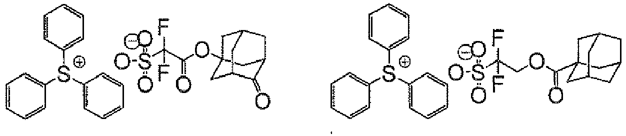

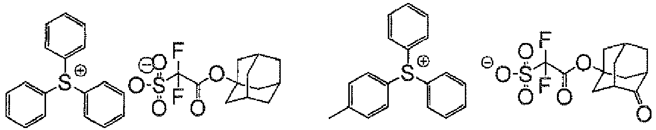

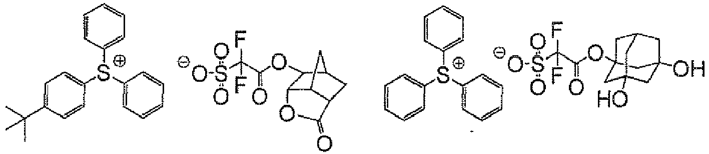

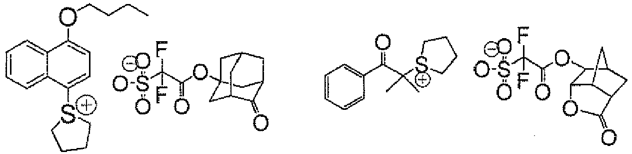

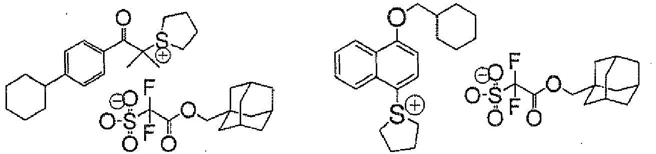

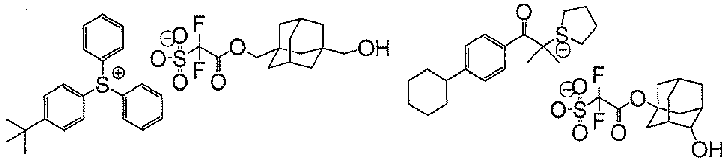

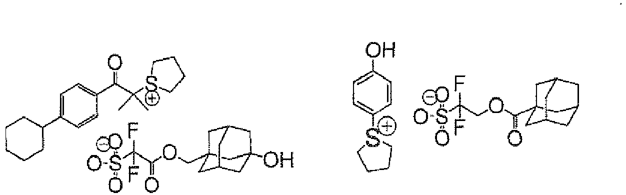

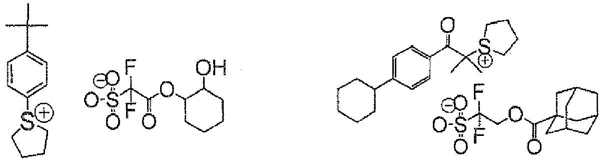

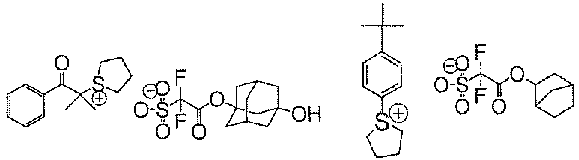

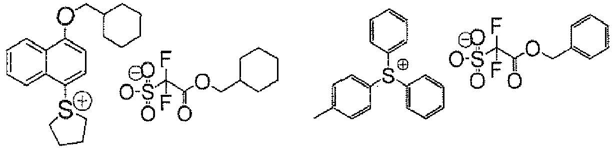

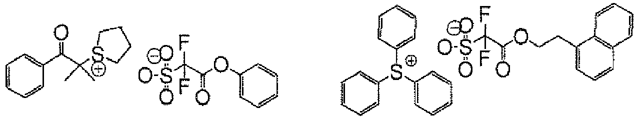

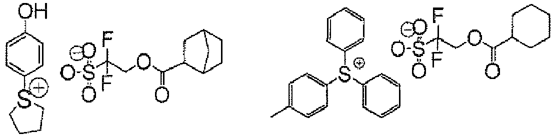

Now, the compounds of general formula (II) will be described.

R₃ represents a monovalent organic group containing a fluorine atom, the monovalent organic group exhibiting a fluorine content 0.35 or below, the fluorine content expressed by formula: (total mass of all fluorine atoms contained)/(total mass of all atoms contained). With respect to R₃, the fluorine content is preferably 0.30 or below, most preferably 0.25 or below.

When n is 2 or greater and two R₃s are bonded to each other to thereby form a ring, the above content of fluorine atoms in R₃ refers to the content of fluorine atoms contained in the bivalent group formed by the bonding of two R₃s.

When m is 1 or greater and R₃ and R₄ are bonded to each other to thereby form a ring, the above content of fluorine atoms in R₃ refers to the content of fluorine atoms contained in the bivalent group formed by the bonding of R₃ and R₄.

With respect to each of the acids generated by the compounds of general formula (II), the number of fluorine atoms contained in each molecule is preferably 8 or less, more preferably 4 or less.

As the monovalent organic group containing a fluorine atom represented by R₃, there can be mentioned an organic group containing an alkylene moiety substituted with at least one fluorine atom that is bonded to a sulfonyl group. It is preferred for the alkylene moiety to be a perfluoroalkylene group. The terminal thereof is preferably substituted with a group with a cyclic structure. The substitution may be effected through a connecting group. From the viewpoint of low fluorine content, it is preferred for this group with a cyclic structure not to contain any fluorine atom. As the monovalent organic group represented by R₃, in its one form, there can be mentioned the structure corresponding to R₃ expressed by general formula (III) to be shown hereinafter.

The group represented by R₄ is an optionally substituted alkyl group, an optionally substituted cycloalkyl group or an optionally substituted aryl group, and, from the viewpoint of acid strength, contains at least an electron withdrawing group. With respect to these, the alkyl group, cycloalkyl group and aryl group refer to a chain alkyl group, a monocyclic alkyl group, a polycyclic hydrocarbon group or a monocyclic aryl group. Substituents may be introduced in these chain alkyl group, monocyclic alkyl group, polycyclic hydrocarbon group and monocyclic aryl group.

The chain alkyl group may be in the form of a linear or branched chain. As such, there can be mentioned methyl, ethyl, propyl, butyl, pentyl, hexyl, heptyl, octyl, dodecyl, 2-ethylhexyl, isopropyl, sec-butyl, t-butyl, isoamyl or the like.

As a substituent that can be introduced in the alkyl group, there can be mentioned a hydroxyl group, a halogen atom (fluorine, chlorine, bromine or iodine), a nitro group, a cyano group, an amido group, a sulfonamido group, an alkoxy group such as methoxy, ethoxy, hydroxyethoxy, propoxy, hydroxypropoxy or butoxy, an alkoxycarbonyl group such as methoxycarbonyl or ethoxycarbonyl, an acyl group such as formyl, acetyl or benzoyl, an acyloxy group such as acetoxy or butyryloxy, or a carboxyl group.

As the monocyclic alkyl group, there can be mentioned cyclopropyl, cyclobutyl, cyclopentyl, cyclohexyl, cycloheptyl, cyclooctyl, cyclododecanyl, cyclopentenyl, cyclohexenyl, cyclooctadienyl or the like. Cyclopropyl, cyclopentyl, cyclohexyl and cyclooctyl are especially preferred.

As a substituent that can be introduced in the monocyclic alkyl group, there can be mentioned a halogen atom (fluorine, chlorine, bromine or iodine), a nitro group, a cyano group, an amido group, a sulfonamido group, an alkyl group such as methyl, ethyl, propyl, n-butyl, sec-butyl, hexyl, 2-ethylhexyl or octyl, an alkoxy group such as methoxy, ethoxy, hydroxyethoxy, propoxy, hydroxypropoxy or butoxy, an alkoxycarbonyl group such as methoxycarbonyl or ethoxycarbonyl, an acyl group such as formyl, acetyl or benzoyl, an acyloxy group such as acetoxy or butyryloxy, or a carboxyl group.

As the polycyclic hydrocarbon group, there can be mentioned bicyclo[4.3.0]nonanyl, decahydronaphthalenyl, tricyclo[5.2.1.0(2,6)]decanyl, bornyl, isobornyl, norbornyl, adamantyl, noradamantyl, 1,7,7-trimethyltricyclo[2.2.1.0^{2,6}]heptanyl, 3,7,7-trimethylbicyclo[4.1.0]heptanyl or the like. Norbornyl, adamantyl and noradamantyl are especially preferred.

The monocyclic aryl group refers to a substituted or unsubstituted phenyl group. As the substituent, there can be mentioned a hydroxyl group, a halogen atom (fluorine, chlorine, bromine or iodine), a nitro group, a cyano group, an amido group, a sulfonamido group, an alkyl group such as methyl, ethyl, propyl, n-butyl, sec-butyl, hexyl, 2-ethylhexyl or octyl, an alkoxy group such as methoxy, ethoxy, hydroxyethoxy, propoxy, hydroxypropoxy or butoxy, an alkoxycarbonyl group such as methoxycarbonyl or ethoxycarbonyl, an acyl group such as formyl, acetyl or benzoyl, an acyloxy group such as acetoxy or butyryloxy, or a carboxyl group.

The group represented by R₄ is a group containing an electron withdrawing group from the viewpoint of acid strength. The electron withdrawing group is not particularly limited. As such, there can be mentioned a cyano group, a nitro group, a carboxyl group, a ketone group, an acyloxy group, a hydroxyl group, a perfluoroalkyl group such as trifluoromethyl, an alkoxy group such as methoxy, ethoxy, isopropoxy, t-butoxy or benzyloxy, a halogen atom such as a fluorine atom or a chlorine atom, or the like. The group containing an electron withdrawing group represented by R₄ is preferably a group containing a fluorine atom, more preferably a group containing a fluorine atom whose molecular weight is up to 220 and most preferably a trifluoromethyl group.

It is preferred for the compounds of general formula (II) above to be the compounds of general formula (III) below.

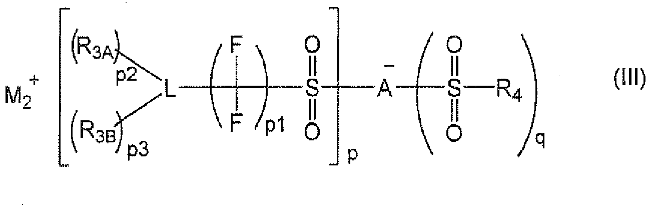

In general formula (III), A, R₄, p and q are as defined above in connection with general formula (II).

R_{3A}, or each of R_{3A}s independently, represents an optionally substituted alkyl group, an optionally substituted cycloalkyl group or an optionally substituted aryl group.

R_{3B} represents a hydrogen atom.

L represents a single bond or a connecting group.

In the formula, p1 is an integer of 1 to 8, preferably 1 to 3 and most preferably 1.

p2 is 1 or 2, and p3 is 0 or 1.

When p2 is 2, two R_{3A}s may be bonded to each other to thereby form a ring structure. When p is 2 or greater, two or more R_{3A}s may be bonded to each other to thereby form a ring structure.

As particular examples of the optionally substituted alkyl groups, optionally substituted cycloalkyl groups and optionally substituted aryl groups represented by R_{3A}, there can be mentioned the same groups as set forth above with respect to the corresponding groups represented by R₄.

It is preferred for the R_{3A} groups to contain no fluorine atom from the viewpoint of low fluorine content.

As the connecting group represented by L, there can be mentioned an oxygen atom (-O-), a sulfur atom (-S-), a nitrogen atom (>N-), a carboxyl group (-OC=O-, -CO=O-), an amido group (>NC=O-) or a sulfonamido group (>NSO₂-). When p2 is 2 and two R_{3A}s are bonded to each other to thereby form a ring, it is preferred for L to be a connecting group containing a nitrogen atom, such as an amido group or a sulfonamido group. If so, it is preferred for R_{3A} to be a cycloamine residue containing the nitrogen atom on L within its ring. As such a cycloamine residue structure, there can be mentioned aziridine, azetidine, pyrrolidine, piperidine, hexamethyleneimine, heptamethyleneimine, piperazine, decahydroquinoline, 8-azabicyclo[3.2.1]octane, indole, oxazolidine, thiazolidine, 2-azanorbornane, 7-azanorbornane, morpholine, thiamorpholine or the like. A substituent may be introduced in these structures. As the substituent, there can be mentioned a hydroxyl group, a halogen atom (fluorine, chlorine, bromine or iodine), a nitro group, a cyano group, an amido group, a sulfonamido group, an alkyl group such as methyl, ethyl, propyl, n-butyl, sec-butyl, hexyl, 2-ethylhexyl or octyl, an alkoxy group such as methoxy, ethoxy, hydroxyethoxy, propoxy, hydroxypropoxy or butoxy, an alkoxycarbonyl group such as methoxycarbonyl or ethoxycarbonyl, an acyl group such as formyl, acetyl, benzoyl or carbonyl on the carbon as a constituent of a ring, an acyloxy group such as acetoxy or butyryloxy, or a carboxyl group.

It is especially preferred for the compounds of general formula (II) above to be the compounds of general formula (IV) below.

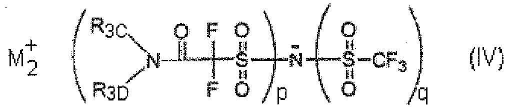

In general formula (IV), R_{3C} represents an optionally substituted alkyl group, an optionally substituted cycloalkyl group or an optionally substituted aryl group. R_{3D} represents a hydrogen atom, an optionally substituted alkyl group, an optionally substituted cycloalkyl group or an optionally substituted aryl group. R_{3C} and R_{3D} may be bonded to each other to thereby form a ring. In the formula, p+q=2, p=1 or 2, and q=0 or 1.

As particular examples of the optionally substituted alkyl groups, optionally substituted cycloalkyl groups and optionally substituted aryl groups represented by R_{3C} or R_{3D}, there can be mentioned the same groups as set forth above with respect to the corresponding groups represented by R₂ in general formula (II).

As the cycloamine structures formed by the mutual bonding of R_{3C} and R_{3D}, there can be mentioned those set forth above as the cycloamine structures formed by the mutual bonding of two R_{3A}s in general formula (III) in which L is an amido group (>NC=O-).

The method of synthesizing the acid-generating compounds of general formula (IV) is not particularly limited. For example, the compounds can be synthesized through the following procedure.

Namely, first, a compound (a) is synthesized from a corresponding amine and a fluorosultone or an acid halide or the like. The compound (a) is converted to a sulfonamide (b) by using ammonia. A sulfonimide compound (c) is derived from the sulfonamide (b). Alternatively, the compound (c) is derived from a direct reaction between the compound (a) and a corresponding sulfonimide. The desired compound can be synthesized by a salt exchange of the compound (c).

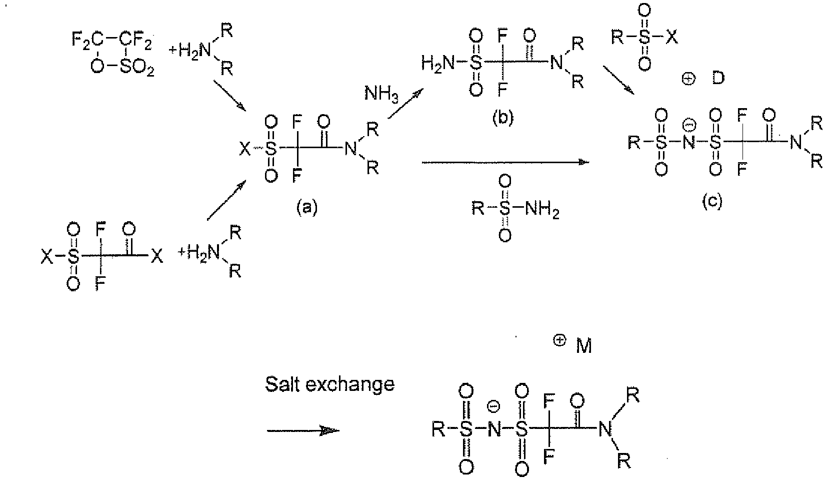

In general formulae (II) to (IV) above, the cations represented by M₂⁺ can be, for example, the same as set forth above in connection with M₁⁺.

Particular examples of the anion moieties of the compounds of general formula (II) according to the present invention are set forth below as the structures of corresponding acids.

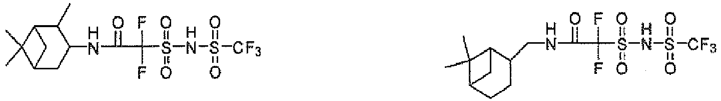

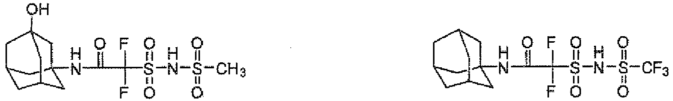

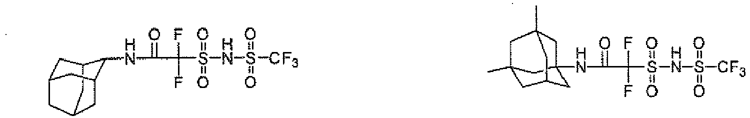

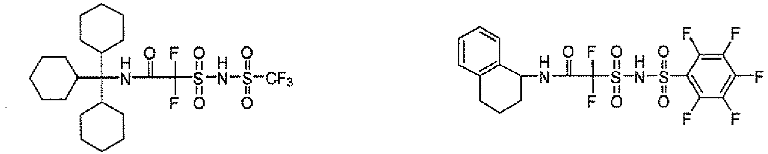

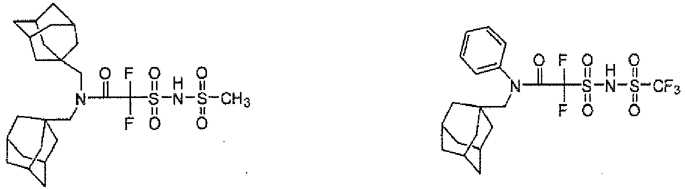

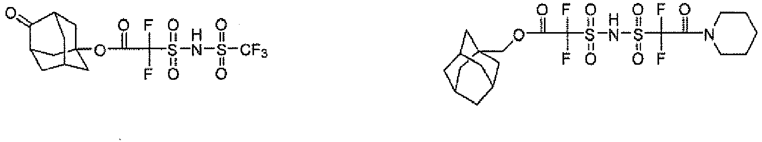

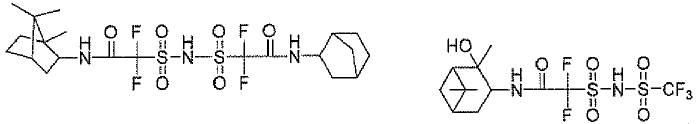

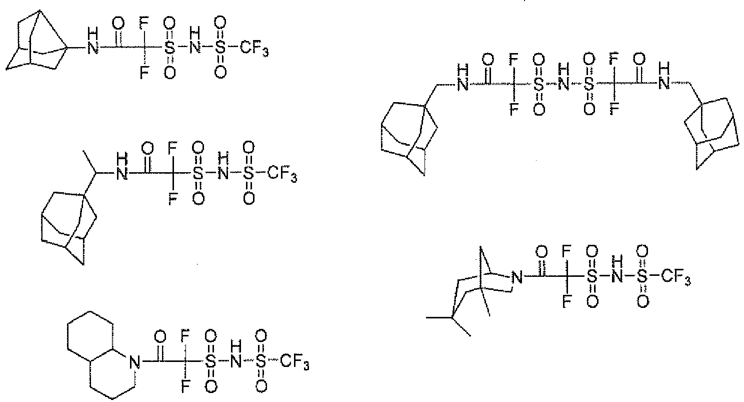

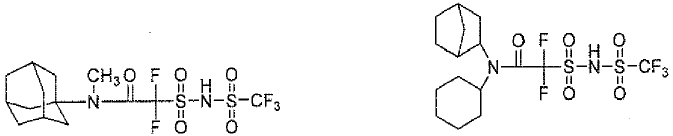

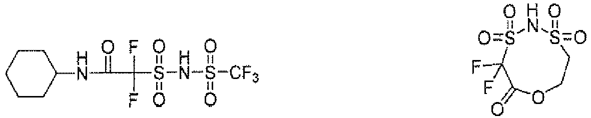

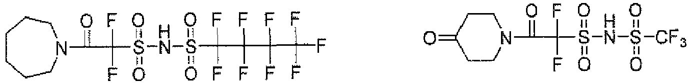

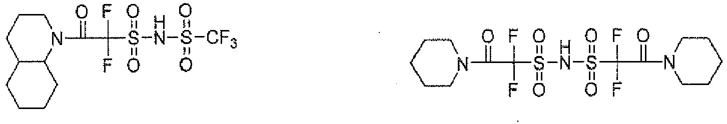

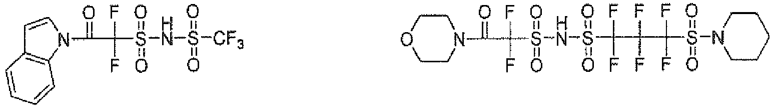

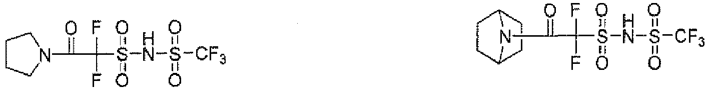

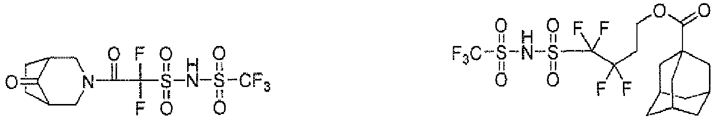

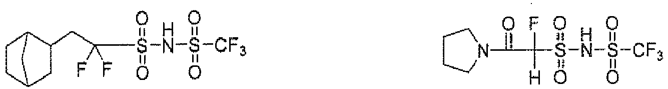

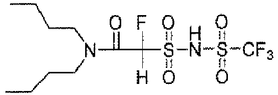

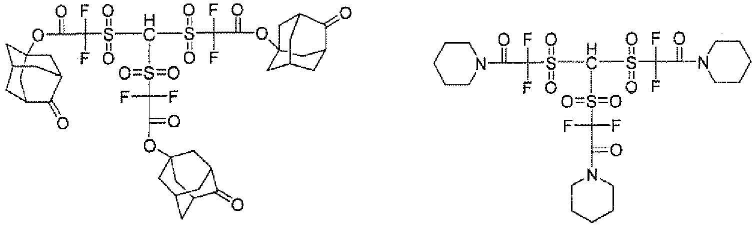

Particular examples of the compounds of general formula (II) will be described below.

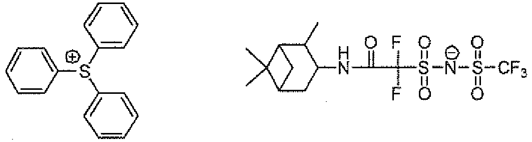

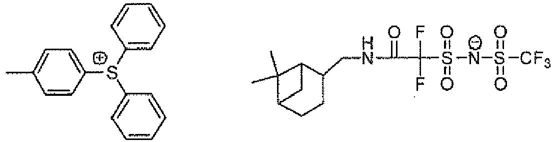

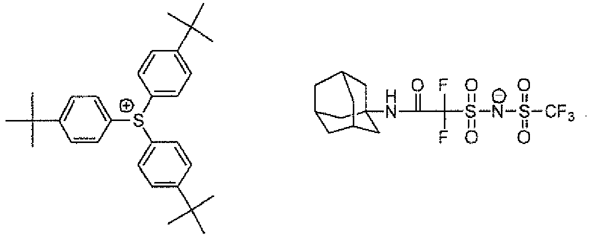

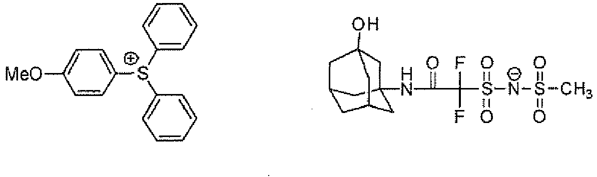

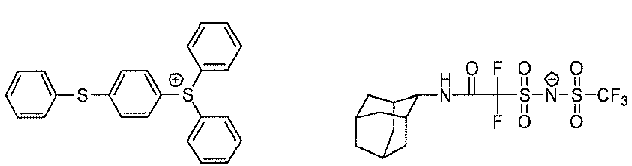

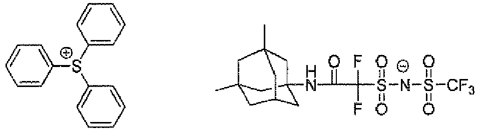

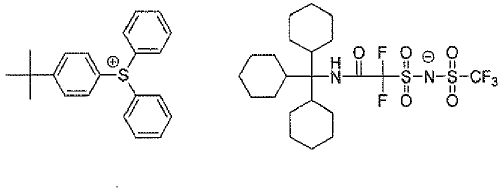

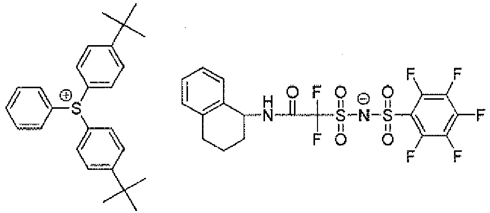

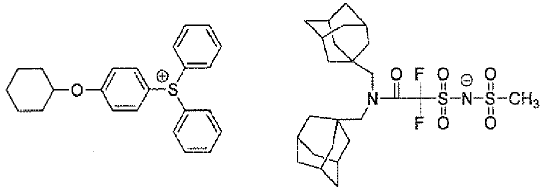

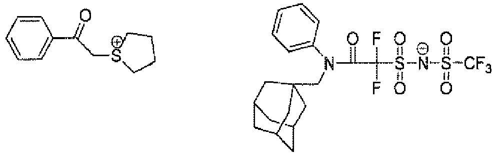

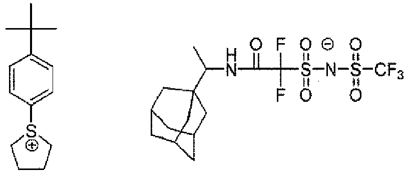

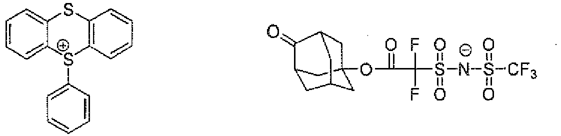

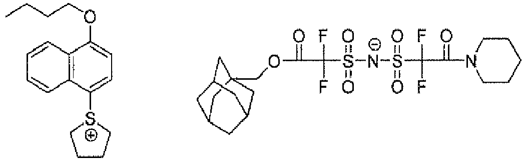

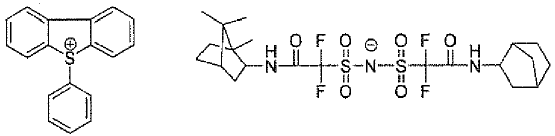

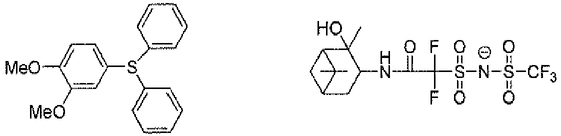

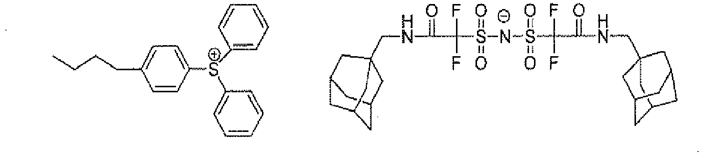

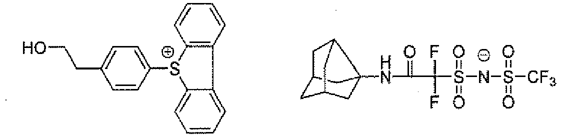

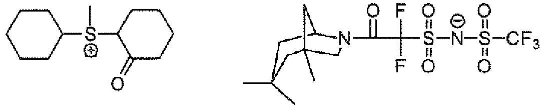

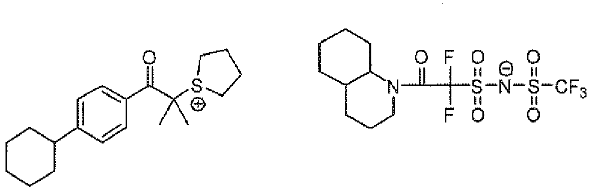

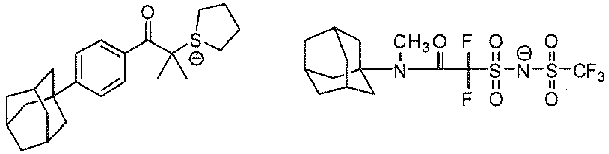

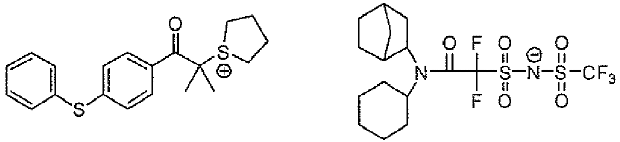

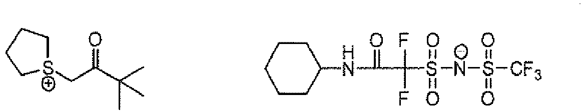

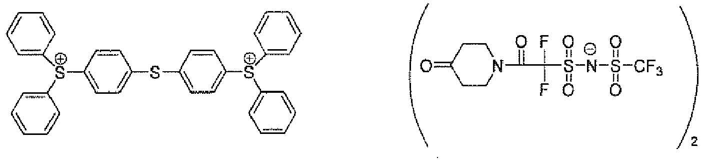

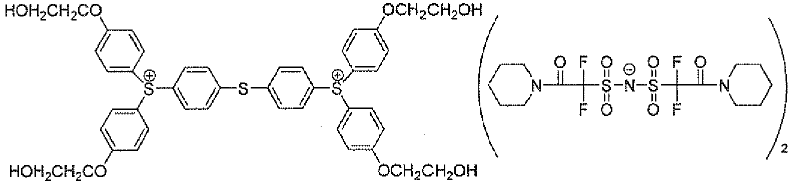

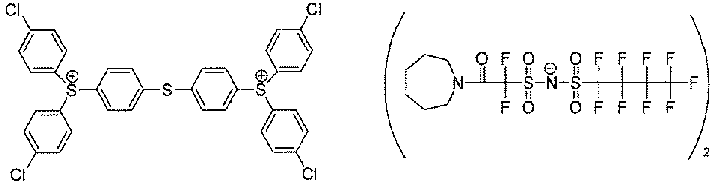

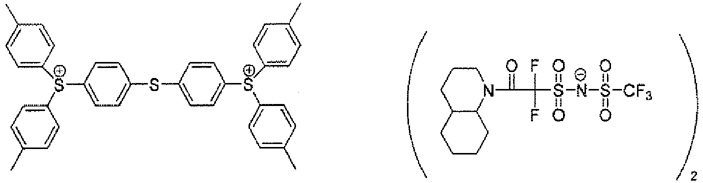

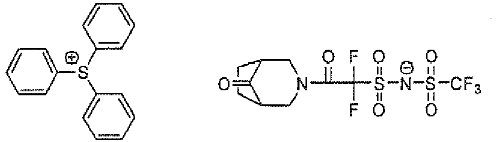

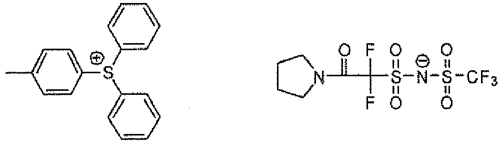

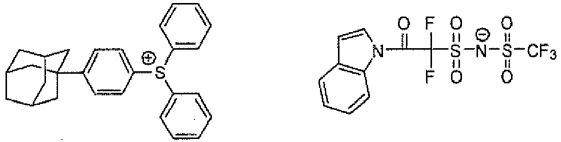

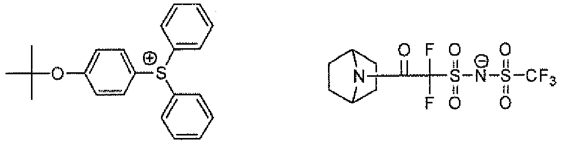

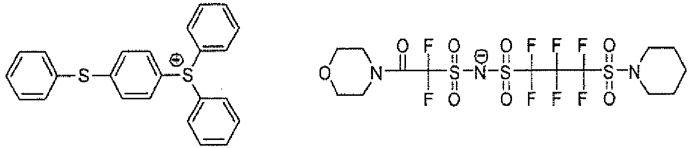

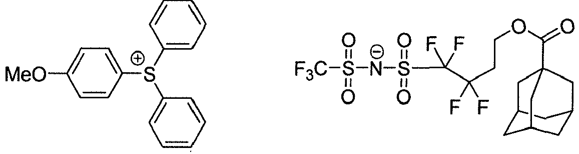

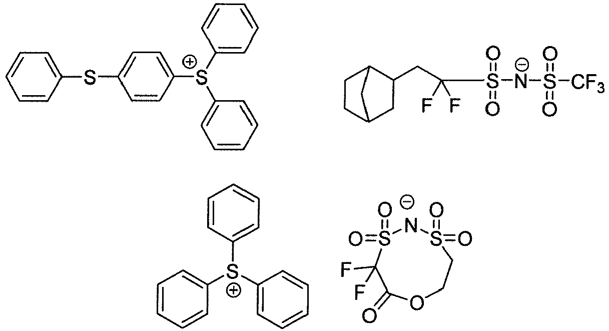

With respect to each of the compounds of general formulae (I) and (II), the fluorine content thereof expressed by the formula: (total mass of all fluorine atoms contained)/(total mass of all atoms contained) is 0.15 or less and further more preferably 0.10 or less which causes the shape of the pattern formed from the resist composition of the present invention to become more favorable.

With respect to the compounds of general formulae (I) and (II), one type thereof may be used alone, or two or more types may be used in combination.

The content of compounds of general formulae (I) and (II), based on the total solids of the composition, is preferably in the range of 0.1 to 30 mass%, more preferably 0.5 to 25 mass%, further more preferably 1 to 23 mass% and most preferably 3 to 20 mass%.

In addition to the compounds of general formulae (I) and (II), other compounds may be used in combination therewith. As such other compounds, there can be mentioned, for example, the compounds of general formulae (ZI'), (ZII') and (ZIII') below.

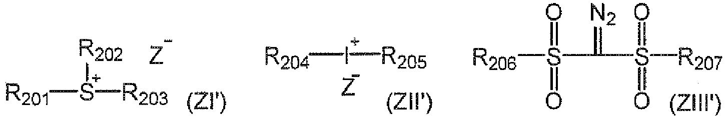

In general formula (ZI') above, R₂₀₁, R₂₀₂ and R₂₀₃ are as defined above in connection with general formula (ZI) .

Z⁻ represents a nonnucleophilic anion (anion whose capability of inducing a nucleophilic reaction is markedly low).

As the nonnucleophilic anion represented by Z⁻, a sulfonate anion (e.g. an aliphatic sulfonate anion, an aromatic sulfonate anion, and a camphor sulfonate anion), a carboxylate anion (e.g. an aliphatic carboxylate anion, an aromatic carboxylate anion, and an aralkyl carboxylate anion), a sulfonylimido anion, a bis(alkylsulfonyl)imido anion, and a tris(alkylsulfonyl)methyl anion can be exemplified.

The aliphatic moiety of the aliphatic sulfonate anion and the aliphatic carboxylate anion may be an alkyl group or a cycloalkyl group, being preferably a linear or branched alkyl group having 1 to 30 carbon atoms or a cycloalkyl group having 3 to 30 carbon atoms.

As a preferred aromatic group of the aromatic sulfonate anion and the aromatic carboxylate anion, an aryl group having 6 to 14 carbon atoms, such as a phenyl group, a tolyl group and a naphthyl group can be exemplified.

The alkyl group, cycloalkyl group and aryl group mentioned above may have one or more substituents. As such, a nitro group, a halogen atom such as a fluorine atom, a carboxy group, a hydroxy group, an amino group, a cyano group, an alkoxy group (preferably having 1 to 15 carbon atoms), a cycloalkyl group (preferably having 3 to 15 carbon atoms), an aryl group (preferably having 6 to 14 carbon atoms), an alkoxycarbonyl group (preferably having 2 to 7 carbon atoms), an acyl group (preferably having 2 to 12 carbon atoms), an alkoxycarbonyloxy group (preferably having 2 to 7 carbon atoms), an alkylthio group (preferably having 1 to 15 carbon atoms), an alkylsulfonyl group (preferably having 1 to 15 carbon atoms), an alkyliminosulfonyl group (preferably having 2 to 15 carbon atoms), an aryloxysulfonyl group (preferably having 6 to 20 carbon atoms), an alkylaryloxysulfonyl group (preferably having 7 to 20 carbon atoms), a cycloalkylaryloxysulfonyl group (preferably having 10 to 20 carbon atoms), an alkyloxyalkyloxy group (preferably having 5 to 20 carbon atoms), and a cycloalkylalkyloxyalkyloxy group (preferably having 8 to 20 carbon atoms) can be exemplified. The aryl group or ring structure of these groups may further have an alkyl group (preferably having 1 to 15 carbon atoms) as its substituent.

As a preferred aralkyl group of the aralkyl carboxylate anion, an aralkyl group having 6 to 12 carbon atoms, such as a benzyl group, a phenethyl group, a naphthylmethyl group, a naphthylethyl group, and a naphthylbutyl group can be exemplified.

As the sulfonylimido anion, a saccharin anion can be exemplified.

The alkyl group of the bis(alkylsulfonyl)imido anion and tris (alkylsulfonyl) methyl anion is preferably an alkyl group having 1 to 5 carbon atoms. As a substituent of these alkyl groups, a halogen atom, an alkyl group substituted with a halogen atom, an alkoxy group, an alkylthio group, an alkyloxysulfonyl group, an aryloxysulfonyl group, and a cycloalkylaryloxysulfonyl group can be exemplified. A fluorine atom or an alkyl group substituted with a fluorine atom is preferred.

As the other nonnucleophilic anions, PF₆⁻, BF₄⁻, and SbF₆⁻ can be exemplified.

The nonnucleophilic anion represented by Z⁻ is preferably selected from among an aliphatic sulfonate anion substituted at its α-position of sulfonic acid with a fluorine atom, an aromatic sulfonate anion substituted with one or more fluorine atoms or a group having a fluorine atom, a bis(alkylsulfonyl)imido anion whose alkyl group is substituted with one or more fluorine atoms and a tris(alkylsulfonyl)methide anion whose alkyl group is substituted with one or more fluorine atoms. More preferably, the nonnucleophilic anion is a perfluorinated aliphatic sulfonate anion (more preferably having 4 to 8 carbon atoms) or a benzene sulfonate anion having a fluorine atom. Still more preferably, the nonnucleophilic anion is a nonafluorobutane sulfonate anion, a perfluorooctane sulfonate anion, a pentafluorobenzene sulfonate anion or a 3,5-bis(trifluoromethyl)benzene sulfonate anion.

From the viewpoint of acid strength, pKa of the generated acid is preferably -1 or lower. Employing such embodiment can make sensitivity of the composition become higher.

In general formulae (ZII') and (ZIII'), each of R₂₀₄ to R₂₀₇ independently represents an aryl group, an alkyl group or a cycloalkyl group.

As such, those explained with respect to the groups represented by R₂₀₁ to R₂₀₃ in the compound (ZI-1) can be exemplified.

The aryl group, the alkyl group and the cycloalkyl group represented by R₂₀₄ to R₂₀₇ may have one or more substituents. As such, those explained with respect to the groups represented by R₂₀₁ to R₂₀₃ in the compound (ZI-1) can be exemplified.

Z⁻ represents a nonnucleophilic anion. As such, those explained with respect to the groups represented by Z⁻ in general formula (ZI') can be exemplified.

As the acid generators that can be used in combination with the acid generators according to the present invention, the compounds represented by the following general formulae (ZIV'), (ZV') and (ZVI') can further be exemplified. 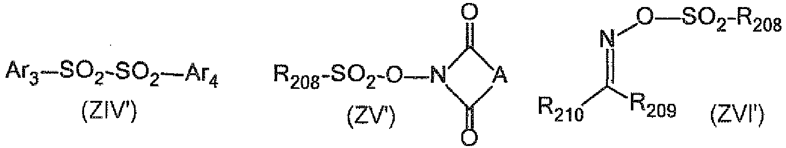 In general formulae (ZIV') to (ZVI'),
each of Ar₃ and Ar₄ independently represents an aryl group.

Each of R₂₀₈, R₂₀₉ and R₂₁₀ independently represents an alkyl group, a cycloalkyl group or an aryl group.

A represents an alkylene group, an alkenylene group or an arylene group.

Especially preferred examples of the acid generators that can be used in combination with the acid generators according to the present invention are shown below.

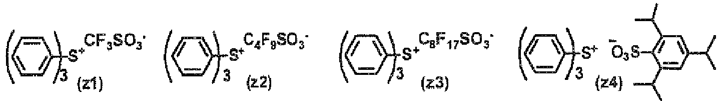

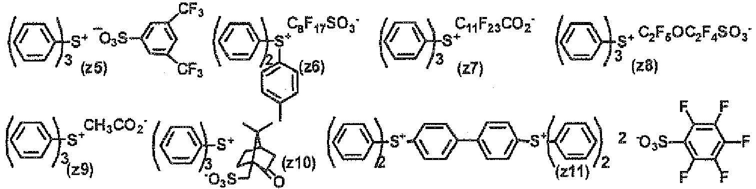

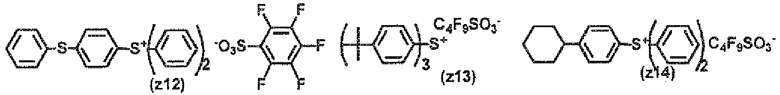

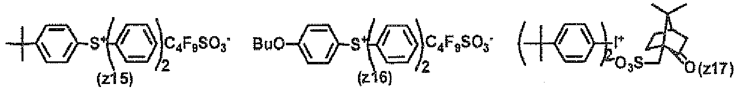

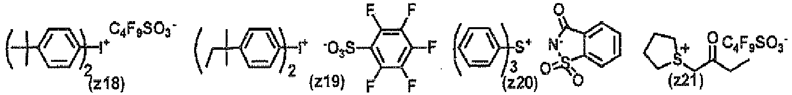

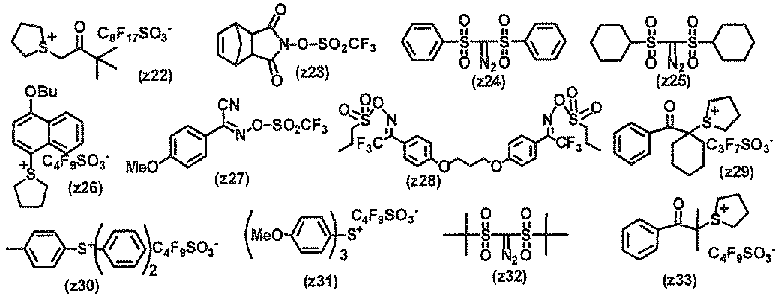

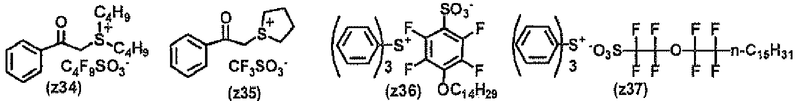

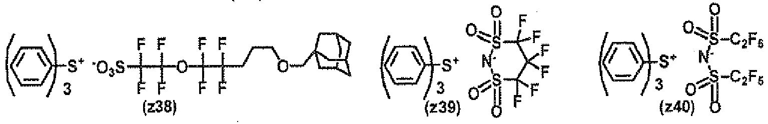

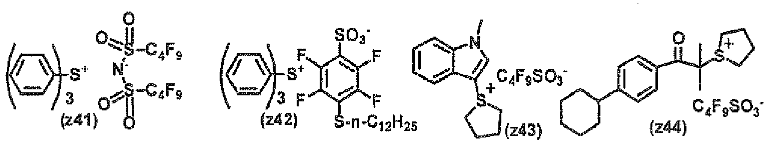

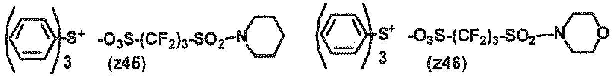

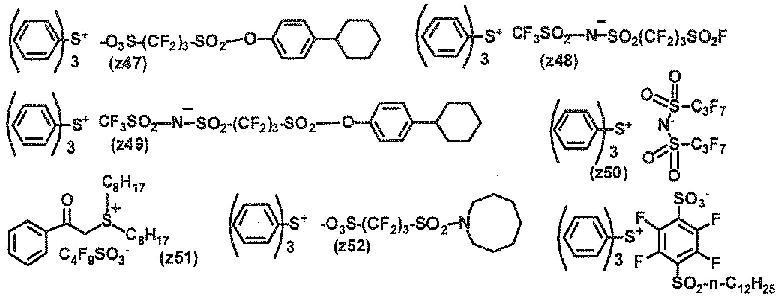

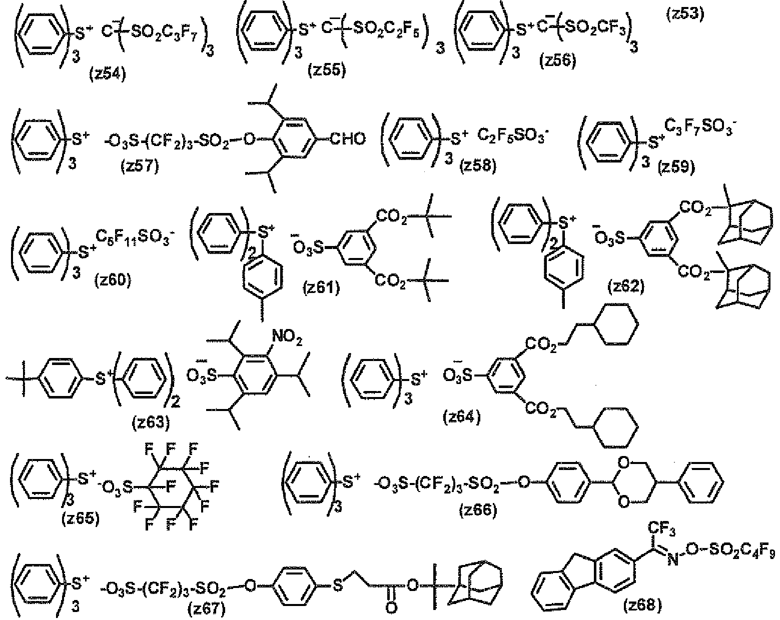

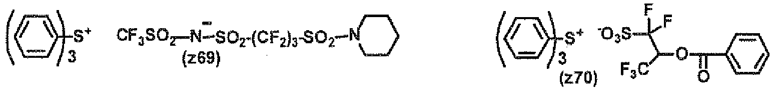

When compounds other than those of general formulae (I) and (II) are used in combination with the latter as the photoacid generators, the content thereof based on the total amount of compounds of general formulae (I) and (II) is preferably 50 mass% or less, more preferably 25 mass% or less and further more preferably 20 mass% or less.

### (C) Hydrophobic resin

The hydrophobic resin (hereinafter also referred to as a "resin (C)") contains at least either a fluorine atom or a silicon atom.

The fluorine atom and/or silicon atom may be introduced in the principal chain of the hydrophobic resin or a side chain thereof.

When the hydrophobic resin contains a fluorine atom, it is preferred for the resin to comprise, as a partial structure containing a fluorine atom, an alkyl group containing a fluorine atom, a cycloalkyl group containing a fluorine atom or an aryl group containing a fluorine atom.

The alkyl group having a fluorine atom is a linear or branched alkyl group whose at least one hydrogen atom is replaced by a fluorine atom. The alkyl group preferably has 1 to 10 carbon atoms, more preferably 1 to 4 carbon atoms. A further other substituent may be introduced in the alkyl group.

The cycloalkyl group having a fluorine atom is a mono- or polycycloalkyl group whose at least one hydrogen atom is replaced by a fluorine atom. A further other substituent may be introduced in the cycloalkyl group.

As the aryl group containing a fluorine atom, there can be mentioned one having at least one hydrogen atom of an aryl group, such as a phenyl or naphthyl group, substituted with a fluorine atom. Further, other substituents may be contained.

As preferred alkyl groups containing a fluorine atom, cycloalkyl groups containing a fluorine atom and aryl groups containing a fluorine atom, there can be mentioned groups of the following general formulae (F2) to (F4), which however in no way limit the scope of the present invention. 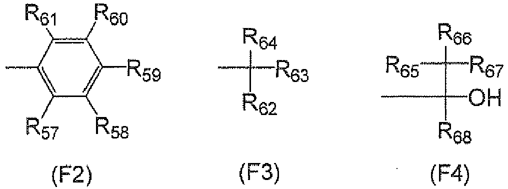 In general formulae (F2) to (F4),
each of R₅₇ to R₆₈ independently represents a hydrogen atom, a fluorine atom or an alkyl group (linear or branched), provided that at least one of each of R₅₇-R₆₁, at least one of each of R₆₂-R₆₄ and at least one of each of R₆₅-R₆₈ represent a fluorine atom or an alkyl group (preferably having 1 to 4 carbon atoms) having at least one hydrogen atom thereof substituted with a fluorine atom.

It is preferred that all of R₅₇-R₆₁ and R₆₅-R₆₇ represent fluorine atoms. Each of R₆₂, R₆₃ and R₆₈ preferably represents a fluoroalkyl group (especially having 1 to 4 carbon atoms), more preferably a perfluoroalkyl group having 1 to 4 carbon atoms. When each of R₆₂ and R₆₃ represents a perfluoroalkyl group, R₆₄ preferably represents a hydrogen atom. R₆₂ and R₆₃ may be bonded with each other to thereby form a ring.

Specific examples of the groups of general formula (F2) include a p-fluorophenyl group, a pentafluorophenyl group, a 3,5-di(trifluoromethyl)phenyl group and the like.

Specific examples of the groups of general formula (F3) include a trifluoromethyl group, a pentafluoropropyl group, a pentafluoroethyl group, a heptafluorobutyl group, a hexafluoroisopropyl group, a heptafluoroisopropyl group, a hexafluoro(2-methyl)isopropyl group, a nonafluorobutyl group, an octafluoroisobutyl group, a nonafluorohexyl group, a nonafluoro-t-butyl group, a perfluoroisopentyl group, a perfluorooctyl group, a perfluoro(trimethyl)hexyl group, a 2,2,3,3-tetrafluorocyclobutyl group, a perfluorocyclohexyl group and the like. Of these, a hexafluoroisopropyl group, a heptafluoroisopropyl group, a hexafluoro(2-methyl)isopropyl group, an octafluoroisobutyl group, a nonafluoro-t-butyl group and a perfluoroisopentyl group are preferred. A hexafluoroisopropyl group and a heptafluoroisopropyl group are more preferred.

Specific examples of the groups of general formula (F4) include -C(CF₃)₂OH, -C(C₂F₅)₂OH, -C(CF₃)(CF₃)OH, -CH(CF₃)OH and the like. -C(CF₃)₂OH is preferred.

The partial structure containing a fluorine atom may be directly bonded to the principal chain, or may be bonded to the principal chain through a group selected from the group consisting of an alkylene group, a phenylene group, an ether group, a thioether group, a carbonyl group, an ester group, an amido group, a urethane group and a ureylene group, or through a group composed of a combination of two or more of these groups.

As preferred repeating units having a fluorine atom, there can be mentioned the repeating units represented by the general formulae below.

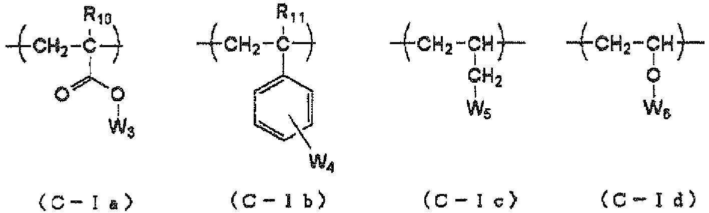

In the formulae, each of R₁₀ and R₁₁ independently represents a hydrogen atom, a fluorine atom or an alkyl group. The alkyl group is preferably a linear or branched alkyl group having 1 to 4 carbon atoms. The alkyl group may have a substituent. As a substituted alkyl group, there can be mentioned, in particular, a fluorinated alkyl group.

Each of W₃ to W₆ independently represents an organic group containing at least one fluorine atom. As such, for example, there can be mentioned the atomic groups of general formulae (F2) to (F4) above.

Further, besides these, the following units may be introduced as the repeating unit containing a fluorine atom.

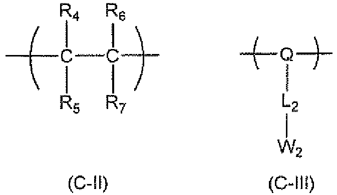

In the formulae, each of R₄ to R₇ independently represents a hydrogen atom, a fluorine atom or an alkyl group. The alkyl group is preferably a linear or branched alkyl group having 1 to 4 carbon atoms. The alkyl group may have a substituent. As a substituted alkyl group, there can be mentioned, in particular, a fluorinated alkyl group.

At least one of R₄ to R₇ represents a fluorine atom. R₄ and R₅, or R₆ and R₇ may cooperate with each other to thereby form a ring.

W₂ represents an organic group containing at least one fluorine atom. As such, for example, there can be mentioned the atomic groups of general formulae (F2) to (F4) above.

L₂ represents a single bond or a bivalent connecting group. As the bivalent connecting group, there can be mentioned a substituted or unsubstituted arylene group, a substituted or unsubstituted alkylene group, a substituted or unsubstituted cycloalkylene group, -O-, -SO₂-, -CO-, -N(R)- (in the formula, R is a hydrogen atom or an alkyl group), -NHSO₂- or a bivalent connecting group consisting of a combination of two or more of these.

Q represents an alicyclic structure. A substituent may be introduced in the alicyclic structure. The alicyclic structure may be monocyclic or polycyclic. The alicyclic structure when being polycyclic may be a bridged one. The alicyclic structure when being monocyclic is preferably a cycloalkyl group having 3 to 8 carbon atoms. As such, there can be mentioned, for example, a cyclopentyl group, a cyclohexyl group, a cyclobutyl group, a cyclooctyl group or the like. As the polycyclic one, there can be mentioned a group with, for example, a bicyclo, tricyclo or tetracyclo structure having 5 or more carbon atoms. A cycloalkyl group having 6 to 20 carbon atoms is preferred. As such, there can be mentioned, for example, an adamantyl group, a norbornyl group, a dicyclopentyl group, a tricyclodecanyl group, a tetracyclododecyl group or the like. The carbon atoms of the cycloalkyl group may be partially replaced with a heteroatom, such as an oxygen atom. It is especially preferred for Q to represent a norbornyl group, a tricyclodecanyl group, a tetracyclododecyl group or the like.

The hydrophobic resin may contain a silicon atom.

It is preferred for the hydrophobic resin to have an alkylsilyl structure (preferably a trialkylsilyl group) or a cyclosiloxane structure as a partial structure having a silicon atom.

As the alkylsilyl structure or cyclosiloxane structure, there can be mentioned, for example, any of the groups of the following general formulae (CS-1) to (CS-3) or the like. 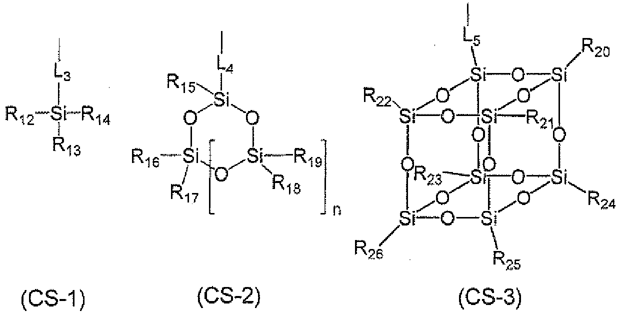 In general formulae (CS-1) to (CS-3),
each of R₁₂ to R₂₆ independently represents a linear or branched alkyl group (preferably having 1 to 20 carbon atoms) or a cycloalkyl group (preferably having 3 to 20 carbon atoms).

Each of L₃ to L₅ represents a single bond or a bivalent connecting group. As the bivalent connecting group, there can be mentioned any one or a combination of two or more groups selected from the group consisting of an alkylene group, a phenylene group, an ether group, a thioether group, a carbonyl group, an ester group, an amido group, a urethane group and a urea group.

In the formulae, n is an integer of 1 to 5. n is preferably an integer of 2 to 4.

It is preferred for the repeating unit containing at least either a fluorine atom or a silicon atom to be a (meth)acrylate repeating unit.

Particular examples of the repeating units each containing at least either a fluorine atom or a silicon atom are shown below, which in no way limit the scope of the present invention.

In the particular examples, X₁ represents a hydrogen atom, -CH₃, -F or -CF₃, and X₂ represents -F or -CF₃.

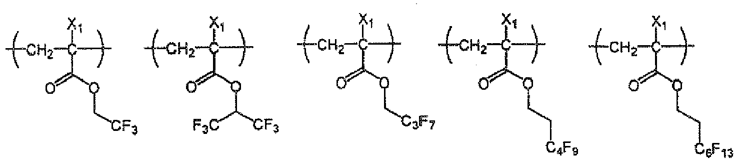

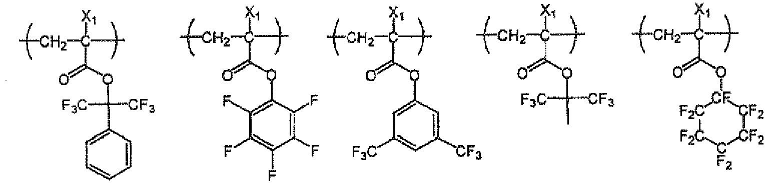

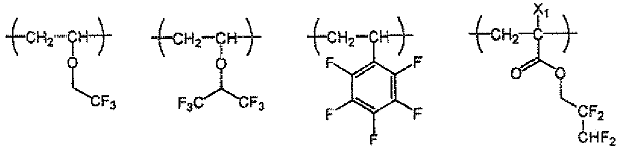

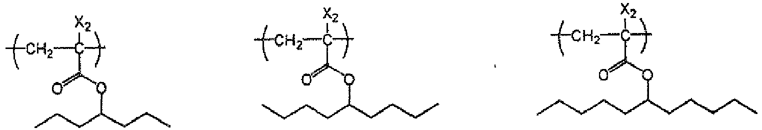

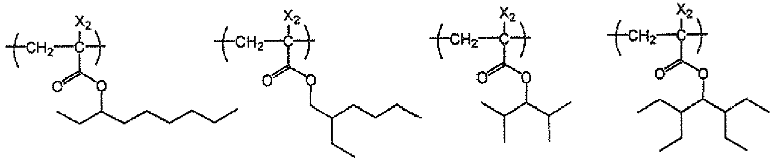

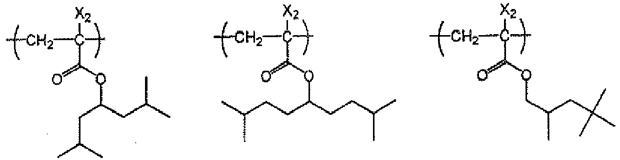

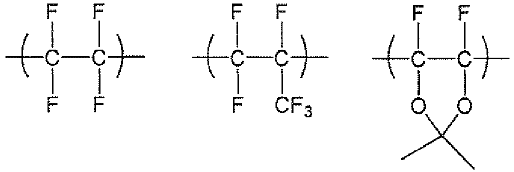

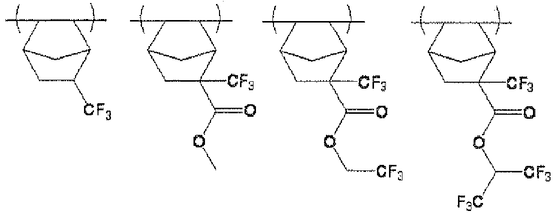

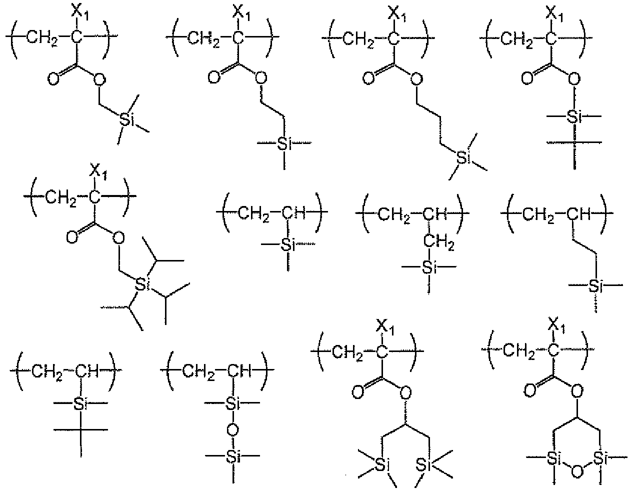

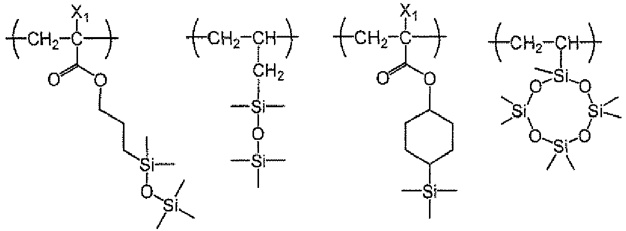

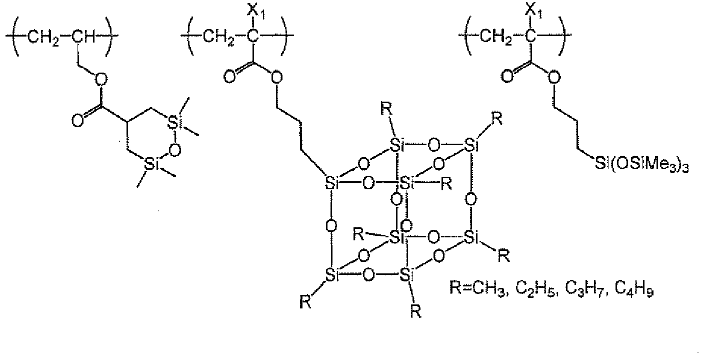

It is preferred for the hydrophobic resin to contain a repeating unit (b) containing at least one group selected from the group consisting of the following groups (x) to (z) .

Namely,
(x) an alkali-soluble group,
(y) a group that when acted on by an alkali developer, is decomposed to thereby increase its solubility in the alkali developer (polarity conversion group), and
(z) a group that when acted on by an acid, is decomposed to thereby increase its solubility in an alkali developer.

The following varieties of repeating units (b) can be mentioned.

Namely, the repeating unit (b) may be:
a repeating unit (b') containing at least either a fluorine atom or a silicon atom and at least one group selected from the group consisting of the above groups (x) to (z) simultaneously introduced in one side chain thereof,
a repeating unit (b*) containing at least one group selected from the group consisting of the above groups (x) to (z) but containing neither a fluorine atom nor a silicon atom, or
a repeating unit (b") in which at least one group selected from the group consisting of the above groups (x) to (z) is introduced in its one side chain while at least either a fluorine atom or a silicon atom is introduced in a side chain other than the above side chain within the same repeating unit.

It is preferred for the hydrophobic resin to contain the repeating unit (b') as the repeating unit (b). Namely, it is preferred for the repeating unit (b) containing at least one group selected from the group consisting of the above groups (x) to (z) to further contain at least either a fluorine atom or a silicon atom.

When the hydrophobic resin contains the repeating unit (b*), it is preferred for the hydrophobic resin to be a copolymer with a repeating unit (repeating unit other than the above-mentioned repeating units (b') and (b")) containing at least either a fluorine atom or a silicon atom. In the repeating unit (b"), it is preferred for the side chain containing at least one group selected from the group consisting of the above groups (x) to (z) and the side chain containing at least either a fluorine atom or a silicon atom to be bonded to the same carbon atom of the principal chain, namely to be in a positional relationship shown in formula (K1) below.

In the formula, B1 represents a partial structure containing at least one group selected from the group consisting of the above groups (x) to (z), and B2 represents a partial structure containing at least either a fluorine atom or a silicon atom.

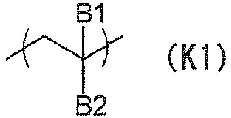

The group selected from the group consisting of the above groups (x) to (z) is preferably (x) an alkali-soluble group or (y) a polarity conversion group, more preferably (y) a polarity conversion group.

As the alkali-soluble group (x), there can be mentioned a phenolic hydroxyl group, a carboxylate group, a fluoroalcohol group, a sulfonate group, a sulfonamido group, a sulfonimido group,
an (alkylsulfonyl)(alkylcarbonyl)methylene group,
an (alkylsulfonyl)(alkylcarbonyl)imido group,
a bis(alkylcarbonyl)methylene group,
a bis(alkylcarbonyl)imido group,
a bis(alkylsulfonyl)methylene group,
a bis(alkylsulfonyl)imido group,
a tris(alkylcarbonyl)methylene group,
a tris(alkylsulfonyl)methylene group or the like.

As preferred alkali-soluble groups, there can be mentioned a fluoroalcohol group (preferably hexafluoroisopropanol group), a sulfonimido group and a bis(alkylcarbonyl)methylene group.

As the repeating unit (bx) having an alkali soluble group (x), preferred use is made of any of a repeating unit resulting from direct bonding of an alkali soluble group to the principal chain of a resin like a repeating unit of acrylic acid or methacrylic acid, a repeating unit resulting from bonding, via a connecting group, of an alkali soluble group to the principal chain of a resin and a repeating unit resulting from polymerization with the use of a chain transfer agent or polymerization initiator having an alkali soluble group to thereby introduce the same in a polymer chain terminal.

When the repeating unit (bx) is a repeating unit containing at least either a fluorine atom or a silicon atom (namely, when corresponding to the above-mentioned repeating unit (b') or repeating unit (b")), the partial structure containing a fluorine atom contained in the repeating unit (bx) can be the same as set forth above in connection with the repeating unit containing at least either a fluorine atom or a silicon atom. As such, preferably, there can be mentioned any of the groups of general formulae (F2) to (F4) above. Also in that instance, the partial structure containing a silicon atom contained in the repeating unit (bx) can be the same as set forth above in connection with the repeating unit containing at least either a fluorine atom or a silicon atom. As such, preferably, there can be mentioned any of the groups of general formulae (CS-1) to (CS-3) above.

The content ratio of repeating units (bx) having an alkali soluble group (x) is preferably in the range of 1 to 50 mol%, more preferably 3 to 35 mol% and still more preferably 5 to 20 mol% based on all the repeating units of the hydrophobic resin.

Specific examples of the repeating units (bx) having an alkali-soluble group (x) will be shown below.

In the formulae, Rx represents a hydrogen atom, -CH₃, -CF₃ or -CH₂OH, and X₁ represents a hydrogen atom, -CH₃, -F or -CF₃.

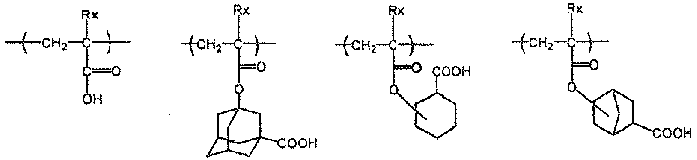

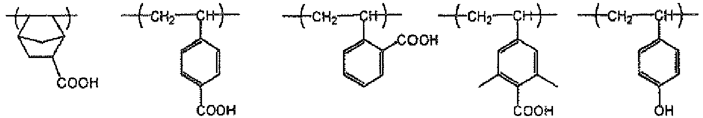

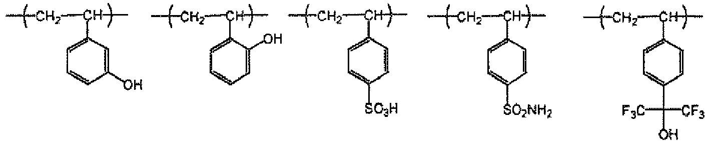

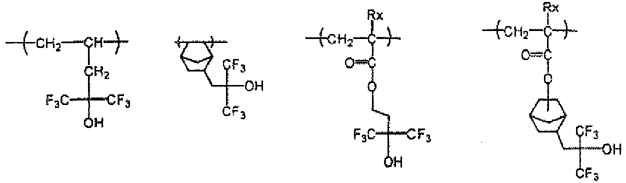

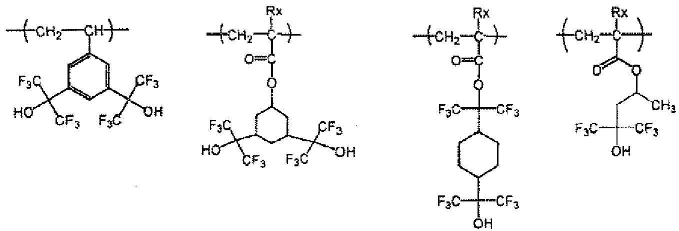

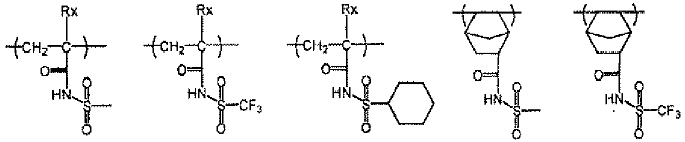

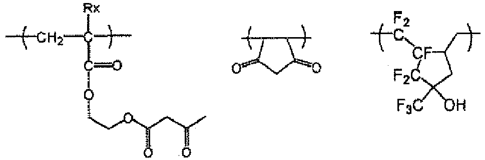

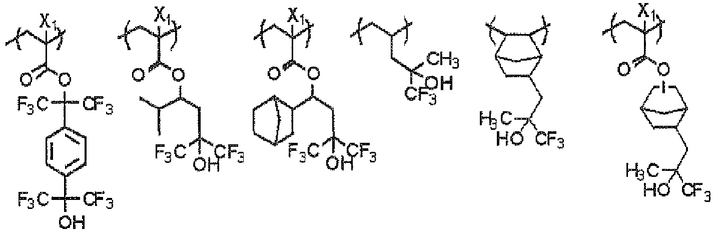

As the polarity conversion group (y), there can be mentioned, for example, a lactone group, a carboxylic ester group (-COO-), an acid anhydride group (-C(O)OC(O)-), an acid imido group (-NHCONH-), a carboxylic thioester group (-COS-), a carbonic ester group (-OC(O)O-), a sulfuric ester group (-OSO₂O-), a sulfonic ester group (-SO₂O-) or the like. A lactone group is particularly preferred.

The polarity conversion group (y) is contained in, for example, two modes which are both preferred. In one mode, the polarity conversion group (y) is contained in a repeating unit of an acrylic ester or methacrylic ester and introduced in a side chain of a resin. In the other mode, the polarity conversion group is introduced in a terminal of a polymer chain by using a polymerization initiator or chain transfer agent containing the polarity conversion group (y) in the stage of polymerization.

As particular examples of the repeating units (by) each containing a polarity conversion group (y), there can be mentioned the repeating units with a lactone structure of formulae (KA-1-1) to (KA-1-17) to be shown hereinafter.

Further, it is preferred for the repeating unit (by) containing a polarity conversion group (y) to be a repeating unit containing at least either a fluorine atom or a silicon atom (namely, corresponding to the above-mentioned repeating unit (b') or repeating unit (b")). The resin comprising this repeating unit (by) is hydrophobic, and is especially preferred from the viewpoint of the reduction of development defects.

As the repeating unit (by), there can be mentioned, for example, any of the repeating units of formula (K0) below.

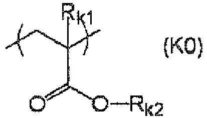

In the formula, Rₖ₁ represents a hydrogen atom, a halogen atom, a hydroxyl group, an alkyl group, a cycloalkyl group, an aryl group or a group containing a polarity conversion group.

Rₖ₂ represents an alkyl group, a cycloalkyl group, an aryl group or a group containing a polarity conversion group.

Here, at least one of Rₖ₁ and Rₖ₂ is a group containing a polarity conversion group.

The polarity conversion group, as mentioned above, refers to a group that is decomposed by the action of an alkali developer to thereby increase its solubility in the alkali developer. It is preferred for the polarity conversion group to be a group represented by X in the partial structures of general formulae (KA-1) and (KB-1) below.

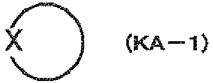

**Y¹-X-Y²** **(KB-1)**

In general formulae (KA-1) and (KB-1), X represents a carboxylic ester group (-COO-), an acid anhydride group (-C(O)OC(O)-), an acid imido group (-NHCONH-), a carboxylic thioester group (-COS-), a carbonic ester group (-OC(O)O-), a sulfuric ester group (-OSO₂O-) or a sulfonic ester group (-SO₂O-).

Y¹ and Y² may be identical to or different from each other, and each thereof represents an electron withdrawing group.

The repeating unit (by) contains a preferred group whose solubility in an alkali developer is increased by containing a group with the partial structure of general formula (KA-1) or (KB-1). When the partial structure has no bonding hand as in the case of the partial structure of general formula (KA-1) or the partial structure of general formula (KB-1) in which Y¹ and Y² are monovalent, the above group with the partial structure refers to a group containing a monovalent or higher-valent group resulting from the deletion of at least one arbitrary hydrogen atom from the partial structure.

The partial structure of general formula (KA-1) or (KB-1) is linked at its arbitrary position to the principal chain of the hydrophobic resin via a substituent.

The partial structure of general formula (KA-1) is a structure in which a ring structure is formed in cooperation with a group represented by X.

In general formula (KA-1), X is preferably a carboxylic ester group (namely, in the case of the formation of a lactone ring structure as KA-1), an acid anhydride group or a carbonic ester group. More preferably, X is a carboxylic ester group.

A substituent may be introduced in the ring structure of general formula (KA-1). For example, when Zₖₐ₁ is a substituent, nka substituents may be introduced.

Zₖₐ₁, or each of a plurality of Zₖₐ₁s independently, represents a halogen atom, an alkyl group, a cycloalkyl group, an ether group, a hydroxyl group, an amido group, an aryl group, a lactone ring group or an electron withdrawing group.

Zₖₐ₁s may be linked to each other to thereby form a ring. As the ring formed by the mutual linkage of Zₖₐ₁s, there can be mentioned, for example, a cycloalkyl ring or a heterocycle (for example, a cycloether ring or a lactone ring).

The above nka is an integer of 0 to 10, preferably 0 to 8, more preferably 0 to 5, further more preferably 1 to 4 and most preferably 1 to 3.

The electron withdrawing groups represented by Zₖₐ₁ are the same as those represented by Y¹ and Y² to be described hereinafter. These electron withdrawing groups may be substituted with other electron withdrawing groups.

Zₖₐ₁ is preferably an alkyl group, a cycloalkyl group, an ether group, a hydroxyl group or an electron withdrawing group. Zₖₐ₁ is more preferably an alkyl group, a cycloalkyl group or an electron withdrawing group. It is preferred for the ether group to be one substituted with, for example, an alkyl group or a cycloalkyl group, namely, to be an alkyl ether group or the like. The electron withdrawing group is as mentioned above.

As the halogen atom represented by Zₖₐ₁, there can be mentioned a fluorine atom, a chlorine atom, a bromine atom, an iodine atom or the like. Among these, a fluorine atom is preferred.

The alkyl group represented by Zₖₐ₁ may contain a substituent, and may be linear or branched. The linear alkyl group preferably has 1 to 30 carbon atoms, more preferably 1 to 20 carbon atoms. As the linear alkyl group, there can be mentioned, for example, a methyl group, an ethyl group, an n-propyl group, an n-butyl group, a sec-butyl group, a t-butyl group, an n-pentyl group, an n-hexyl group, an n-heptyl group, an n-octyl group, an n-nonyl group, an n-decanyl group or the like. The branched alkyl group preferably has 3 to 30 carbon atoms, more preferably 3 to 20 carbon atoms. As the branched alkyl group, there can be mentioned, for example, an i-propyl group, an i-butyl group, a t-butyl group, an i-pentyl group, a t-pentyl group, an i-hexyl group, a t-hexyl group, an i-heptyl group, a t-heptyl group, an i-octyl group, a t-octyl group, an i-nonyl group, a t-decanyl (t-decanoyl) group or the like. It is preferred for the alkyl group represented by Zₖₐ₁ to be one having 1 to 4 carbon atoms, such as a methyl group, an ethyl group, an n-propyl group, an i-propyl group, an n-butyl group, an i-butyl group or a t-butyl group.

The cycloalkyl group represented by Zₖₐ₁ may contain a substituent and may be monocyclic or polycyclic. When polycyclic, the cycloalkyl group may be a bridged one. Namely, in that case, the cycloalkyl group may have a bridged structure. The monocycloalkyl group is preferably a cycloalkyl group having 3 to 8 carbon atoms. As such a cycloalkyl group, there can be mentioned, for example, a cyclopropyl group, a cyclopentyl group, a cyclohexyl group, a cyclobutyl group, a cyclooctyl group or the like. As the polycycloalkyl group, there can be mentioned a group with, for example, a bicyclo, tricyclo or tetracyclo structure having 5 or more carbon atoms. This polycycloalkyl group is preferably a cycloalkyl group having 6 to 20 carbon atoms. As such, there can be mentioned, for example, an adamantyl group, a norbornyl group, an isobornyl group, a camphonyl group, a bicyclopentyl group, an α-pinanyl group, a tricyclodecanyl group, a tetracyclododecyl group, an androstanyl group or the like. As the cycloalkyl groups, there can also be mentioned any of the following structures. The carbon atoms of each of the cycloalkyl groups may be partially replaced with a heteroatom, such as an oxygen atom.

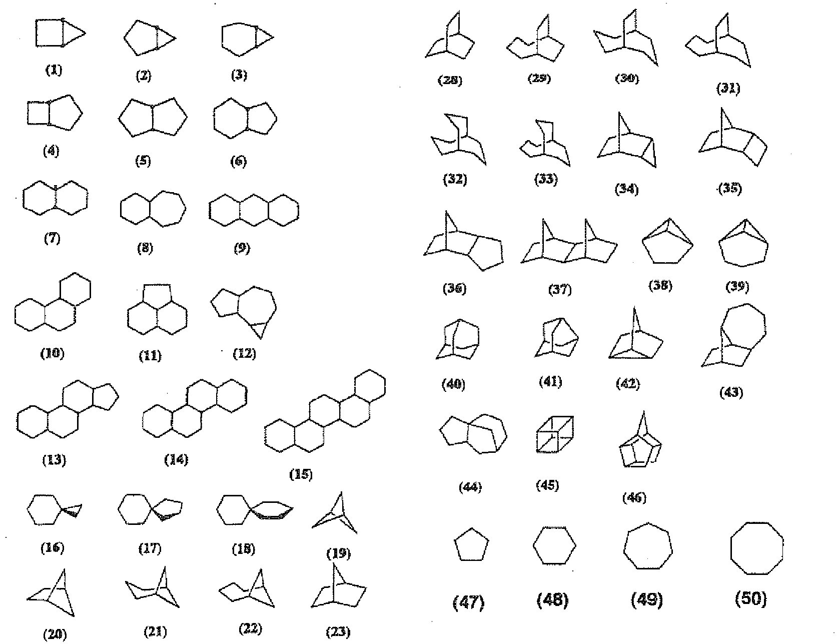

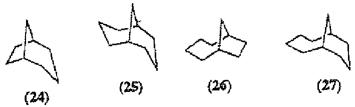

As preferred alicyclic moieties among the above, there can be mentioned an adamantyl group, a noradamantyl group, a decalin group, a tricyclodecanyl group, a tetracyclododecanyl group, a norbornyl group, a cedrol group, a cyclohexyl group, a cycloheptyl group, a cyclooctyl group, a cyclodecanyl group and a cyclododecanyl group. As more preferred alicyclic moieties, there can be mentioned an adamantyl group, a decalin group, a norbornyl group, a cedrol group, a cyclohexyl group, a cycloheptyl group, a cyclooctyl group, a cyclodecanyl group, a cyclododecanyl group and a tricyclodecanyl group.

As a substituent that can be introduced in these alicyclic structures, there can be mentioned an alkyl group, a halogen atom, a hydroxyl group, an alkoxy group, a carboxyl group or an alkoxycarbonyl group. The alkyl group is preferably a lower alkyl group, such as a methyl group, an ethyl group, a propyl group, an isopropyl group or a butyl group. More preferably, the alkyl group is a methyl group, an ethyl group, a propyl group or an isopropyl group. As preferred alkoxy groups, there can be mentioned those each having 1 to 4 carbon atoms, such as a methoxy group, an ethoxy group, a propoxy group and a butoxy group. As a substituent that may be introduced in these alkyl and alkoxy groups, there can be mentioned a hydroxyl group, a halogen atom, an alkoxy group (preferably having 1 to 4 carbon atoms) or the like.

Further substituents may be introduced in these groups. As further substituents, there can be mentioned a hydroxyl group; a halogen atom (fluorine, chlorine, bromine or iodine); a nitro group; a cyano group; the above alkyl groups; an alkoxy group, such as a methoxy group, an ethoxy group, a hydroxyethoxy group, a propoxy group, a hydroxypropoxy group, an n-butoxy group, an isobutoxy group, a sec-butoxy group or a t-butoxy group; an alkoxycarbonyl group, such as a methoxycarbonyl group or an ethoxycarbonyl group; an aralkyl group, such as a benzyl group, a phenethyl group or a cumyl group; an aralkyloxy group; an acyl group, such as a formyl group, an acetyl group, a butyryl group, a benzoyl group, a cyanamyl group or a valeryl group; an acyloxy group, such as a butyryloxy group; the above alkenyl groups; an alkenyloxy group, such as a vinyloxy group, a propenyloxy group, an allyloxy group or a butenyloxy group; the above aryl groups; an aryloxy group, such as a phenoxy group; an aryloxycarbonyl group, such as a benzoyloxy group; and the like.

Preferably, X of general formula (KA-1) represents a carboxylic ester group and the partial structure of general formula (KA-1) is a lactone ring. A 5- to 7-membered lactone ring is preferred.

Further, as shown in formulae (KA-1-1) to (KA-1-17) below, the 5- to 7-membered lactone ring as the partial structure of general formula (KA-1) is preferably condensed with another ring structure in such a fashion that a bicyclo structure or a spiro structure is formed.

The peripheral ring structures to which the ring structure of general formula (KA-1) may be bonded can be, for example, those shown in formulae (KA-1-1) to (KA-1-17) below, or those similar to the same.

It is preferred for the structure containing the lactone ring structure of general formula (KA-1) to be the structure of any of formulae (KA-1-1) to (KA-1-17) below. The lactone structure may be directly bonded to the principal chain. As preferred structures, there can be mentioned those of formulae (KA-1-1), (KA-1-4), (KA-1-5), (KA-1-6), (KA-1-13), (KA-1-14) and (KA-1-17).

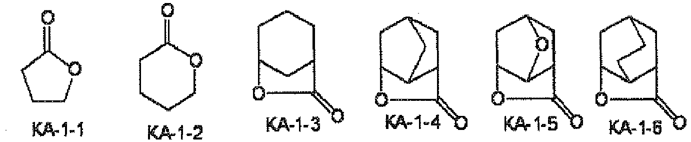

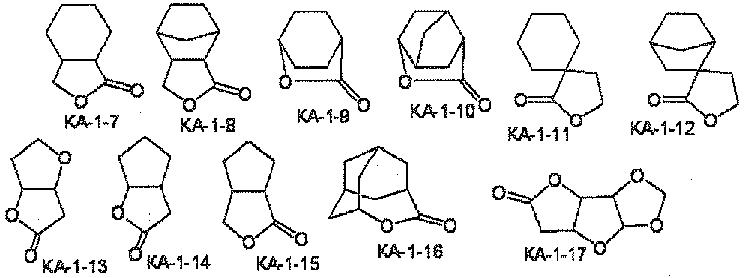

A substituent may or may not be introduced in the above structures containing the lactone ring structure. As preferred substituents, there can be mentioned the same as the substituents Zₖₐ₁ that may be introduced in the ring structure of general formula (KA-1) above.

In general formula (KB-1), X is preferably a carboxylic ester group (-COO-).

In general formula (KB-1), each of Y¹ and Y² independently represents an electron withdrawing group.

The electron withdrawing group has the partial structure of formula (EW) below. In formula (EW), * represents either a bonding hand directly bonded to the structure of general formula (KA-1) or a bonding hand directly bonded to X of general formula (KB-1).

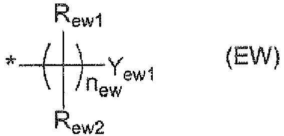

In formula (EW),
n_{ew} is the number of repetitions of each of the connecting groups of the formula -C(R_{ew1}) (R_{ew2})-, being an integer of 0 or 1. When n_{ew} is 0, a single bond is represented, indicating the direct bonding of Y_{ew1}.

Y_{ew1} can be any of a halogen atom, a cyano group, a nitrile group, a nitro group, any of the halo(cyclo)alkyl groups or haloaryl groups of the formula -C(R_{f1})(R_{f2})-R_{f3} to be described hereinafter, an oxy group, a carbonyl group, a sulfonyl group, a sulfinyl group and a combination thereof. The electron withdrawing groups may have, for example, the following structures. Herein, the "halo(cyclo)alkyl group" refers to an at least partially halogenated alkyl group or cycloalkyl group. The "haloaryl group" refers to an at least partially halogenated aryl group. In the following structural formulae, each of R_{ew3} and R_{ew4} independently represents an arbitrary structure. Regardless of the types of the structures of R_{ew3} and R_{ew4}, the partial structures of formula (EW) exhibit electron withdrawing properties, and may be linked to, for example, the principal chain of the resin. Preferably, each of R_{ew3} and R_{ew4} is an alkyl group, a cycloalkyl group or a fluoroalkyl group.

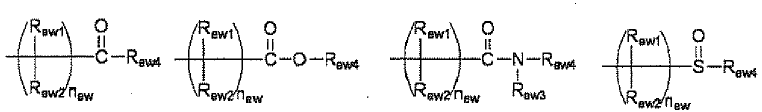

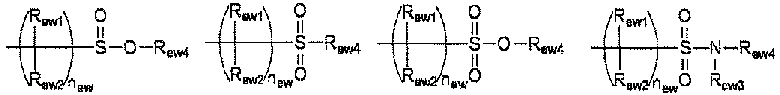

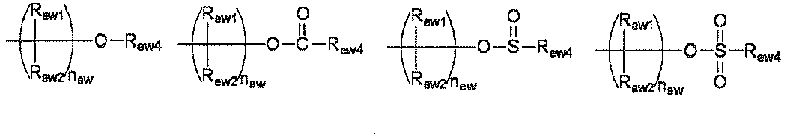

When Y_{ew1} is a bivalent or higher-valent group, the remaining bonding hand or hands form a bond with an arbitrary atom or substituent. At least any of the groups represented by Y_{ew1}, R_{ew1} and R_{ew2} may be linked via a further substituent to the principal chain of the hydrophobic resin.

Y_{ew1} is preferably a halogen atom or any of the halo(cyclo)alkyl groups or haloaryl groups of the formula -C(R_{f1})(R_{f2})-R_{f3}.

Each of R_{ew1} and R_{ew2} independently represents an arbitrary substituent, for example, a hydrogen atom, an alkyl group, a cycloalkyl group or an aryl group.

At least two of R_{ew1}, R_{ew2} and Y_{ew1} may be linked to each other to thereby form a ring.

In the above formula, R_{f1} represents a halogen atom, a perhaloalkyl group, a perhalocycloalkyl group or a perhaloaryl group. R_{f1} is preferably a fluorine atom, a perfluoroalkyl group or a perfluorocycloalkyl group, more preferably a fluorine atom or a trifluoromethyl group.

Each of R_{f2} and R_{f3} independently represents a hydrogen atom, a halogen atom or an organic group. R_{f2} and R_{f3} may be linked to each other to thereby form a ring. As the organic group, there can be mentioned, for example, an alkyl group, a cycloalkyl group, an alkoxy group or the like. It is preferred for R_{f2} to represent the same groups as R_{f1} or to be linked to R_{f3} to thereby form a ring.

R_{f1} to R_{f3} may be linked to each other to thereby form a ring. As the formed ring, there can be mentioned a (halo)cycloalkyl ring, a (halo)aryl ring or the like.

As the (halo) alkyl groups represented by R_{f1} to R_{f3}, there can be mentioned, for example, the alkyl groups mentioned above as being represented by Zₖₐ₁ and structures resulting from halogenation thereof.

As the (per)halocycloalkyl groups and (per)haloaryl groups represented by R_{f1} to R_{f3} or contained in the ring formed by the mutual linkage of R_{f2} and R_{f3}, there can be mentioned, for example, structures resulting from halogenation of the cycloalkyl groups mentioned above as being represented by Zₖₐ₁, preferably fluorocycloalkyl groups of the formula -C(ₙ)F(₂ₙ₋₂)H and perfluoroaryl groups of the formula -C(ₙ)F(ₙ₋₁). The number of carbon atoms, n, is not particularly limited. Preferably, however, it is in the range of 5 to 13, more preferably 6.

As preferred rings that may be formed by the mutual linkage of at least two of R_{ew1}, R_{ew2} and Y_{ew1}, there can be mentioned cycloalkyl groups and heterocyclic groups. Preferred heterocyclic groups are lactone ring groups. As the lactone rings, there can be mentioned, for example, the structures of formulae (KA-1-1) to (KA-1-17) above.

The repeating unit (by) may contain two or more of the partial structures of general formula (KA-1), or two or more of the partial structures of general formula (K3-1), or both any one of the partial structures of general formula (KA-1) and any one of the partial structures of general formula (KB-1).

A part or the whole of any of the partial structures of general formula (KA-1) may double as the electron withdrawing group represented by Y¹ or Y² of general formula (KB-1). For example, when X of general formula (KA-1) is a carboxylic ester group, the carboxylic ester group can function as the electron withdrawing group represented by Y¹ or Y² of general formula (KB-1).

When the repeating unit (by) corresponds to the above-mentioned repeating unit (b*) or repeating unit (b") and contains any of the partial structures of general formula (KA-1), it is preferred for the partial structures of general formula (KA-1) to be a partial structure in which the polarity conversion group is expressed by -COO-appearing in the structures of general formula (KA-1).

The repeating unit (by) can be a repeating unit with the following partial structure. 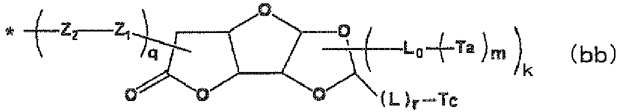 In general formula (bb),
Z₁ represents a single bond, an ether bond, an ester bond, an amido bond, a urethane bond or a urea bond. When there are a plurality of Z₁s, they may be identical to or different from each other. Z₁ is preferably an ester bond.
Z₂ represents an alkylene group or a cycloalkylene group. When there are a plurality of Z₂s, they may be identical to or different from each other. Z₂ is preferably an alkylene group having 1 or 2 carbon atoms and a cycloalkylene group having 5 to 10 carbon atoms.
Ta, or each of Ta's independently, represents an alkyl group, a cycloalkyl group, an alkoxy group, a nitrile group, a hydroxyl group, an amido group, an aryl group or an electron withdrawing group (having the same meaning as that of the electron withdrawing group represented by Y¹ or Y² of general formula (KB-1) above). An alkyl group, a cycloalkyl group and an electron withdrawing group are preferred. An electron withdrawing group is more preferred. Two or more Ta's may be bonded to each other to thereby form a ring.
L₀ represents a single bond or a hydrocarbon group with a valence of m+1 (preferably having 20 or less carbon atoms) . A single bond is preferred. L₀ is a single bond when m is 1. The hydrocarbon group with a valence of m+1 represented by L₀ is, for example, one resulting from the removal of any m-1 hydrogen atoms from an alkylene group, a cycloalkylene group, a phenylene group or a combination thereof.
L, or each of L's independently, represents a carbonyl group, a carbonyloxy group or an ether group.
Tc represents a hydrogen atom, an alkyl group, a cycloalkyl group, a nitrile group, a hydroxyl group, an amido group, an aryl group or an electron withdrawing group (having the same meaning as that of the electron withdrawing group represented by Y¹ or Y² of general formula (KB-1)).

In the formula, * represents a bonding hand to the principal chain or a side chain of the resin. Specifically, any of the partial structures of formula (cc) may be directly bonded to the principal chain, or may be bonded to a side chain of the resin. The bonding hand to the principal chain is one to an atom contained in the bonds as constituents of the principal chain. The bonding hand to a side chain is one to an atom being present outside the bonds as constituents of the principal chain.

In the general formula,
m is an integer of 0 to 28, preferably an integer of 1 to 3, more preferably 1;
k is an integer of 0 to 2, preferably 1;
q represents the number of repetitions of the group (Z₂-Z₁), being an integer of 0 to 5, preferably 0 to 2; and r is an integer of 0 to 5.

The moiety -(L)r-Tc may be replaced with -L₀-(Ta)m.

Among the lactone structures of general formula (cc), those in which a fluorine atom or a group containing a fluorine atom is introduced as a substituent in the location remotest from the above * (location at which the number of intervening atoms is the greatest) and those in which a fluorine atom is introduced in the side chain within the same repeating unit different from the side chain on the lactone side shown in general formula (cc) (corresponding to the above repeating unit (cy")) are also preferred.

The alkylene group represented by Z₂ when it is linear preferably has 1 to 30 carbon atoms, more preferably 1 to 20 carbon atoms. The alkylene group represented by Z₂ when it is branched preferably has 3 to 30 carbon atoms, more preferably 3 to 20 carbon atoms. As particular examples of the alkylene groups represented by Z₂, there can be mentioned the groups resulting from the removal of one arbitrary hydrogen atom from each of the particular examples of alkyl groups mentioned above as being represented Zₖₐ₁.

The cycloalkylene group represented by Z₂ preferably has 3 to 8 carbon atoms. As particular examples thereof, there can be mentioned the groups resulting from the removal of one arbitrary hydrogen atom from each of the cycloalkyl groups mentioned above as being represented Zₖₐ₁.

With respect to the alkyl groups and cycloalkyl groups represented by Ta and Tc, the preferred number of carbon atoms and particular examples are as mentioned above in connection with the alkyl groups and cycloalkyl groups represented by Zₖₐ₁.

The alkoxy group represented by Ta preferably has 1 to 8 carbon atoms. As such, there can be mentioned a methoxy group, an ethoxy group, a propoxy group, a butoxy group or the like.

Each of the aryl groups represented by Ta and Tc preferably has 6 to 12 carbon atoms. As such, there can be mentioned, for example, a phenyl group and a naphthyl group.

With respect to the alkylene group and cycloalkylene group represented by L₀, the preferred number of carbon atoms and particular examples are as mentioned above in connection with the alkylene group and cycloalkylene group represented by Z₂.

As further particular structures of the repeating units (bb), the repeating units with the following partial structures are preferred. 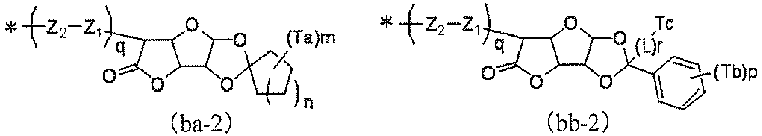 In general formulae (ba-2) and (bb-2),
n is an integer of 0 to 11, preferably an integer of 0 to 5, more preferably 1 or 2; and
p is an integer of 0 to 5, preferably an integer of 0 to 3, more preferably 1 or 2.

Tb, or each of Tbs independently, represents an alkyl group, a cycloalkyl group, an alkoxy group, a nitrile group, a hydroxyl group, an amido group, an aryl group or an electron withdrawing group (having the same meaning as that of the electron withdrawing group represented by Y¹ or Y² of general formula (KB-1)). An alkyl group, a cycloalkyl group and an electron withdrawing group are preferred. When there are a plurality of Tbs, they may be bonded to each other to thereby form a ring.

In the formulae, * represents a bonding hand to the principal chain or a side chain of the resin. Specifically, any of the partial structures of general formulae (ba-2) and (bb-2) may be directly bonded to the principal chain, or may be bonded to a side chain of the resin.

Z₁, Z₂, Ta, Tc, L, *, m, q and r are as defined above in connection with general formula (bb). Preferred examples thereof are also the same as above.

The repeating unit (by) can be a repeating unit with the partial structure of general formula (KY-0) below. 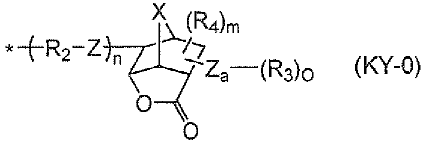 In general formula (KY-0),
R₂, when n≥2 each independently, represents an alkylene group or a cycloalkylene group.
R₃, when o≥2 each independently, represents a hydrocarbon group whose hydrogen atoms on constituent carbons are partially or entirely replaced with fluorine atoms.
R₄, when m≥2 each independently, represents a halogen atom, a cyano group, a hydroxyl group, an amido group, an alkyl group, a cycloalkyl group, an alkoxy group, a phenyl group, an acyl group, an alkoxycarbonyl group or any of the groups of the formula R-C(=O)- or R-C(=O)O- in which R is an alkyl group or a cycloalkyl group. When m≥2, two or more R₄s may be bonded to each other to thereby form a ring.
X represents an alkylene group, a cycloalkylene group, an oxygen atom or a sulfur atom.

Each of Z and Za independently represents a single bond, an ether bond, an ester bond, an amido bond, a urethane bond or a urea bond. When n≥2 a plurality of Zs may be identical to or different from each other.

In the formula, * represents a bonding hand to the principal chain or a side chain of the resin (C); o is an integer of 1 to 7; m is an integer of 0 to 7; and n is an integer of 0 to 5.

The structure -R₂-Z- is preferably the structure of formula -(CH₂)l-COO- in which l is an integer of 1 to 5.

With respect to the alkylene group and cycloalkylene group represented by R₂, the preferred number of carbon atoms and particular examples are as mentioned above in connection with the alkylene group and cycloalkylene group represented by Z₂ of general formula (bb).

The number of carbon atoms of the linear, branched or cyclic hydrocarbon group represented by R₃ is preferably in the range of 1 to 30, more preferably 1 to 20 when the hydrocarbon group is linear; is preferably in the range of 3 to 30, more preferably 3 to 20 when the hydrocarbon group is branched; and is in the range of 6 to 20 when the hydrocarbon group is cyclic. As particular examples of the R₃ groups, there can be mentioned the above particular examples of the alkyl and cycloalkyl groups represented by Zₖₐ₁.

With respect to the alkyl groups and cycloalkyl groups represented by R₄ or R, the preferred number of carbon atoms and particular examples are as mentioned above in connection with the alkyl groups and cycloalkyl groups represented by Zₖₐ₁.

The acyl group represented by R₄ preferably has 1 to 6 carbon atoms. As such, there can be mentioned, for example, a formyl group, an acetyl group, a propionyl group, a butyryl group, an isobutyryl group, a valeryl group, a pivaloyl group or the like.

As the alkyl moiety of the alkoxy group and alkoxycarbonyl group represented by R₄, there can be mentioned a linear, branched or cyclic alkyl moiety. With respect to the alkyl moiety, the preferred number of carbon atoms and particular examples are as mentioned above in connection with the alkyl groups and cycloalkyl groups represented by Zₖₐ₁.

With respect to the alkylene group and cycloalkylene group represented by X, the preferred number of carbon atoms and particular examples are as mentioned above in connection with the alkylene group and cycloalkylene group represented by R₂.

Moreover, as particular structures of the repeating units (by), there can be mentioned the repeating units with the following partial structures. 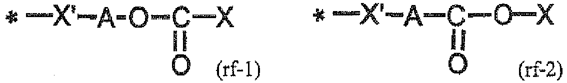 In general formulae (rf-1) and (rf-2),
X' represents an electron withdrawing substituent, preferably a carbonyloxy group, an oxycarbonyl group, an alkylene group substituted with a fluorine atom or a cycloalkylene group substituted with a fluorine atom.
A represents a single bond or a bivalent connecting group of the formula -C(Rx) (Ry)-. In the formula, each of Rx and Ry independently represents a hydrogen atom, a fluorine atom, an alkyl group (preferably having 1 to 6 carbon atoms, optionally substituted with a fluorine atom) or a cycloalkyl group (preferably having 5 to 12 carbon atoms, optionally substituted with a fluorine atom) . Each of Rx and Ry is preferably a hydrogen atom, an alkyl group or an alkyl group substituted with a fluorine atom.
X represents an electron withdrawing group. As particular examples thereof, there can be mentioned the electron withdrawing groups set forth above as being represented by Y¹ and Y². X is preferably a fluoroalkyl group, a fluorocycloalkyl group, an aryl group substituted with fluorine or a fluoroalkyl group, an aralkyl group substituted with fluorine or a fluoroalkyl group, a cyano group or a nitro group.
* represents a bonding hand to the principal chain or a side chain of the resin, namely, a bonding hand bonded to the principal chain of the resin through a single bond or a connecting group.
When X' is a carbonyloxy group or an oxycarbonyl group, A is not a single bond.

The receding contact angle with water of the resin composition film after alkali development can be decreased by the polarity conversion effected by the decomposition of the polarity conversion group by the action of an alkali developer. The decrease of the receding contact angle between water and the film after alkali development is preferred from the viewpoint of the inhibition of development defects.

The receding contact angle with water of the resin composition film after alkali development is preferably 50° or less, more preferably 40° or less, further more preferably 35° or less and most preferably 30° or less at 23±3°C in a humidity of 45±5%.

The receding contact angle refers to a contact angle determined when the contact line at a droplet-substrate interface draws back. It is generally known that the receding contact angle is useful in the simulation of droplet mobility in a dynamic condition. In brief, the receding contact angle can be defined as the contact angle exhibited at the recession of the droplet interface at the time of, after application of a droplet discharged from a needle tip onto a substrate, re-indrawing the droplet into the needle. Generally, the receding contact angle can be measured according to a method of contact angle measurement known as the dilation/contraction method.

The above receding contact angle of the film after alkali development refers to the contact angle obtained by measuring the following film by the dilation/contraction method to be described in examples. Namely, an organic antireflection film ARC29A (produced by Nissan Chemical Industries, Ltd.) was applied onto a silicon wafer (8-inch caliber) and baked at 205°C for 60 seconds, thereby forming a 98 nm-thick antireflection film. Each of the compositions of the present invention was applied thereonto and baked at 120°C for 60 seconds, thereby forming a 120 nm-thick film. The film was developed with an aqueous solution of tetramethylammonium hydroxide (2.38 mass%) for 30 seconds, rinsed with pure water and spin dried. The contact angle of the thus obtained film was measured in accordance with the dilation/contraction method.

The rate of hydrolysis of the hydrophobic resin in an alkali developer is preferably 0.001 nm/sec or greater, more preferably 0.01 nm/sec or greater, further more preferably 0.1 nm/sec or greater and most preferably 1 nm/sec or greater.

Herein, the rate of hydrolysis of the hydrophobic resin in an alkali developer refers to the rate of decrease of the thickness of a resin film formed from only the hydrophobic resin in 23°C TMAH (aqueous solution of tetramethylammonium hydroxide) (2.38 mass%)

It is preferred for the repeating unit (by) to be a repeating unit containing at least two polarity conversion groups.

When the repeating unit (by) contains at least two polarity conversion groups, it is preferred for the repeating unit to contain a group with any of the partial structures having two polarity conversion groups of general formula (KY-1) below. When the structure of general formula (KY-1) has no bonding hand, a group with a mono- or higher-valent group resulting from the removal of at least any arbitrary one of the hydrogen atoms contained in the structure is referred to. 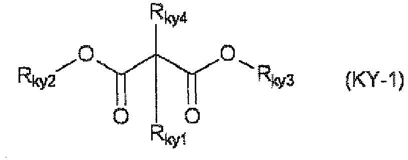 In general formula (KY-1),
each of R_{ky1} and R_{ky4} independently represents a hydrogen atom, a halogen atom, an alkyl group, a cycloalkyl group, a carbonyl group, a carbonyloxy group, an oxycarbonyl group, an ether group, a hydroxyl group, a cyano group, an amido group or an aryl group. Alternatively, both R_{ky1} and R_{ky4} may be bonded to the same atom to thereby form a double bond. For example, both R_{ky1} and R_{ky4} may be bonded to the same oxygen atom to thereby form a part (=O) of a carbonyl group.

Each of R_{ky2} and R_{ky3} independently represents an electron withdrawing group. Alternatively, R_{ky1} and R_{ky2} are linked to each other to thereby form a lactone structure, while R_{ky3} is an electron withdrawing group. The formed lactone structure is preferably any of the above-mentioned structures (KA-1-1) to (KA-1-17). As the electron withdrawing group, there can be mentioned any of the same groups as mentioned above with respect to Y¹ and Y² of general formula (KB-1). This electron withdrawing group is preferably a halogen atom, or any of the halo (cyclo) alkyl groups or haloaryl groups of the formula -C(R_{f1}) (R_{f2}) -R_{f3} above. Preferably, R_{ky3} is a halogen atom, or any of the halo(cyclo)alkyl groups or haloaryl groups of the formula -C (R_{f1}) (R_{f2}) -R_{f3} above, while R_{ky2} is either linked to R_{ky1} to thereby form a lactone ring, or an electron withdrawing group containing no halogen atom.

R_{ky1}, R_{ky2} and R_{ky4} may be linked to each other to thereby form a monocyclic or polycyclic structure.

As R_{ky1} and R_{ky4}, there can be mentioned, for example, the same groups as set forth above with respect to Zₖₐ₁ of general formula (KA-1).

The lactone rings formed by the mutual linkage of R_{ky1} and R_{ky2} preferably have the structures of formulae (KA-1-1) to (KA-1-17) above. As the electron withdrawing groups, there can be mentioned those mentioned above as being represented by Y¹ and Y² of general formula (KB-1) above.

It is more preferred for the structure of general formula (KY-1) to be the structure of general formula (KY-2) below. The structure of general formula (KY-2) refers to a group with a mono- or higher-valent group resulting from the removal of at least any arbitrary one of the hydrogen atoms contained in the structure. 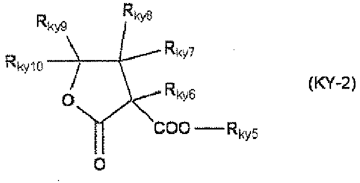 In formula (KY-2),
each of R_{ky6} to R_{ky10} independently represents a hydrogen atom, a halogen atom, an alkyl group, a cycloalkyl group, a carbonyl group, a carbonyloxy group, an oxycarbonyl group, an ether group, a hydroxyl group, a cyano group, an amido group or an aryl group.

At least two of R_{ky6} to R_{ky10} may be linked to each other to thereby form a monocyclic or polycyclic structure.

R_{ky5} represents an electron withdrawing group. As the electron withdrawing group, there can be mentioned any of the same groups as set forth above with respect to Y¹ and Y². This electron withdrawing group is preferably a halogen atom, or any of the halo(cyclo)alkyl groups or haloaryl groups of the formula -C(R_{f1})(R_{f2})-R_{f3} above.

As R_{ky5} to R_{ky10}, there can be mentioned, for example, the same groups as set forth above with respect to Zₖₐ₁ of formula (KA-1).

It is more preferred for the structure of formula (KY-2) to be the partial structure of general formula (KY-3) below.

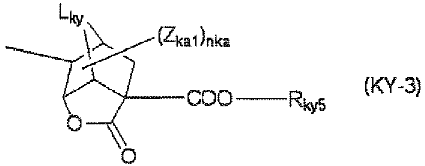

In formula (KY-3), Zₖₐ₁ and nka are as defined above in connection with general formula (KA-1). R_{ky5} is as defined above in connection with formula (KY-2).

L_{ky} represents an alkylene group, a cycloalkylene group, an oxygen atom or a sulfur atom. As the alkylene group represented by L_{ky'} there can be mentioned a methylene group, an ethylene group or the like. L_{ky} is preferably an oxygen atom or a methylene group, more preferably a methylene group.

The repeating units (b) are not limited as long as they are derived by polymerization, such as addition polymerization, condensation polymerization or addition condensation. Preferred repeating units are those obtained by the addition polymerization of a carbon to carbon double bond. As such repeating units, there can be mentioned, for example, acrylate repeating units (including the family having a substituent at the α- and/or β-position), styrene repeating units (including the family having a substituent at the α- and/or β-position), vinyl ether repeating units, norbornene repeating units, repeating units of maleic acid derivatives (maleic anhydride, its derivatives, maleimide, etc.) and the like. Of these, acrylate repeating units, styrene repeating units, vinyl ether repeating units and norbornene repeating units are preferred. Acrylate repeating units, vinyl ether repeating units and norbornene repeating units are more preferred. Acrylate repeating units are most preferred.

When the repeating unit (by) is a repeating unit containing at least either a fluorine atom or a silicon atom (namely, corresponding to the above repeating unit (b') or (b")), as the partial structure containing a fluorine atom within the repeating unit (by), there can be mentioned any of those set forth in connection with the aforementioned repeating unit containing at least either a fluorine atom or a silicon atom, preferably the groups of general formulae (F2) to (F4) above. As the partial structure containing a silicon atom within the repeating unit (by), there can be mentioned any of those set forth in connection with the aforementioned repeating unit containing at least either a fluorine atom or a silicon atom, preferably the groups of general formulae (CS-1) to (CS-3) above.

Monomers corresponding to the repeating units (by) each containing a group whose solubility is increased in an alkali developer can be synthesized in accordance with any of the processes described in, for example, US 2010/0152400 A, WO 2010/067905 A and WO 2010/067898 A.

The content of repeating unit (by) in the hydrophobic resin, based on all the repeating units of the hydrophobic resin, is preferably in the range of 10 to 100 mol%, more preferably 20 to 99 mol%, further more preferably 30 to 97 mol% and most preferably 40 to 95 mol%.

Particular examples of the repeating units (by) containing a group whose solubility in an alkali developer is increased are shown below, which however in no way limit the scope of the repeating units.

Ra represents a hydrogen atom, a fluorine atom, a methyl group or a trifluoromethyl group.

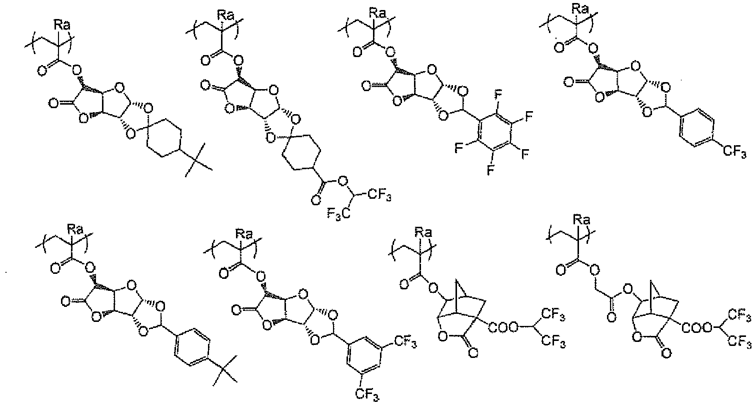

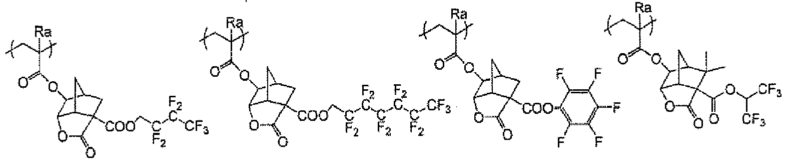

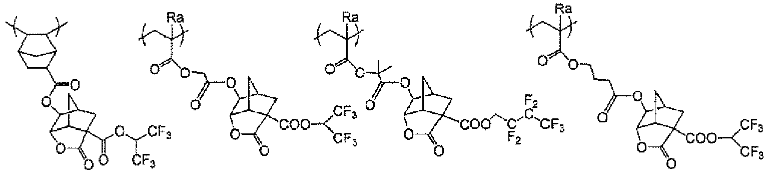

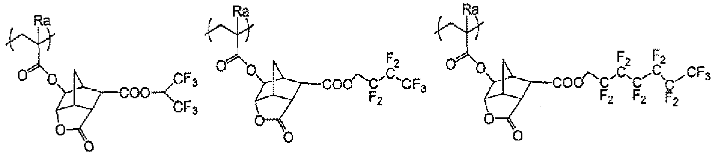

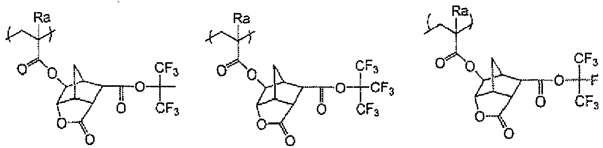

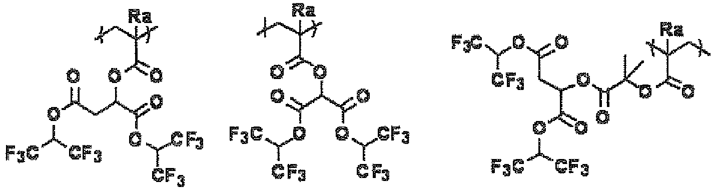

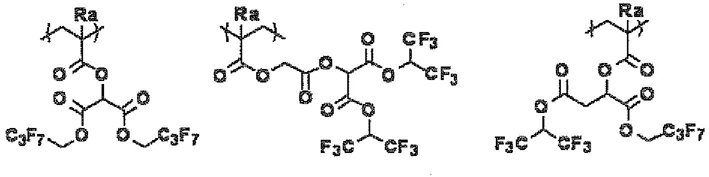

The repeating unit (bz) containing a group that when acted on by an acid, is decomposed (z), contained in the hydrophobic resin can be the same as any of the repeating units each containing an acid-decomposable group set forth above in connection with the resin (A).

When the repeating unit (bz) is a repeating unit containing at least either a fluorine atom or a silicon atom (namely, when corresponding to the above-mentioned repeating unit (b') or repeating unit (b")), the partial structure containing a fluorine atom contained in the repeating unit (bz) can be the same as set forth above in connection with the repeating unit containing at least either a fluorine atom or a silicon atom. As such, preferably, there can be mentioned any of the groups of general formulae (F2) to (F4) above. Also in that instance, the partial structure containing a silicon atom contained in the repeating unit (bz) can be the same as set forth above in connection with the repeating unit containing at least either a fluorine atom or a silicon atom. As such, preferably, there can be mentioned any of the groups of general formulae (CS-1) to (CS-3) above.

The content of repeating unit (bz) containing a group that when acted on by an acid, is decomposed (z) in the hydrophobic resin is preferably in the range of 1 to 80 mol%, more preferably 10 to 80 mol% and further more preferably 20 to 60 mol%, based on all the repeating units of the hydrophobic resin.

The repeating unit (b) containing at least one group selected from the group consisting of the above groups (x) to (z) has been described. The content of repeating unit (b) in the hydrophobic resin is preferably in the range of 1 to 98 mol%, more preferably 3 to 98 mol%, further more preferably 5 to 97 mol% and most preferably 10 to 95 mol%, based on all the repeating units of the hydrophobic resin.

The content of repeating unit (b') in the hydrophobic resin is preferably in the range of 1 to 100 mol%, more preferably 3 to 99 mol%, further more preferably 5 to 97 mol% and most preferably 10 to 95 mol%, based on all the repeating units of the hydrophobic resin.

The content of repeating unit (b*) in the hydrophobic resin is preferably in the range of 1 to 90 mol%, more preferably 3 to 80 mol%, further more preferably 5 to 70 mol% and most preferably 10 to 60 mol%, based on all the repeating units of the hydrophobic resin. The content of repeating unit containing at least either a fluorine atom or a silicon atom used in combination with the repeating unit (b*) is preferably in the range of 10 to 99 mol%, more preferably 20 to 97 mol%, further more preferably 30 to 95 mol% and most preferably 40 to 90 mol%, based on all the repeating units of the hydrophobic resin.

The content of repeating unit (b") in the hydrophobic resin is preferably in the range of 1 to 100 mol%, more preferably 3 to 99 mol%, further more preferably 5 to 97 mol% and most preferably 10 to 95 mol%, based on all the repeating units of the hydrophobic resin.

The hydrophobic resin may further contain any of the repeating units represented by the following general formula (III). 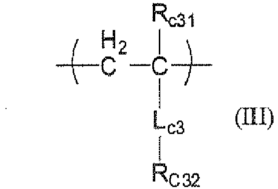 In the formula (III),
R_{c31} represents a hydrogen atom, an alkyl group, an alkyl group optionally substituted with one or more fluorine atoms, a cyano group or a group of the formula -CH₂-O-R_{ac2} in which R_{ac2} represents a hydrogen atom, an alkyl group or an acyl group. R_{c31} is preferably a hydrogen atom, a methyl group, a hydroxymethyl group, or a trifluoromethyl group, more preferably a hydrogen atom or a methyl group.
R_{c32} represents a group containing an alkyl group, a cycloalkyl group, an alkenyl group, a cycloalkenyl group, or an aryl group. These groups may be substituted with fluorine atom and/or silicon atom.
L_{c3} represents a single bond or a bivalent connecting group.

The alkyl group represented by R_{c32} is preferably a linear or branched alkyl group having 3 to 20 carbon atoms.

The cycloalkyl group is preferably a cycloalkyl group having 3 to 20 carbon atoms.

The alkenyl group is preferably an alkenyl group having 3 to 20 carbon atoms.

The cycloalkenyl group is preferably a cycloalkenyl group having 3 to 20 carbon atoms.

The aryl group is preferably an aryl group having 6 to 20 carbon atoms such as a phenyl group or a naphthyl group.

These groups may have one or more substituents.

Preferably, R_{c32} represents an unsubstituted alkyl group or an alkyl group substituted with one or more fluorine atoms.

L_{c3} represents a single bond or a bivalent connecting group. As the bivalent connecting group represented by L_{c3}, an alkylene group (preferably having 1 to 5 carbon atoms), an oxy group, a phenylene group, or an ester bond (a group represented by -COO-) can be exemplified.

The hydrophobic resin may further contain any of the repeating units represented by general formula (BII-AB) below. 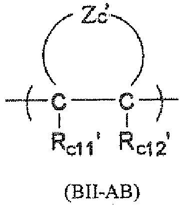 In formula (BII-AB),
each of R_{c11}' and R_{c12}' independently represents a hydrogen atom, a cyano group, a halogen atom or an alkyl group.
Zc' represents an atomic group required for forming an alicyclic structure in cooperation with two carbon atoms (C-C) to which R_{c11'} and R_{c12'} are respectively bonded.

When any of the groups contained in the repeating unit represented by general formulae (III) or (BII-AB) is substituted with a group containing a fluorine atom or a silicone atom, the repeating unit is also corresponding to the aforementioned repeating unit containing at least either a fluorine atom or a silicon atom.

Specific examples of the repeating unit represented by general formulae (III) or (BII-AB) will be shown below, which however in no way limit the scope of the present invention. In the formulae, Ra represents H, CH₃, CH₂OH, CF₃ or CN. Note that the repeating unit in which Ra represents CF₃ also corresponds to the repeating unit containing at least either a fluorine atom or a silicon atom.

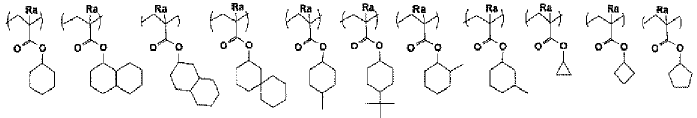

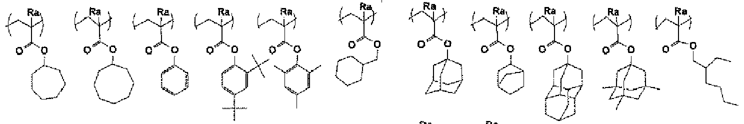

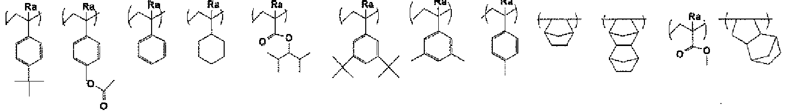

Impurities such as metals in the hydrophobic resin should naturally be of low quantity as in the resin (A). The content of residual monomers and oligomer components is preferably in the range of 0 to 10 mass%, more preferably 0 to 5 mass%, and still more preferably 0 to 1 mass%. Accordingly, there can be obtained a composition being free from in-liquid foreign matters and a change in sensitivity, etc. over time. From the viewpoint of resolving power, resist profile, side wall of resist pattern, roughness, etc., the molecular weight distribution (Mw/Mn, also referred to as the degree of dispersal) thereof is preferably in the range of 1 to 3, more preferably 1 to 2, still more preferably 1 to 1.8, and most preferably 1 to 1.5.

A variety of commercially available products can be used as the hydrophobic resin, and also the resin can be synthesized in accordance with conventional methods (for example, by radical polymerization). As general synthesizing methods, a batch polymerization method in which a monomer species and an initiator are dissolved in a solvent and heated to carry out polymerization and a dropping polymerization method in which a solution of monomer species and initiator is dropped into a hot solvent over a period of 1 to 10 hours can be exemplified. Of these, the dropping polymerization method is preferred.

The reaction solvent, polymerization initiator, reaction conditions (temperature, concentration, etc.) and purification method after reaction are the same as described above in connection with the resin (A).

Specific examples of the hydrophobic resins will be shown below. The following Table 1 shows the molar ratio of individual repeating units (corresponding to individual repeating units in order from the left), weight average molecular weight, and degree of dispersal with respect to each of the resins.

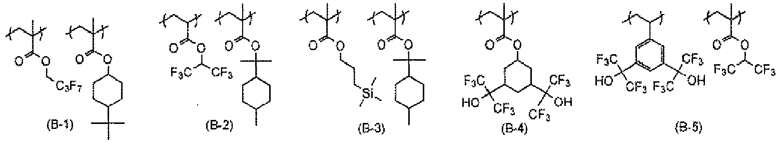

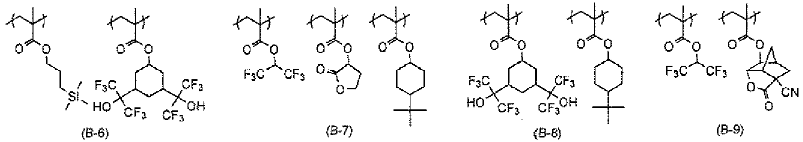

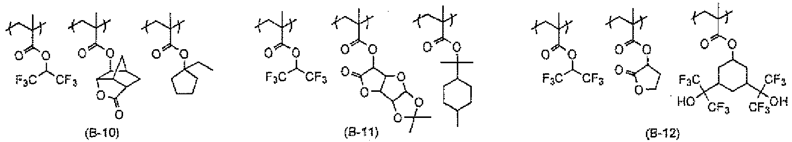

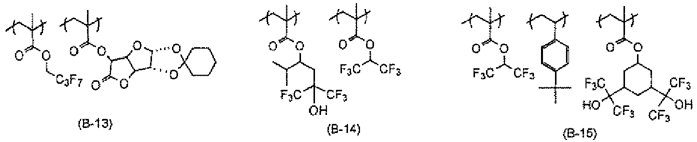

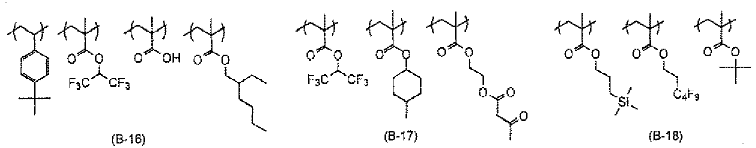

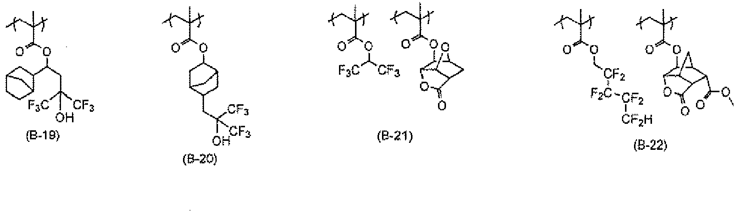

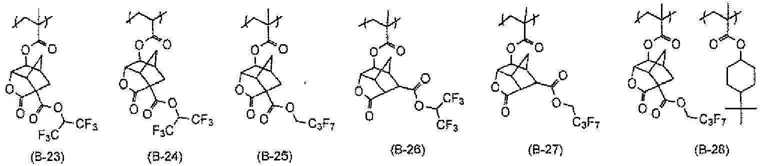

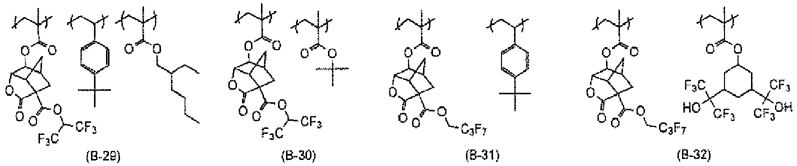

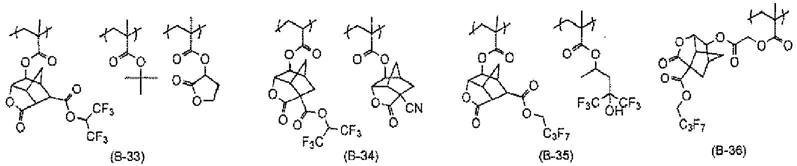

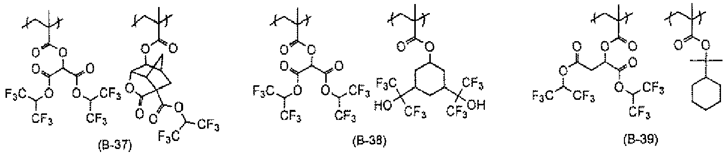

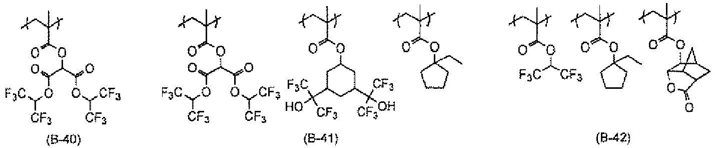

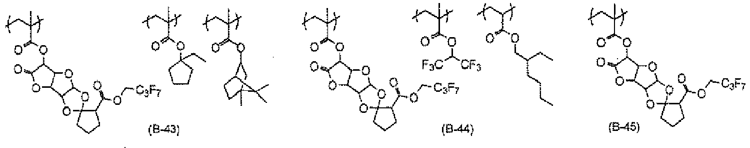

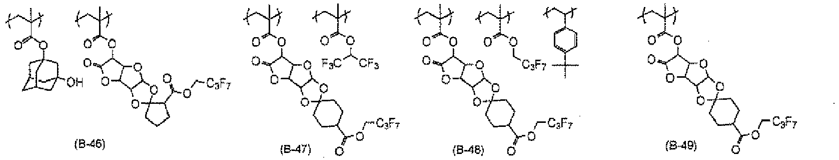

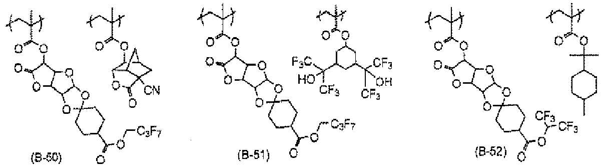

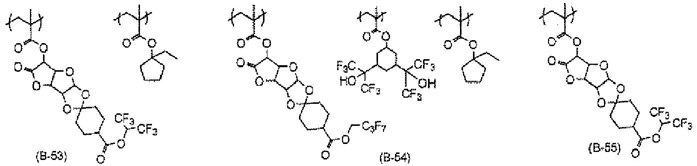

**Table 1**

| Resin | Composition (mol%) | Mw | Mw/Mn |
|---|---|---|---|
| B-1 | 50/50 | 6000 | 1.5 |
| B-2 | 30/70 | 6500 | 1.4 |
| B-3 | 45/55 | 8000 | 1.4 |
| B-4 | 100 | 15000 | 1.7 |
| B-5 | 60/40 | 6000 | 1.4 |
| B-6 | 40/60 | 8000 | 1.4 |
| B-7 | 30/40/30 | 8000 | 1.4 |
| B-8 | 60/40 | 8000 | 1.3 |
| B-9 | 50/50 | 6000 | 1.4 |
| B-10 | 40/40/20 | 7000 | 1.4 |
| B-11 | 40/30/30 | 9000 | 1.6 |
| B-12 | 30/30/40 | 6000 | 1.4 |
| B-13 | 60/40 | 9500 | 1.4 |
| B-14 | 60/40 | 8000 | 1.4 |
| B-15 | 35/35/30 | 7000 | 1.4 |
| B-16 | 50/40/5/5 | 6800 | 1.3 |
| B-17 | 20/30/50 | 8000 | 1.4 |
| B-18 | 25/25/50 | 6000 | 1.4 |
| B-19 | 100 | 9500 | 1.5 |
| 8-20 | 100 | 7000 | 1.5 |
| B-21 | 50/50 | 6000 | 1.6 |
| B-22 | 40/60 | 9600 | 1.3 |
| B-23 | 100 | 20000 | 1.7 |
| B-24 | 100 | 25000 | 1.4 |
| B-25 | 100 | 15000 | 1.7 |
| B-26 | 100 | 12000 | 1.8 |
| B-27 | 100 | 18000 | 1.3 |
| B-28 | 70/30 | 15000 | 2.0 |
| B-29 | 80/15/5 | 18000 | 1.8 |
| B-30 | 60/40 | 25000 | 1.8 |
| B-31 | 90/10 | 19000 | 1.6 |
| 8-32 | 60/40 | 20000 | 1.8 |
| B-33 | 50/30/20 | 11000 | 1.6 |
| B-34 | 60/40 | 12000 | 1.8 |
| B-35 | 60/40 | 15000 | 1.6 |
| B-36 | 100 | 22000 | 1.8 |
| B-37 | 20/80 | 35000 | 1.6 |
| B-38 | 30/70 | 12000 | 1.7 |
| B-39 | 30/70 | 9000 | 1.5 |
| B-40 | 100 | 9000 | 1.5 |
| B-41 | 40/15/45 | 12000 | 1.9 |
| B-42 | 30/30/40 | 13000 | 2.0 |
| B-43 | 40/40/20 | 23000 | 2.1 |
| B-44 | 65/30/5 | 25000 | 1.6 |
| B-45 | 100 | 15000 | 1.7 |
| B-46 | 20/80 | 9000 | 1.7 |
| B-47 | 70/30 | 18000 | 1.5 |
| B-48 | 60/20/20 | 18000 | 1.8 |
| B-49 | 100 | 12000 | 1.4 |
| B-50 | 60/40 | 20000 | 1.6 |
| B-51 | 70/30 | 33000 | 2.0 |
| B-52 | 60/40 | 19000 | 1.8 |
| B-53 | 50/50 | 15000 | 1.5 |
| B-54 | 40/20/40 | 35000 | 1.9 |
| B-55 | 100 | 16000 | 1.4 |

When the hydrophobic resin containing at least either a fluorine atom or a silicon atom is contained, the hydrophobic resin is unevenly distributed in a surface layer portion of the film formed from the resist composition. When the immersion medium is water, the receding contact angle of the film surface with respect to water is increased so that the immersion-water tracking properties can be enhanced.

The receding contact angle of the film of the composition of the present invention after the bake of the coating but prior to the exposure thereof is preferably in the range of 60° to 90°, more preferably 65° or greater, further more preferably 70° or greater and most preferably 75° or greater at the exposure temperature, generally room temperature 23±3°C in a humidity of 45±5%.

Although the hydrophobic resin is unevenly localized on any interface, as different from the surfactant, the resin does not necessarily have to have a hydrophilic group in its molecule and does not need to contribute toward uniform mixing of polar/nonpolar substances.

In the operation of liquid immersion exposure, it is needed for the liquid for liquid immersion to move on a wafer while tracking the movement of an exposure head involving high-speed scanning on the wafer and thus forming an exposure pattern. Therefore, the contact angle of the liquid for liquid immersion with respect to the resist film in dynamic condition is important, and it is required for the resist composition to be capable of tracking the high-speed scanning of the exposure head without leaving droplets.

The hydrophobic resin, due to its hydrophobicity, is likely to cause the blob defect and development residue (scum) after alkali development to deteriorate. When use is made of a hydrophobic resin having three or more polymer chains via at least one branch portion, as compared with a linear-chain resin, the alkali dissolution rate is increased to thereby improve the development residue (scum) and blob defect performance.

When the hydrophobic resin contains fluorine atoms, the content of the fluorine atoms based on the molecular weight of the hydrophobic resin is preferably in the range of 5 to 80 mass%, and more preferably 10 to 80 mass%. The repeating unit containing fluorine atoms preferably exists in the hydrophobic resin in an amount of 10 to 100 mass%, more preferably 30 to 100 mass%.

When the hydrophobic resin contains silicon atoms, the content of the silicon atoms based on the molecular weight of the hydrophobic resin is preferably in the range of 2 to 50 mass%, more preferably 2 to 30 mass%. The repeating unit containing silicon atoms preferably exists in the hydrophobic resin in an amount of 10 to 90 mass%, more preferably 20 to 80 mass%.

The weight average molecular weight of the hydrophobic resin is preferably in the range of 1000 to 100,000, more preferably 2000 to 50,000 and further more preferably 3000 to 30,000. Herein, the weight average molecular weight of the resin refers to the polystyrene-equivalent molecular weight measured by GPC (carrier: tetrahydrofuran (THF)).

One type of hydrophobic resin may be used alone, or two or more types thereof may be used in combination.

The content of hydrophobic resin in the resist composition can be regulated so that the receding contact angle of the actinic-ray- or radiation-sensitive resin film falls within the above-mentioned range. The content of hydrophobic resin based on the total solids of the resist composition is preferably in the range of 0.01 to 20 mass%, more preferably 0.1 to 15 mass%, further more preferably 0.1 to 10 mass% and most preferably 0.5 to 8 mass%.

### (D) Solvent

The resist composition of the present invention contains a mixed solvent comprising 5 to 20 mass%, based on the mixed solvent, of a solvent exhibiting a normal boiling point of 200°C or higher. This results in an enhancement of the uneven distribution of the hydrophobic resin in the surface to thereby increase the hydrophobicity of the resist film. Therefore, the reduction of watermark defects can be attained.

It is preferred for the solvent exhibiting a normal boiling point of 200°C or higher to be a solvent expressed by any of general formulae (S1) to (S3) below.

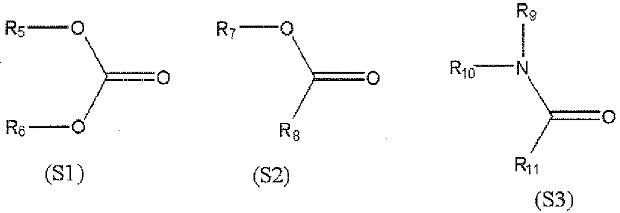

In the formulae, each of R₅ to R₁₁ independently represents an alkyl group, a cycloalkyl group or an aryl group, provided that R₅ and R₆, R₇ and R₈, and R₁₀ and R₁₁ may be bonded to each other to thereby form a ring.

In general formulae (S1) to (S3), preferably, R₅ to R₁₁ are alkyl groups. More preferably, further, R₅ and R₆, R₇ and R₈, and R₁₀ and R₁₁ are bonded to each other to thereby form a ring.

Among the solvents with the structures of general formulae (S1) to (S3), the solvents of general formulae (S1) and (S2) are preferred, and the solvents of general formula (S1) are most preferred.

Among the solvents with the structures of general formulae (S1) to (S3), for example, a solvent with a lactone structure such as γ-butyrolactone (normal boiling point: 203°C), a solvent with an alkylene carbonate structure such as ethylene carbonate (normal boiling point: 244°C), propylene carbonate (normal boiling point: 242°C) or butylene carbonate (normal boiling point: 251°C), N-methylpyrrolidone (normal boiling point: 203°C) and the like are preferred. Of these, a solvent with a lactone structure and a solvent with an alkylene carbonate structure are more preferred, and γ-butyrolactone and propylene carbonate are especially preferred. Propylene carbonate is most preferred.

The solvent exhibiting a normal boiling point of below 200°C that can be contained in the solvent (D) according to the present invention is not particularly limited. As such, there can be mentioned the following hydroxylated solvent and nonhydroxylated solvent and the like.

As the hydroxylated solvent, there can be mentioned, for example, ethylene glycol, ethylene glycol monomethyl ether, ethylene glycol monoethyl ether, propylene glycol, propylene glycol monomethyl ether (PGME, also known as 1-methoxy-2-propanol), propylene glycol monoethyl ether, ethyl lactate or the like. Of these, propylene glycol monomethyl ether and ethyl lactate are especially preferred.

As the nonhydroxylated solvent, there can be mentioned, for example, propylene glycol monomethyl ether acetate (PGMEA, also known as 1-methoxy-2-acetoxypropane), ethyl ethoxypropionate, 2-heptanone, cyclohexanone, butyl acetate, N,N-dimethylacetamide, dimethyl sulfoxide or the like. Of these, propylene glycol monomethyl ether acetate, ethyl ethoxypropionate, 2-heptanone, cyclohexanone and butyl acetate are especially preferred. Propylene glycol monomethyl ether acetate, ethyl ethoxypropionate, 2-heptanone and cyclohexanone are most preferred.

The mixed solvent containing the nonhydroxylated solvent in an amount of 50 mass% or more is especially preferred from the viewpoint of coating uniformity.

It is preferred for the solvent (D) to contain propylene glycol monomethyl ether acetate. More preferably, the solvent (D) is a mixed solvent containing a solvent whose normal boiling point is 200°C or higher, a hydroxylated solvent and a nonhydroxylated solvent. Further more preferably, the solvent (D) is a mixed solvent containing a solvent whose normal boiling point is 200°C or higher, an alkylene glycol monoalkyl ether acetate and an alkylene glycol monoalkyl ether.

The resist composition of the present invention may further contain components other than the foregoing components (A) to (D) . For example, the composition of the present invention may further contain the following components.

### <Basic compound>

The composition of the present invention preferably contains a basic compound so as to decrease any performance alteration over time from exposure to heating.

As preferred basic compounds, there can be mentioned the compounds having the structures of the following formulae (A) to (E). 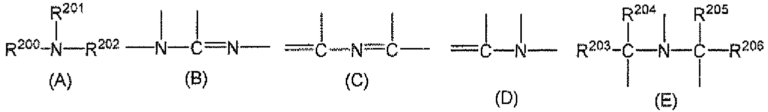 In the general formulae (A) and (E),
R²⁰⁰, R²⁰¹ and R²⁰² may be identical to or different from each other and each represent a hydrogen atom, an alkyl group (preferably having 1 to 20 carbon atoms), a cycloalkyl group (preferably having 3 to 20 carbon atoms) or an aryl group (having 6 to 20 carbon atoms) . R²⁰¹ and R²⁰² may be bonded with each other to thereby form a ring. R²⁰³, R²⁰⁴, R²⁰⁵ and R²⁰⁶ may be identical to or different from each other and each represent an alkyl group having 1 to 20 carbon atoms.

With respect to the above alkyl group, as a preferred substituted alkyl group, there can be mentioned an aminoalkyl group having 1 to 20 carbon atoms, a hydroxyalkyl group having 1 to 20 carbon atoms or a cyanoalkyl group having 1 to 20 carbon atoms.

More preferably, in these general formulae (A) and (E) the alkyl group is unsubstituted.

As preferred compounds, there can be mentioned guanidine, aminopyrrolidine, pyrazole, pyrazoline, piperazine, aminomorpholine, aminoalkylmorpholine, piperidine and the like. Further, as preferred compounds, there can be mentioned compounds with an imidazole structure, a diazabicyclo structure, an onium hydroxide structure, an onium carboxylate structure, a trialkylamine structure, an aniline structure or a pyridine structure, alkylamine derivatives having a hydroxyl group and/or an ether bond, aniline derivatives having a hydroxyl group and/or an ether bond and the like.

As the compounds with an imidazole structure, there can be mentioned imidazole, 2,4,5-triphenylimidazole, benzimidazole, 2-phenylbenzoimidazole and the like. As the compounds with a diazabicyclo structure, there can be mentioned 1,4-diazabicyclo[2,2,2]octane, 1,5-diazabicyclo[4,3,0]non-5-ene, 1,8-diazabicyclo[5,4,0]undec-7-ene and the like. As the compounds with an onium hydroxide structure, there can be mentioned tetrabutylammonium hydroxide, triarylsulfonium hydroxide, phenacylsulfonium hydroxide, and sulfonium hydroxides having a 2-oxoalkyl group such as triphenylsulfonium hydroxide, tris(t-butylphenyl)sulfonium hydroxide, bis(t-butylphenyl)iodonium hydroxide, phenacylthiophenium hydroxide, 2-oxopropylthiophenium hydroxide and the like. As the compounds with an onium carboxylate structure, there can be mentioned those having a carboxylate at the anion moiety of the compounds with an onium hydroxide structure, for example, acetate, adamantane-1-carboxylate, perfluoroalkyl carboxylate and the like. As the compounds with a trialkylamine structure, there can be mentioned tri(n-butyl)amine, tri(n-octyl)amine and the like. As the aniline compounds, there can be mentioned 2,6-diisopropylaniline, N,N-dimethylaniline, N,N-dibutylaniline, N,N-dihexylaniline and the like. As the alkylamine derivatives having a hydroxyl group and/or an ether bond, there can be mentioned ethanolamine, diethanolamine, triethanolamine, N-phenyldiethanolamine, tris(methoxyethoxyethyl)amine and the like. As the aniline derivatives having a hydroxyl group and/or an ether bond, there can be mentioned N, N-bis (hydroxyethyl) aniline and the like.

As preferred basic compounds, there can be further mentioned an amine compound having a phenoxy group, an ammonium salt compound having a phenoxy group, an amine compound having a sulfonic ester group and an ammonium salt compound having a sulfonic ester group.

Each of the above amine compound having a phenoxy group, ammonium salt compound having a phenoxy group, amine compound having a sulfonic ester group and ammonium salt compound having a sulfonic ester group preferably has at least one alkyl group bonded to the nitrogen atom thereof. Further preferably, the alkyl group in its chain contains an oxygen atom, thereby forming an oxyalkylene group. The number of oxyalkylene groups in each molecule is one or more, preferably 3 to 9 and more preferably 4 to 6. Oxyalkylene groups having the structure of -CH₂CH₂O-, -CH(CH₃)CH₂O-or -CH₂CH₂CH₂O- are preferred.

As specific examples of the above amine compound having a phenoxy group, ammonium salt compound having a phenoxy group, amine compound having a sulfonic ester group and ammonium salt compound having a sulfonic ester group, there can be mentioned the compounds (C1-1) to (C3-3) shown as examples in Section [0066] of US 2007/0224539 A, which are however nonlimiting.

These basic compounds may be used either individually or in combination.

The content of the basic compounds is typically in the range of 0.001 to 10 mass%, preferably 0.01 to 5 mass% based on the total solids of the composition.

With respect to the ratio of the acid generator to the basic compound used in the composition, preferably, the acid generator/ the basic compound (molar ratio) = 2.5 to 300. The reason for this is that the molar ratio is preferred to be 2.5 or higher from the viewpoint of sensitivity and resolving power. The molar ratio is preferred to be 300 or below from the viewpoint of the inhibition of any resolving power deterioration due to thickening of resist pattern over time from exposure to heating treatment. The acid generator/ the basic compound (molar ratio) is more preferably in the range of 5.0 to 200, still more preferably 7.0 to 150.

### <Low-molecular compound containing a group cleaved by the action of an acid that upon the cleavage, exhibits an increased basicity>

It is preferred for the composition of the present invention to contain a low-molecular compound containing a group cleaved by the action of an acid that upon the cleavage, exhibits an increased basicity (hereinafter also referred to as a "low-molecular compound (D)."

The group that is cleaved when acted on by an acid is not particularly limited. However, an acetal group, a carbonate group, a carbamate group, a tertiary ester group, a tertiary hydroxyl group and a hemiaminal ether group are preferably used. A carbamate group and a hemiaminal ether group are especially preferred.

The molecular weight of the compound (D) is preferably in the range of 100 to 1000, more preferably 100 to 700 and most preferably 100 to 500.

As the compound (D), an amine derivative containing a group that is cleaved when acted on by an acid being connected to a nitrogen atom.

The compound (D) may contain a carbamate group with a protective group, the carbamate group being connected to a nitrogen atom. The protective group contained in the carbamate group can be represented, for example, by the following formula (d-1). 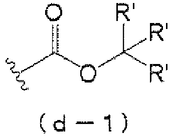 In formula (d-1),
Each of R's independently represents a hydrogen atom, a linear or branched alkyl group, a cycloalkyl group, an aryl group, an aralkyl group, or an alkoxyalkyl group. At least two of R's may be connected to each other to form a ring.

Preferably, R' represents a linear or branched alkyl group, a cycloalkyl group, or an aryl group. More preferably, R' represents a linear or branched alkyl group, or a cycloalkyl group.

The low-molecular compound (D) may have a structure in which any of the above-mentioned basic compounds are combined with the structure represented by general formula (d-1).

The low-molecular compound (D) is especially preferred to be the one represented by general formula (A) below. Note that, the low-molecular compound (D) may be any of the basic compounds described above as long as it is a low-molecular compound containing a group that is cleaved when acted on by an acid.

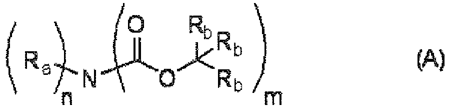

In the general formula (A), Ra represents a hydrogen atom, an alkyl group, a cycloalkyl group, an aryl group, or an aralkyl group. When n=2, two Ra's may be the same or different from each other, and may be connected to each other to form a bivalent heterocyclic hydrocarbon group (preferably having 20 or less carbon atoms) or its derivatives.

Each of Rb's independently represents a hydrogen atom, an alkyl group, a cycloalkyl group, an aryl group, an aralkyl group, or an alkoxyalkyl group, with the proviso that when at least one of Rb's are hydrogen atoms, at least one of the remainder represents a cyclopropyl group, 1-alkoxyalkyl group, or an aryl group.

At least two of Rb's may be connected to each other to form a alicyclic hydrocarbon group, an aromatic hydrocarbon group, a heterocyclic hydrocarbon group, or their derivatives.

In the formula (A), n represents an integer of 0 to 2, m represents an integer of 1 to 3, and n+m=3.

In the formula (A), the alkyl group, the cycloalkyl group, the aryl group, and the aralkyl group represented by Ra and Rb may be substituted with a functional group such as a hydroxyl group, a cyano group, an amino group, a pyrrolidino group, a piperidino group, a morpholino group, and an oxo group; an alkoxy group; or a halogen atom. The same applies to the alkoxyalkyl group represented by Rb.

As the alkyl group, the cycloalkyl group, the aryl group, and the aralkyl group (these groups may be substituted with the above functional group, an alkoxy group, or a halogen atom) represented by Ra and/or Rb, the following groups can be exemplified:
a group derived from a linear or branched alkane such as methane, ethane, propane, butane, pentane, hexane, heptane, octane, nonane, decane, undecane, or dodecane; and the group derived from the alkane and substituted with one or more cycloalkyl groups such as a cyclobutyl group, a cyclopentyl group, or a cyclohexyl group;
a group derived from cycloalkane such as cyclobutane, cyclopentane, cyclohexane, cycloheptane, cyclooctane, norbornane, adamantane, or noradamantane; and the group derived from the cycloalkane and substituted with one or more linear or branched alkyl group such as a methyl group, an ethyl group, a n-propyl group, an i-propyl group, a n-butyl group, a 2-methylpropyl group, a 1-methylpropyl group, or a t-butyl group;
a group derived from aromatic compound such as benzene, naphthalene, or anthracene; and the group derived from the atomatic compound and substituted with one or more linear or branched alkyl group such as a methyl group, an ethyl group, a n-propyl group, an i-propyl group, a n-butyl group, a 2-methylpropyl group, a 1-methylpropyl group, or a t-butyl group;
a group derived from heterocyclic compound such as pyrrolidine, piperidine, morpholine, tetrahydrofuran, tetrahydropyrane, indole, indoline, quinoline, perhydroquinoline, indazole, or benzimidazole; the group derived from heterocyclic compound and substituted with one or more linear or branched alkyl group or a group derived from the aromatic compound;
a group derived from linear or branched alkane and substituted with a group derived from aromatic compound such as a phenyl group, a naphthyl group, or an anthracenyl group;
a group derived from cycloalkane and substituted with a group derived from aromatic compound such as a phenyl group, a naphthyl group, or an anthracenyl group; or
each of these groups substituted with a functional group such as a hydoroxyl group, a cyano group, an amino group, a pyrrolidino group, a piperidino group, a morpholino group, or an oxo group.

Further, as the bivalent heterocyclic hydrocarbon group (preferably having 1 to 20 carbon atoms) or its derivative, formed by mutual binding of Ra's, for example, the followings can be exemplified:
a group derived from heterocyclic compound such as pyrrolidine, piperidine, morpholine, 1,4,5,6-tetrahydropyrimidine, 1,2,3,4-tetrahydroquinoline, 1,2,3,6-tetrahydroquinoline, homopiperadine, 4-azabenzimidazole, benztriazole, 5-azabenztriazole, 1H-1,2,3-triazole, 1,4,7-triazacyclononane, tetrazole, 7-azaindole, indazole, benzimidazole, imidazo[1,2-a]pyridine, (1S,4S)-(+)2,5-azabicyclo[2.2.1]heptane, 1,5,7-triazabicyclo[4.4.0]aec-5-en, indole, indoline, 1,2,3,4-tetrahydroquinoxaline, perhydroquinoline, or 1,5,9-triazacyclododecane; or
the group derived from heterocyclic compound and substituted with at least one of a group derived from linear or branched alkane, a group derived from cycloalkane, a group derived from aromatic compound, a group derived from heterocyclic compound, or a functional group such as a hydroxyl group, a cyano group, an amino group, a pyrrolidino group, a piperidino group, a morpholino group, or an oxo group.

Particularly preferred examples of the low-molecular compound (D) will be shown below, which however in no way limit the scope of the present invention.

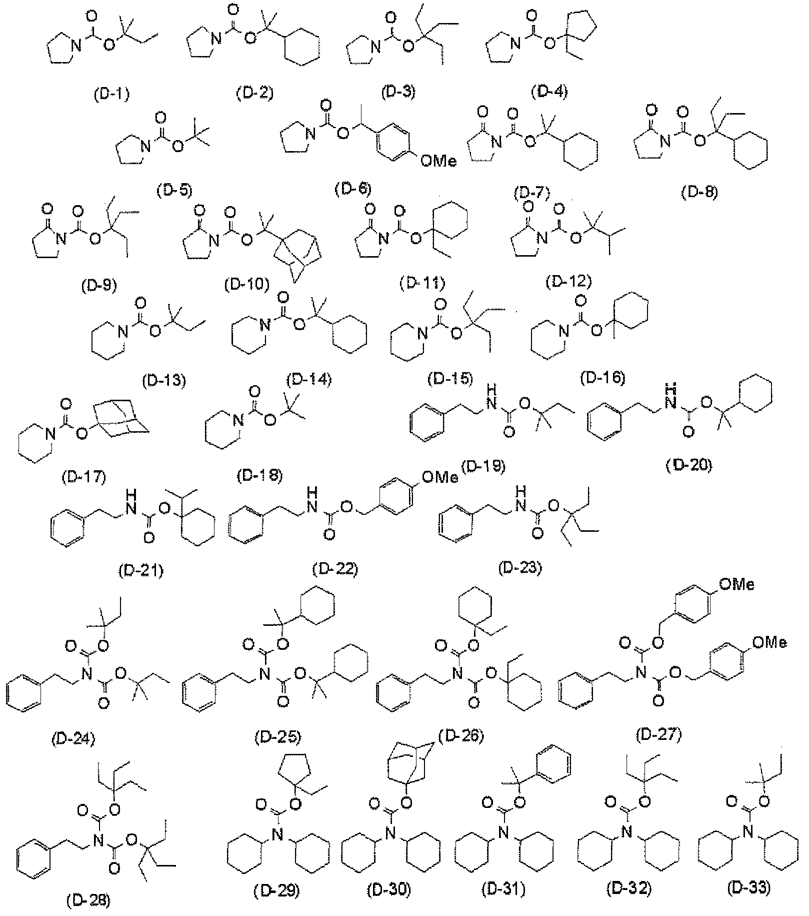

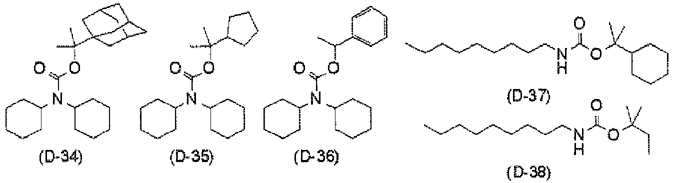

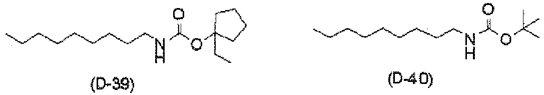

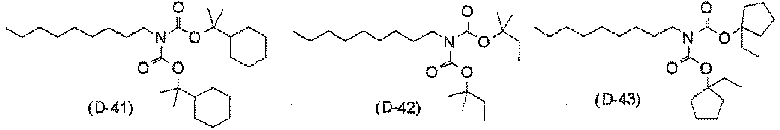

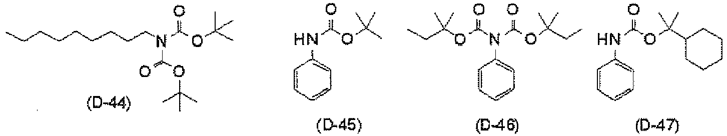

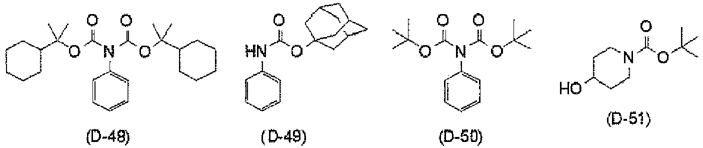

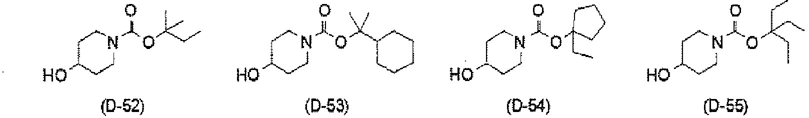

The compounds of general formula (A) can be synthesized by, for example, the method described in JP-A-2009-199021.

In the present invention, one type of low-molecular compound (D) may be used alone, or two or more types thereof may be used in a mixture.

In the present invention, the content of low-molecular compound (D), based on the total solids of the composition mixed with the above-mentioned basic compound, is generally in the range of 0.001 to 20 mass%, preferably 0.001 to 10 mass% and more preferably 0.01 to 5 mass%.

With respect to the ratio between acid generator and low-molecular compound (D) used in the composition, it is preferred for the molar ratio of acid generator/[low-molecular compound (D) + above-mentioned basic compound] to be in the range of 2.5 to 300. Namely, the molar ratio is preferred to be 2.5 or higher from the viewpoint of sensitivity and resolution, and the molar ratio is preferred to be 300 or below from the viewpoint of inhibiting the lowering of resolution by thickening of resist pattern over time from exposure to baking treatment. The molar ratio of acid generator/[low-molecular compound (D) + above-mentioned basic compound] is more preferably in the range of 5.0 to 200, further more preferably 7.0 to 150.

### <Surfactant>

The composition of the present invention may further contain a surfactant. When the composition contains a surfactant, the composition preferably contains any one, or two or more members, of fluorinated and/or siliconized surfactants (fluorinated surfactant, siliconized surfactant and surfactant containing both fluorine and silicon atoms).

The composition of the present invention when containing the above surfactant would, in the use of an exposure light source of 250 nm or below, especially 220 nm, or below, realize favorable sensitivity and resolving power and produce a resist pattern with less adhesion and development defects.

As fluorinated and/or siliconized surfactants, there can be mentioned, for example, those described in section [0276] of US 2008/0248425 A1. As useful commercially available surfactants, there can be mentioned, for example, fluorinated surfactants/siliconized surfactants, such as Eftop EF301 and EF303 (produced by Shin-Akita Kasei Co., Ltd.), Florad FC 430, 431 and 4430 (produced by Sumitomo 3M Ltd.), Megafac F171, F173, F176, F189, F113, F110, F177, F120 and R08 (produced by Dainippon Ink & Chemicals, Inc.), Surflon S-382, SC101, 102, 103, 104, 105 and 106 (produced by Asahi Glass Co., Ltd.), Troy Sol S-366 (produced by Troy Chemical Co., Ltd.), GF-300 and GF-150 (produced by TOAGOSEI CO., LTD.), Sarfron S-393 (produced by SEIMI CHEMICAL CO. , LTD.), Eftop EF121, EF122A, EF122B, RF122C, EF125M, EF135M, EF351, EF352, EF801, EF802 and EF601 (produced by JEMCO INC.), PF636, PF656, PF6320 and PF6520 (produced by OMNOVA), and FTX-204G, 208G, 218G, 230G, 204D, 208D, 212D, 218D and 222D (produced by NEOS). Further, polysiloxane polymer KP-341 (produced by Shin-Etsu Chemical Co., Ltd.) can be employed as the siliconized surfactant.

As the surfactant, besides the above publicly known surfactants, use can be made of a surfactant based on a polymer having a fluorinated aliphatic group derived from a fluorinated aliphatic compound, produced by a telomerization technique (also called a telomer process) or an oligomerization technique (also called an oligomer process). The fluorinated aliphatic compound can be synthesized by the process described in JP-A-2002-90991.

The polymer containing a fluorinated aliphatic group is preferably a copolymer from a monomer containing a fluorinated aliphatic group and a poly(oxyalkylene) acrylate and/or poly(oxyalkylene) methacrylate, which copolymer may have an irregular distribution or may result from block copolymerization. As the poly(oxyalkylene) group, there can be mentioned a poly(oxyethylene) group, a poly(oxypropylene) group, a poly(oxybutylene) group or the like. Further, use can be made of a unit comprising alkylenes of different chain lengths in a single chain, such as poly(oxyethylene-oxypropylene-oxyethylene block concatenation) or poly(oxyethylene-oxypropylene block concatenation). Moreover, the copolymer from a monomer containing a fluorinated aliphatic group and a poly(oxyalkylene) acrylate (or methacrylate) is not limited to two-monomer copolymers and may be a three-or-more-monomer copolymer obtained by simultaneous copolymerization of two or more different monomers having a fluorinated aliphatic group, two or more different poly(oxyalkylene) acrylates (or methacrylates), etc.

For example, as a commercially available surfactant, there can be mentioned, for example, Megafac F178, F-470, F-473, F-475, F-476 or F-472 (produced by Dainippon Ink & Chemicals, Inc.). Further, there can be mentioned a copolymer from an acrylate (or methacrylate) having a C₆F₁₃ group and a poly(oxyalkylene) acrylate (or methacrylate), a copolymer from an acrylate (or methacrylate) having a C₃F₇ group, poly(oxyethylene) acrylate (or methacrylate) and poly(oxypropylene) acrylate (or methacrylate), or the like.

In the present invention, surfactants other than the fluorinated and/or siliconized surfactants can also be employed. In particular, there can be mentioned, for example, those described in section [0280] of US 2008/0248425 A1.

These surfactants may be used either individually or in combination.

The content of the surfactant based on the total solids of the composition is preferably in the range of 0 to 2 mass%, more preferably 0 to 1.5 mass%, and most preferably 0 to 1 mass%.

### (Carboxylic acid onium salt)

The composition according to the present invention may further contain a carboxylic acid onium salt. Preferred carboxylic acid onium salt is a sulfonium salt and an iodonium salt. A preferred anion moiety thereof is a linear, branched, monocyclic or polycyclic alkylcarboxylate anion having 1 to 30 carbon atoms. A more preferred anion moiety is an anion of carboxylic acid wherein the alkyl group is partially or wholly fluorinated. The alkyl chain may contain an oxygen atom. If so, the transparency to light of wavelength 220 nm or shorter can be ensured, the sensitivity and resolving power can be enhanced, and the iso/dense bias and exposure margin can also be enhanced.

As the fluorinated carboxylic acid anion, any of the anions of fluoroacetic acid, difluoroacetic acid, trifluoroacetic acid, pentafluoropropionic acid, heptafluorobutyric acid, nonafluoropentanoic acid, perfluorododecanoic acid, perfluorotridecanoic acid, perfluorocyclohexanecarboxylic acid, and 2,2-bistrifluoromethylpropionic acid can be exemplified.

The content of the carboxylic acid onium salt based on the total solids of the composition is preferably in the range of 0.1 to 20 mass%, more preferably 0.5 to 10 mass%, and most preferably 1 to 7 mass%.

### (Dissolution inhibiting compound)

The composition according to the present invention may further contain a dissolution inhibiting compound. Here the "dissolution inhibiting compound" means compound having 3000 or less molecular weight that is decomposed by the action of an acid to increase the solubility in an alkali developer.

From the viewpoint of preventing lowering of the transmission at the wavelength of 220 nm or shorter, the dissolution inhibiting compound is preferably an alicyclic or aliphatic compound having an acid-decomposable group, such as any of cholic acid derivatives having an acid-decomposable group described in Proceeding of SPIE, 2724, 355 (1996). The acid-decomposable group and alicyclic structure can be the same as described earlier.

When the composition according to the present invention is exposed to a KrF excimer laser or irradiated with electron beams, preferred use is made of one having a structure resulting from substitution of the phenolic hydroxy group of a phenol compound with an acid-decomposable group. The phenol compound preferably contains 1 to 9 phenol skeletons, more preferably 2 to 6 phenol skeletons.

The content of the dissolution inhibiting compound based on the total solids of the composition is preferably in the range of 3 to 50 mass%, and more preferably 5 to 40 mass%.

Specific examples of the dissolution inhibiting compound will be shown below, which however in no way limit the scope of the present invention.

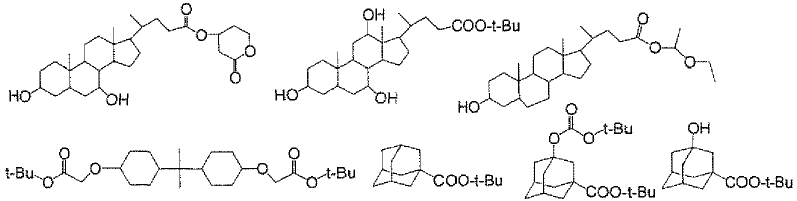

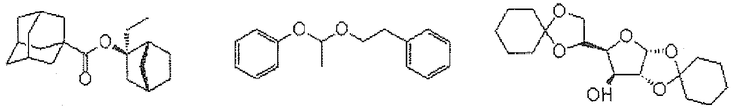

### <Other additives>

The composition according to the present invention may further contain a dye, a plasticizer, a photosensitizer, a light absorber, and/or a compound capable of increasing the solubility in a developer (for example, a phenolic compound of 1000 or less molecular weight or a carboxylated alicyclic or aliphatic compound), etc.

The above phenolic compound of 1000 or less molecular weight can be easily synthesized by persons of ordinary skill in the art while consulting the processes described in, for example, JP-As 4-122938 and 2-28531, USP 4, 916,210, and EP 219294.

As the nonlimiting examples of the carboxylated alicyclic or aliphatic compound, a carboxylic acid derivative of steroid structure such as cholic acid, deoxycholic acid or lithocholic acid, an adamantanecarboxylic acid derivative, adamantanedicarboxylic acid, cyclohexanecarboxylic acid, and cyclohexanedicarboxylic acid can be exemplified.

### <Method of forming pattern>

From the viewpoint of enhancing the resolving power, it is preferred for the composition of the present invention to be used with a film thickness of 30 to 250 nm. More preferably, the composition is used with a film thickness of 30 to 200 nm. This film thickness can be attained by setting the solid content of the actinic-ray- or radiation-sensitive resin composition within an appropriate range so as to cause the composition to have an appropriate viscosity, thereby improving the applicability and film forming property.

The total solid content of the composition of the present invention is generally in the range of 1 to 10 mass%, preferably 1 to 8.0 mass% and more preferably 1.0 to 7.0 mass%.

The composition of the present invention is used in such a manner that the above components are dissolved in a given organic solvent, preferably the above mixed solvent, and filtered and applied onto a given support in the following manner. Preferably, the filter medium for the filtration is made of a polytetrafluoroethylene, polyethylene or nylon having a pore size of 0.1 µm or less, especially 0.05 µm or less and further especially 0.03 µm or less.

For example, the actinic-ray- or radiation-sensitive resin composition is applied onto a substrate, such as one for use in the production of precision integrated circuit elements (e.g., silicon/silicon dioxide coating), by appropriate application means, such as a spinner or coater, and dried to thereby form a film.

The obtained film is exposed through a given mask to actinic rays or radiation, preferably baked (heated), developed and rinsed. Thus, a desirable pattern can be obtained.

As the actinic rays or radiation, infrared rays, visible light, ultraviolet rays, far ultraviolet rays, extreme ultraviolet rays (EUV), X-rays, and electron beams can be exemplified. Among them, preferred use is made of far ultraviolet rays with wavelength of preferably 250 nm or less, more preferably 220 nm or less, and still more preferably 1 to 200 nm, such as a KrF excimer laser (248 nm), an ArF excimer laser (193 nm) and an F₂ excimer laser (157 nm), EUV (13 nm) and electron beams.

The application of the composition to the substrate can be preceded by the application of an antireflection film.

As the anti-reflection film, use can be made of not only an inorganic film of titanium, titanium oxide, titanium nitride, chromium oxide, carbon, amorphous silicon or the like but also an organic film composed of a light absorber and a polymer material. Also, as the organic anti-reflection film, use can be made of commercially available organic anti-reflection films, such as the DUV30 Series and DUV40 Series produced by Brewer Science Inc. and AR-2, AR-3 and AR-5 produced by Shipley Co., Ltd.

Generally, an aqueous solution of any of quaternary ammonium salts, a typical example thereof being tetramethylammonium hydroxide, is employed as the alkali developer for use in the development operation. However, other aqueous alkali solutions of an inorganic alkali, a primary amine, a secondary amine, a tertiary amine, an alcoholamine, a cycloamine, etc. can also be employed.

An appropriate amount of alcohol and/or surfactant may be added to the alkali developer.

The alkali concentration of the alkali developer is generally in the range of 0.1 to 20 mass%.

The pH value of the alkali developer is generally in the range of 10.0 to 15.0.

Pure water is used as the rinse liquid. An appropriate amount of surfactant may be added to the rinse liquid before use.

The development operation or rinse operation may be followed by the operation for removing any portion of developer or rinse liquid adhering onto the pattern by use of a supercritical fluid.

A liquid immersion exposure may be carried out for the film produced from the composition of the present invention. Namely, the film may be exposed to actinic rays or radiation under the conditions that the space between the film and a lens is filled with a liquid whose refractive index is higher than that of air. If so, an enhanced resolution can be attained.

The liquid for liquid immersion for use in the liquid immersion exposure will now be described.

The liquid for liquid immersion preferably consists of a liquid being transparent in exposure wavelength whose temperature coefficient of refractive index is as low as possible so as to ensure minimization of any distortion of optical image projected on the resist film. Especially in the use of an ArF excimer laser (wavelength: 193 nm) as an exposure light source, however, it is more preferred to use water from not only the above viewpoints but also the viewpoints of easy procurement and easy handling.

For the attainment of further wavelength shortening, use can be made of a medium whose refractive index is 1.5 or higher. This medium may be an aqueous solution or an organic solvent.

In the use of water as a liquid for liquid immersion, a slight proportion of additive (liquid) that would not dissolve the resist film on a wafer and would be negligible with respect to its influence on an optical coat for an under surface of lens element may be added in order to not only decrease the surface tension of water but also increase a surface activating power.

The additive is preferably an aliphatic alcohol with a refractive index approximately equal to that of water, for example, methyl alcohol, ethyl alcohol, isopropyl alcohol or the like. The addition of an alcohol with a refractive index approximately equal to that of water is advantageous in that even when the alcohol component is evaporated from water to thereby cause a change of content concentration, the change of refractive index of the liquid as a whole can be minimized. On the other hand, when a substance being opaque in 193 nm rays or an impurity whose refractive index is greatly different from that of water is mixed therein, the mixing would invite a distortion of optical image projected on the resist film. Accordingly, it is preferred to use distilled water as the liquid immersion water. Furthermore, use may be made of pure water having been filtered through an ion exchange filter or the like.

Desirably, the electrical resistance of the water is 18.3 MQcm or higher, and the TOC (organic matter concentration) thereof is 20 ppb or below. Prior deaeration of the water is desired.

Raising the refractive index of the liquid for liquid immersion would enable an enhancement of lithography performance. From this viewpoint, an additive suitable for refractive index increase may be added to the water, or heavy water (D₂O) may be used in place of water.

### EXAMPLE

Embodiments of the present invention will be described in greater detail below by way of examples thereof. However, the scope of the present invention is in no way limited to these examples.

### [Examples 1 to 23 and Comparative Examples 1 to 12]

### <Resin (A)>

### (Synthetic Example 1)

Monomers 1, 2 and 3 indicated in the line "resin 1" of Table 2 below were provided in a ratio of 40/10/50 (molar ratio). These were dissolved in cyclohexanone, thereby obtaining 450 g of a solution of 15 mass% solid content. Thereafter, 1 mol% of polymerization initiator V-601 produced by Wako Pure Chemical Industries, Ltd. was added to the solution. The resultant mixture was dropped into 50 g of cyclohexanone heated at 100 °C in a nitrogen atmosphere over a period of 6 hours. After the completion of the dropping, the reaction liquid was agitated for two hours. After the completion of the reaction, the reaction liquid was cooled to room temperature and crystallized in 5 liters of methanol. The thus precipitated white powder was collected by filtration. Thus, a desired resin 1 was recovered.

With respect to this resin, the polymer component ratio determined by NMR was 40/10/50. The standard-polystyrene-equivalent weight average molecular weight determined by GPC measurement was 7800, and the molecular weight dispersity thereof was 1.62.

Other resins 2 to 9 were synthesized in the same manner as described above.

The starting material monomers, repeating unit component ratio, weight average molecular weight and dispersity with respect to each of the resins (A) are summarized in Table 2 below.

**Table 2**

| No. | Monomer 1 | Monomer 2 | Monomer 3 | Monomer 4 | Monomer 5 | Comp. ratio (molar ratio) | Mw | Mw/Mn |
|---|---|---|---|---|---|---|---|---|
| 1 | 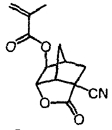 | 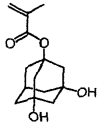 | 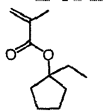 | - | - | 40/10/50 | 7800 | 1.62 |
| 2 | 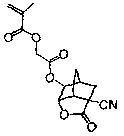 | 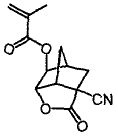 | 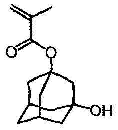 | 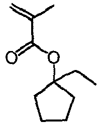 | 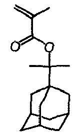 | 20/20/20/20/20 | 7600 | 1.65 |
| 3 * | 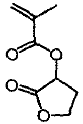 | 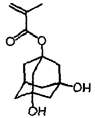 | 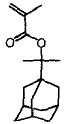 | - | - | 50/10/40 | 9500 | 1.73 |
| 4 * | 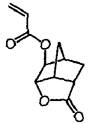 | 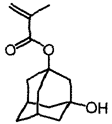 | 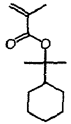 | 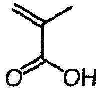 | - | 40/10/40/10 | 7700 | 1.64 |
| 5 * | 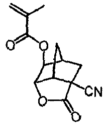 | 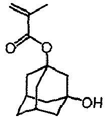 | 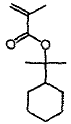 | - | - | 30/20/50 | 8900 | 1.74 |
| 6 * | 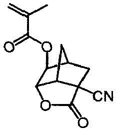 | 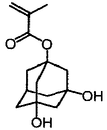 | 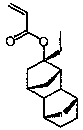 | - | - | 40/15/45 | 8300 | 1.64 |
| 7 * | 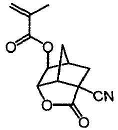 | 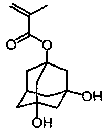 | 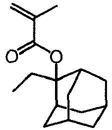 | - | - | 45/15/40 | 8500 | 1.71 |
| 8 | 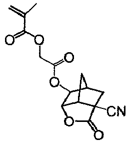 | 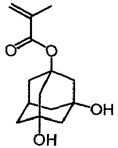 | 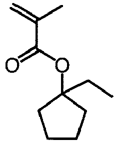 | 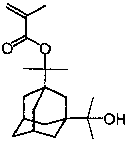 | - | 40/10/20/30 | 9200 | 1.68 |
| 9 * | 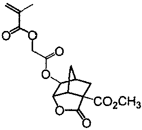 | 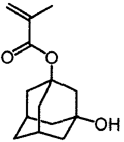 | 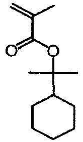 | - | - | 50/10/40 | 9900 | 1.74 |

| | | | | | | | | |
|---|---|---|---|---|---|---|---|---|
| * For Reference | | | | | | | | |

### <Resin (C)>

### (Synthetic Example 2)

The following resins (1) to (14) were provided as the resin (C).

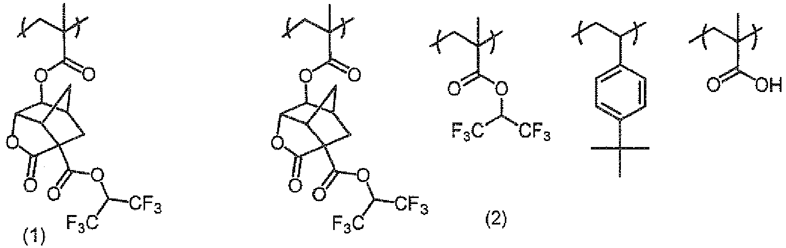

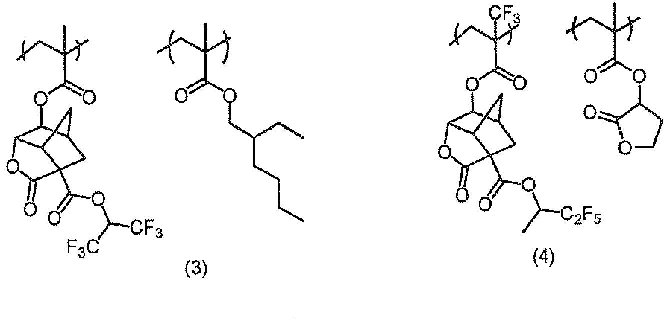

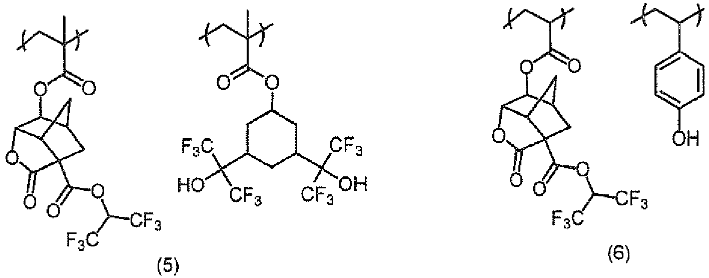

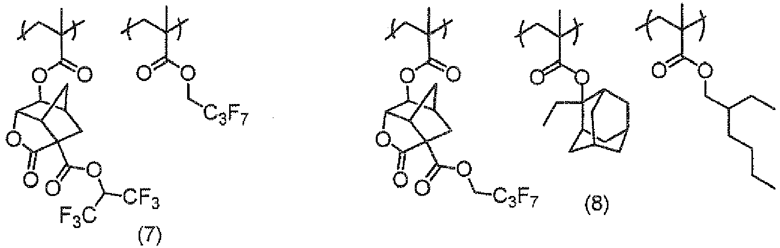

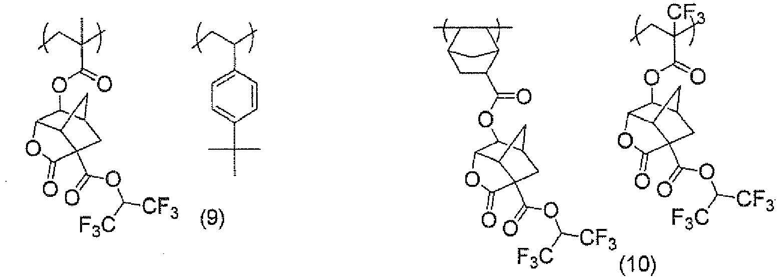

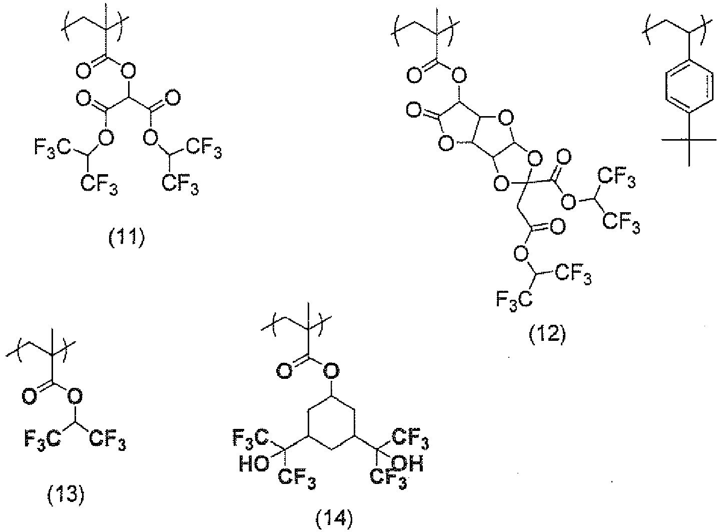

As a synthetic example, the synthesis of resin (3) is described below.

First, the monomers corresponding to the repeating units of resin (3) were provided in a ratio of 95/5 (molar ratio). The monomers were dissolved in PGMEA, thereby obtaining 450 g of a solution of 15 mass% solid content. Thereafter, 1 mol% of polymerization initiator V-601 produced by Wako Pure Chemical Industries, Ltd. was added to the solution. The resultant mixture was dropped into 50 g of PGMEA heated at 100°C in a nitrogen atmosphere over a period of 6 hours. After the completion of the dropping, the reaction liquid was agitated for two hours. After the completion of the reaction, the reaction liquid was cooled to room temperature and crystallized in 5 liters of methanol. The thus precipitated white powder was collected by filtration. Thus, a desired resin (3) was recovered.

The polymer component ratio determined by NMR was 95/5. The standard-polystyrene-equivalent weight average molecular weight determined by GPC measurement was 6200, and the molecular weight dispersity thereof was 1.55.

Other resins (1), (2) and (4) to (14) were synthesized in the same manner as described above.

The repeating unit component ratio, weight average molecular weight and dispersity with respect to each of the resins (C) are summarized in Table 3 below.

**Table 3**

| No. | Comp. ratio (molar ratio) | Mw | Mw/Mn |
|---|---|---|---|
| 1 | 100 | 9700 | 1.45 |
| 2 | 40/20/35/5 | 8200 | 1.38 |
| 3 | 95/5 | 6200 | 1.55 |
| 4 | 50/50 | 8700 | 1.49 |
| 5 | 90/10 | 12200 | 1.43 |
| 6 | 85/15 | 6200 | 1.37 |
| 7 | 80/20 | 9200 | 1.29 |
| 8 | 80/15/5 | 8200 | 1.45 |
| 9 | 80/20 | 9200 | 1.37 |
| 10 | 50/50 | 7700 | 1.44 |
| 11 | 100 | 5700 | 1.38 |
| 12 | 80/20 | 6700 | 1.41 |
| 13 | 100 | 3700 | 1.40 |
| 14 | 100 | 6200 | 1.50 |

### <Photoacid generator>

The following compounds were provided as photoacid generators.

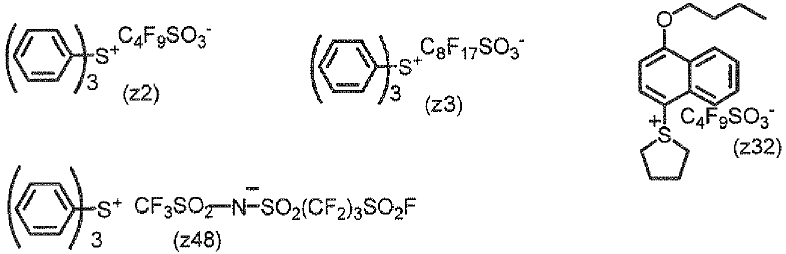

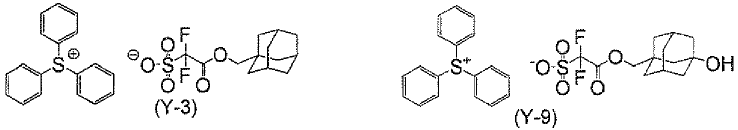

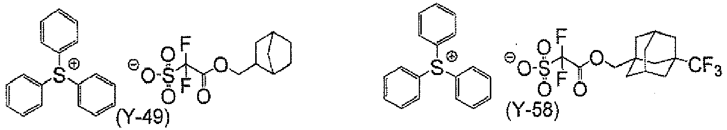

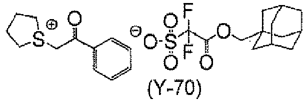

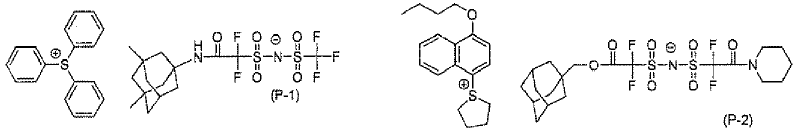

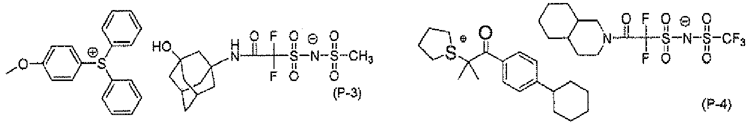

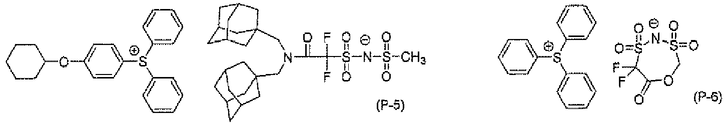

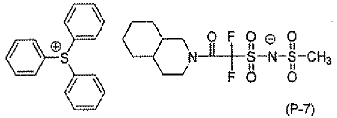

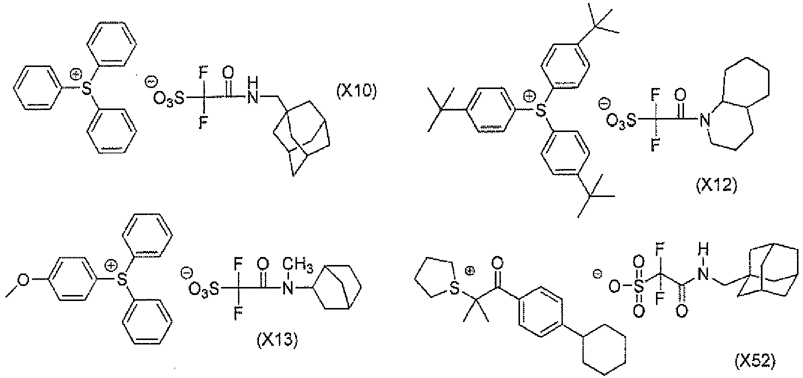

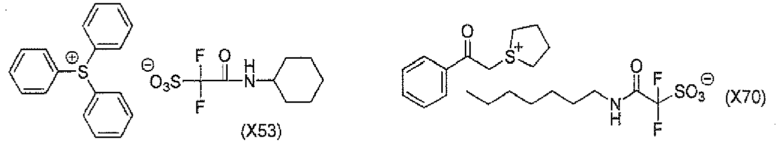

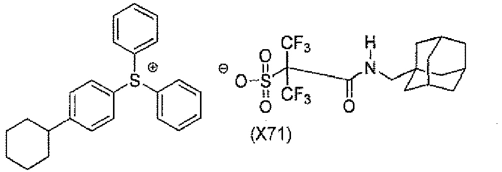

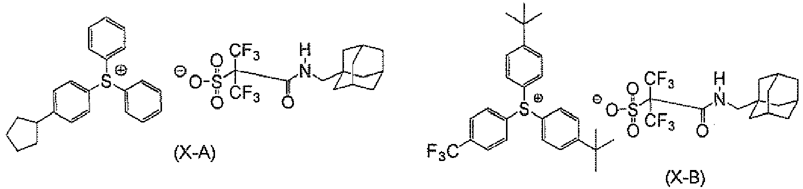

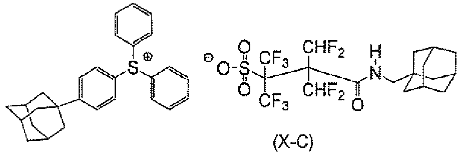

### <Solvent>

The solvents indicated in Table 4 below were provided. Among them, the solvents SL-6 to SL-9 have a normal boiling point of higher than 200°C.

**Table 4**

| Symbol | Name | Boiling point (°C) |
|---|---|---|
| SL-1 | Propylene glycol monomethyl ether acetate | 146 |
| SL-2 | Propylene glycol monomethyl ether | 121 |
| SL-3 | Ethyl lactate | 151 |
| SL-4 | 1-butoxy-2-propanol | 170 |
| SL-5 | Cyclohexanone | 156 |
| SL-6 | γ-butyrolactone | 203 |
| SL-7 | Propylene carbonate | 242 |
| SL-8 | Diethylene glycol monobutyl ether acetate | 245 |
| SL-9 | N-methyl pyrrolidone | 203 |

### <Basic compound>

The following basic compounds were provided.
N-1: N,N-dibutylaniline,
N-2: 2,6-diisopropylaniline, and
N-3: tri-n-octylamine.

### <Surfactant>

The following surfactants were provided.
W-2: Troy Sol S-366 (produced by Troy Chemical Co., Ltd.),
W-2: PF6320 (produced by OMNOVA SOLUTIONS, INC.) and
W-3: polysiloxane polymer KP-341 (produced by Shin-Etsu Chemical Co., Ltd.).

### <Preparation of resist composition>

As listed in Table 5 below, individual components were dissolved in solvents, thereby obtaining solutions of 4 mass% solid content. The solutions were each passed through a polyethylene filter of 0.1 µm pore size, thereby obtaining positive resist compositions. In Table 5, when two or more varieties are used in each of the components, the mass ratio thereof is indicated.

### <Formation of resist pattern>

An organic antireflection film ARC29SR (produced by Nissan Chemical Industries, Ltd.) was applied onto a 12-inch silicon wafer and baked at 205°C for 60 seconds, thereby forming a 78 nm-thick antireflection film. Each of the prepared positive resist compositions was applied thereonto, and baked and dried on a hot plate at 100°C for 60 seconds, thereby forming a 100 nm-thick resist film.

The resultant wafer was exposed through a 6% half-tone mask of 45 nm 1:1 line and space pattern by means of an ArF excimer laser liquid-immersion scanner (manufactured by ASML, XT1700i, NA 1.20) . Ultrapure water was used as the immersion liquid. Thereafter, the exposed wafer was baked on a hot plate at 110°C for 60 seconds, developed with an aqueous tetramethylammonium hydroxide solution of 2.38 mass% concentration at 23°C for 60 seconds, rinsed with pure water for 40 seconds and dried, thereby obtaining a resist pattern.

### [Evaluation of WM (watermark) defect performance]

In the observation of a 45 nm line and space pattern resolved in the optimum exposure amount (exposure amount in which a line and space pattern of 45 nm line width was just resolved in relevant evaluation conditions), random-mode measurement was carried out by means of a defect inspection apparatus KLA2360 manufactured by KLA-Tencor Corporation. In the defect inspection apparatus, the pixel size was set at 0.16 m and the threshold value at 20. Any development defects extracted from differences generated by superimposition between a comparative image and the pixel unit were detected. Thereafter, the development defects were observed by means of SEM Vision G3 (manufactured by Applied Material, Inc.), and the number of WM defects on the wafer was determined. The evaluation marks ⊚, ○, Δ and × were given when the number of WM defects observed on the wafer was 0, 1 to 4, 5 to 9 and 10 or greater, respectively. The smaller this value, the better the WM defect performance exhibited.

### <Evaluation of pattern shape>

In the observation of a 45 nm line and space pattern resolved in the optimum exposure amount, the shape of resist pattern was observed by means of cross-section SEM S4800 (manufactured by Hitachi). The closer to rectangle the shape of resist pattern, the better the shape.

The evaluation results are given in Table 5 below.

**Table 5**

| | | Composition | | | | | | | Amt.of fluorine in photoacid generator (mass%) | | Evaluation | |
|---|---|---|---|---|---|---|---|---|---|---|---|---|
| | | Resin A (2g) | Resin C (50mg) | Photocid generator B1 (mg) | Photocid generator B2 (mg) | Solvent (mass ratio) | Basic compd. (mg) | Surfactant (3mg) | | | Pattern shape | WM defect |
| | | | | | | | | | B1 | B2 | | |
| | Ex.1 | 1 | 1 | Y-58 (160) | - | SL-1/SL-6 (95/5) | N-1 (7) | W-2 | 14.5 | - | Approx. rectangular | ○ |
| | Ex.2 | 2 | 2 | P-1 (230) | - | SL-1/SL-2/SL-6 (80/15/5) | N-2 (11) | W-3 | 12.8 | - | Approx. rectangular | ○ |
| * | Ex.3 | 3 | 3 | P-4 (230) | Y-49 (100) | SL-1/SL-2/SL-6 (70/15/15) | N-3 (6) | W-3 | 10.8 | 7.0 | Approx. rectangular | ⊚ |
| * | Ex. 4 | 4 | 4 | Y-70 (350) | - | SL-1/SL-3/SL-6 (65/30/5) | N-2 (10) | W-3 | 7.2 | - | Rectangular | ⊚ |
| * | Ex. 5 | 5 | 5 | Y-3 (180) | - | SL-1/SL-3/SL-6 (50/30/20) | N-2 (11) | W-1 | 6.5 | - | Rectangular | ⊚ |
| * | Ex. 6 | 6 | 6 | P-2 (260) | Y-9 (100) | SL-1/SL-6 (97/3) | N-1 (7) | W-1 | 9.0 | 6.3 | Rectangular | ⊚ |
| * | Ex.7 | 7 | 7 | X-71 (240) | - | SL-1/SL-3/SL-6 (95/3/2) | N-2 (13) | W-3 | 14.8 | - | Rectangular | ○ |
| | Ex.8 | 8 | 8 | X-52 (200) | Y-3 (80) | SL-1/SL-3/SL-6 (90/5/5) | N-2 (13) | W-3 | 5.9 | 6.5 | Rectangular | ⊚ |
| * | Ex.9 | 9 | 9 | X-53 (160) | - | SL-1/SL-2/SL-6 (80/10/10) | N-2 (10) | W-3 | 7.3 | - | Rectangular | ⊚ |
| | Ex.10 | 1 | 10 | X-10 (180) | - | SL-1/SL-7 (95/5) | N-2 (11) | W-3 | 6.5 | - | Rectangular | ⊚ |
| | Ex.11 | 2 | 1 | P-3 (220) | - | SL-1/SL-2/SL-7 (85/5/10) | N-1 (7) | W-1 | 5.4 | - | Rectangular | ⊚ |
| * | Ex.12 | 3 | 2/3 (25mg/ 25mg) | X-13 (180) | - | SL-1/SL-3/SL-8 (65/20/15) | N-2 (11) | W-3 | 6.6 | - | Rectangular | ○ |
| * | Ex.13 | 4 | 3 | P-6 (160) | - | -SL-1/SL-3/SL-9 (65/20/15) | N-2 (11) | W-1 | 7.4 | - | Rectangular | ○ |
| * | Ex.14 | 5 | 11 | X-12 (230) | - | SL-1/SL-6 (95/5) | N-3 (6) | W-1 | 5.2 | - | Rectangular | ○ |
| * | Ex.15 | 6/7 (1g/1g) | 12 | P-5 (290) | - | SL-1/SL-2/SL-6 (80/15/5) | N-2 (8) | W-1 | 4.1 | - | Rectangular | ○ |
| * | Ex.16 | 7 | 13 | X-70 (300) | - | SL-1/SL-7 (95/5) | N-2 (8) | W-3 | 7.9 | - | Rectangular | ○ |
| | Ex.17 | 8 | 14 | P-7 (210) | - | SL-1/SL-2/SL-7-(85/5/10) | N-1 (7) | W-3 | 5.6 | - | Rectangular | ○ |
| * | Ex.18 | 7 | 7 | X-71 (240) | - | SL-1/SL-3/SL-6 (87/3/10) | N-2 (13) | W-3 | 14.8 | - | Rectangular | ⊚ |
| * | Ex.19 | 7 | 7 | X-A (240) | - | SL-1/SL-2/SL-7 (85/5/10) | N-1 (7) | W-3 | 15.1 | - | Approx. rectangular | ⊚ |
| * | Ex.20 | 7 | 7 | X-B (240) | - | SL-1/SL-2/SL-7 (85/5/10) | N-1 (7) | W-3 | 19.8 | - | Approx. rectangular | ⊚ |
| * | Ex.21 | 7 | 7 | X-C (240) | - | SL-1/SL-2/SL-7 (85/5/10) | N-1 (7) | W-3 | 20.3 | - | Approx. rectangular | ○ |
| * | Ex.22 | 7 | 7 | X-71 (240) | - | SL-1/SL-3/SL-6 (90/5.1/4.9) | N-2 (13) | W-3 | 14.8 | - | Rectangular | ○ |
| * | Ex.23 | 7 | 7 | X-71 (240) | - | SL-1/SL-3/SL-6 (90/5/5) | N-2 (13) | W-3 | 14.8 | - | Rectangular | ⊚ |
| Comp. Ex.1 | | 1 | 1 | z-2 (170) | - | SL-1/SL-2/SL-6 (80/15/5) | N-1 (7) | W-2 | 30.4 | - | Round top | △ |
| Comp. Ex. 2 | | 2 | - | Y-70 (350) | - | SL-1/SL-2/SL-7 (85/5/10) | N-2 (11) | W-3 | 7.2 | - | Round top | △ |
| Comp. Ex.3 | | 3 | - | P-2 (260) | Y-9 (100) | SL-1/SL-6 (95/5) | N-3 (6) | W-3 | 9.0 | 6.3 | Round top | △ |
| Comp. Ex.4 | | 4 | - | X-52 (200) | Y-3 (80) | SL-1/SL-9 (85/15) | N-2 (10) | W-3 | 5.9 | 6.5 | Round top | △ |
| Comp. Ex.5 | | 5 | 2 | Y-58 (160) | - | SL-1/SL-2 (80/20) | N-2 (11) | W-1 | 14.5 | - | Round top | △ |
| Comp. Ex.6 | | 6 | 3 | Y-3 (180) | - | SL-1/SL-2/SL-4 (60/20/20) | N-1 (7) | W-1 | 6.5 | - | Round top | △ |
| Comp. Ex.7 | | 7 | 4 | Y-9 (200) | - | SL-1/SL-2/SL-5 (60/20/20) | N-2 (13) | W-3 | 6.3 | - | Round top | △ |
| Comp. Ex.8 | | 8 | 5 | Y-49 (210) | - | SL-4 (100) | N-2 (13) | W-3 | 7.0 | - | Round top | △ |
| Comp. Ex.9 | | 9 | 6 | P-1 (230) | - | SL-5 (100) | N-2 (10) | W-3 | 12.8 | - | Round top | △ |
| Comp. Ex.10 | | 1 | - | z-3 (230) | - | SL-1 (100) | N-2 (11) | W-3 | 42.4 | - | Film thinning | × |
| Comp. Ex.11 | | 3 | - | z-32 (180) | z-2 (60) | SL-1/SL-5 (50/50) | N-2 (7) | W-3 | 29.2 | 30.4 | Film thinning | × |
| Comp. Ex.12 | | 4 | - | z-48 (230) | - | SL-1/SL-5 (50/50) | N-3 (6) | W-3 | 26.3 | - | Film thinning | × |

As apparent from Table 5, a pattern of good to excellent shape realizing the reduction of WM defects could be formed by employing the resist composition of the present invention.

The composition according to the present invention can find appropriate application as a lithography process in the manufacturing of a variety of electronic devices including semiconductor elements, recording media and the like.

## Claims

1. A resist composition comprising:
(A) a resin that decomposes when acted on by an acid to thereby Increase Its solubility in an alkali developer, wherein the resin has a repeating unit with an acid-decomposable group according to General Formula (AI) below;
(B) a compound according to General Formulae (I) or (II) below that generates an acid when exposed to actinic rays or radiation, the compound having a fluorine content of 0.15 or less when calculated from (total mass of all fluorine atoms contained)/(total mass of all atoms contained);
(C) a resin containing at least either a fluorine atom or a silicon atom; and
(D) a mixed solvent comprising 5 to 20 mass %, based on the mixed solvent, of a solvent exhibiting a normal boiling point of 200°C or higher; 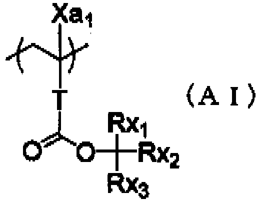
wherein Xa₁ represents a hydrogen atom, an optionally substituted methyl group, or a group represented by -CH₂-R₉;
R₉ represents a hydroxyl group or a monovalent organic group;
T represents a single bond or a bivalent connecting group;
each of Rx₁ to Rx₃ independently represents a linear or branched alkyl group or a monocyclic or polycyclic cycloalkyl group, provided that at least two of Rx₁ to Rx₃ are bonded together to form a monocyclic cycloalkyl group having 5 or 6 carbon atoms; 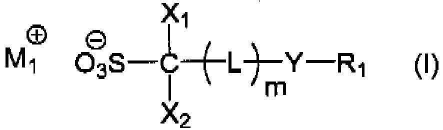
wherein X₁ and X₂ each independently represents a fluorine atom or a fluoroalkyl group;
each L independently represents a bivalent connecting group;
m is an integer of 0 or greater;
Y represents -CO-, -COO-, -OCO-, -CON(R₂)-, -O-, -S-, -SO-, -SO₂-, -OSO₂-,-SO₂O- or a combination of two or more of these;
R₁ and R₂ each independently represents a hydrogen atom, an alkyl group or a group with a cyclic structure, provided that R₁ and R₂ are not both hydrogen atoms, and provided that R₁ and R₂ may be bonded to each other to form a ring, and
M₁⁺ represents a cation; and 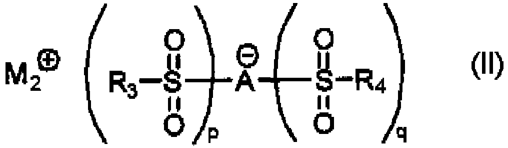
wherein A represents a nitrogen atom or a carbon atom, provided that when A is a nitrogen atom, p+q=2, p is 1 or 2, and q is 0 or 1, and provided that when A is a carbon atom, p+q=3, p is an integer of 1 to 3, and q is an integer of 0 to 2;
R₃ represents a monovalent organic group containing a fluorine atom, the monovalent organic group exhibiting a fluorine content of 0.35 or below when calculated from (total mass of all fluorine atoms contained)/(total mass of all atoms contained), provided that when p≥ 2 a plurality of R₃s may be identical to or different from each other, and provided that in that instance, a plurality of R₃s may be bonded together to form a ring, and provided that when a plurality of R₃s are bonded together to form a ring, the above fluorine content refers to a value calculated with respect to a bivalent group constructing the ring;
R₄ represents a group containing an electron withdrawing group, provided that when q=2, two R₄s may be identical to or different from each other;
when q≥ 1, R₃ and R₄ may be bonded together to form a ring, provided that in that instance, the above fluorine content refers to a value calculated with respect to a bivalent group constructing the ring formed by R₃ and R₄; and
M₂⁺ represents a cation.

2. A composition according to Claim 1, wherein Y is -CON(R₂)- in General Formula (I).

3. A composition according to Claim 1, wherein the mixed solvent (D) contains a solvent according to any of General Formulae (S1) to (S3) below as the solvent exhibiting a normal boiling point of 200°C or higher, 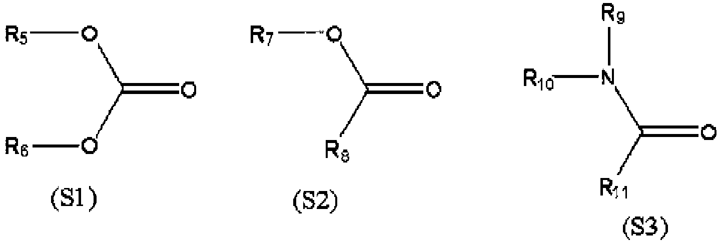 wherein R₅ to R₁₁ each independently represents an alkyl group, a cycloalkyl group or an aryl group, provided that R₅ and R₆, R₇ and R₈, and R₁₀ and R₁₁ may be bonded together to form a ring.

4. A composition according to Claim 1, wherein the resin (C) contains a repeating unit containing a group that when acted on by an alkali developer, is decomposed to thereby increase its solubility in the alkali developer.

5. A composition according to Claim 1, wherein the resin (C) contains a repeating unit containing a partial structure according to General Formula (KY-0): 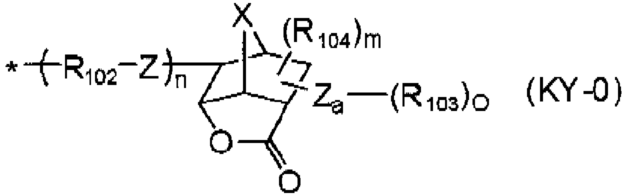
wherein each R₁₀₂ independently represents an alkylene group or a cycloalkylene group;
each R₁₀₃ independently represents a hydrocarbon group whose hydrogen atoms on constituent carbons are partially or entirely replaced with fluorine atoms;
each R₁₀₄ independently represents a halogen atom, a cyano group, a hydroxyl group, an amido group, an alkyl group, a cycloalkyl group, an alkoxy group, a phenyl group, an acyl group, an alkoxycarbonyl group or any of the groups of the formula R-C(=O)- or R-C(=O)O- in which R is an alkyl group or a cycloalkyl group, provided that when m≥ 2, two or more R₁₀₄s may be bonded together to form a ring;
X represents an alkylene group, a cycloalkylene group, an oxygen atom or a sulfur atom;
Z and Za each independently represents a single bond, an ether bond, an ester bond, an amido bond, a urethane bond or a urea bond, provided that when n≥ 2, a plurality of Zs may be identical to or different from each other;
* represents a point of attachment to the principal chain or a side chain of the resin (C);
o is an integer of 1 to 7;
m is an integer of 0 to 7; and
n is an integer of 0 to 5.

6. A composition according to Claim 1, wherein the resin (A) contains a repeating unit with a lactone structure substituted with a cyano group.

7. A resist composition according to Claim 1, wherein the cation M₁⁺ or M₂⁺ in compound (B) is represented by General Formula (ZI-4): 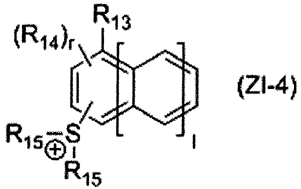
wherein R₁₃ represents a hydrogen atom, a fluorine atom, a hydroxyl group, an alkyl group, a cycloalkyl group, an alkoxy group, an alkoxycarbonyl group or a group with a cycloalkyl skeleton of a single ring or multiple rings;
each R₁₄ independently represents an alkyl group, a cycloalkyl group, an alkoxy group, an alkoxycarbonyl group, an alkylcarbonyl group, an alkylsulfonyl group, a cycloalkylsulfonyl group or a group with a cycloalkyl skeleton of a single ring or multiple rings;
each R₁₅ independently represents an alkyl group, a cycloalkyl group or a naphthyl group, provided that the two R₁₅s may be bonded to each other to thereby form a ring;
l is an integer of 0 to 2; and
r is an integer of 0 to 8.

8. A resist film formed from the composition according to Claim 1.

9. A pattern-forming method comprising:
forming the composition according to Claim 1 into a film;
exposing the film to light; and
developing the exposed film.

10. A method according to Claim 9, wherein the exposure is performed through an immersion liquid.

11. A process for manufacturing an electronic device, wherein the process comprises the pattern-forming method according to Claim 9.

## Patentansprüche

1. Resistzusammensetzung, umfassend:
(A) ein Harz, das abgebaut wird, wenn eine Säure darauf einwirkt, um seine Löslichkeit in einem alkalischen Entwickler zu erhöhen, wobei das Harz eine Widerholungseinheit mit einer Säure-abbaubaren Gruppe gemäß der nachstehenden allgemeinen Formel (AI) aufweist,
(B) eine Verbindung der nachstehenden allgemeinen Formel (I) oder (II), die eine Säure erzeugt, wenn sie aktinischen Strahlen oder Strahlung ausgesetzt ist, wobei die Verbindung einen Fluorgehalt von 0,15 oder weniger, berechnet aus (Gesamtmasse aller enthaltenen Fluoratome)/(Gesamtmasse aller enthaltenen Atome), aufweist,
(C) ein Harz, das mindestens ein Fluoratom oder ein Siliciumatom enthält, und
(D) ein gemischtes Lösungsmittel, das 5 bis 20 Masse-%, bezogen auf das gemischte Lösungsmittel, eines Lösungsmittels umfasst, das einen Normalsiedepunkt von 200°C oder höher aufweist, 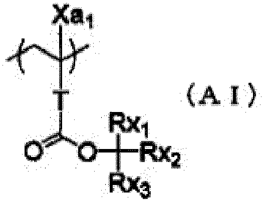
worin Xa₁ ein Wasserstoffatom, eine gegebenenfalls substituierte Methylgruppe oder eine durch -CH₂-R₉ dargestellte Gruppe darstellt,
R₉ eine Hydroxylgruppe oder eine monovalente organische Gruppe darstellt,
T eine Einfachbindung oder eine bivalente Verknüpfungsgruppe darstellt,
jedes von Rx₁ bis Rx₃ unabhängig eine geradkettige oder verzweigte Alkylgruppe oder eine monocyclische oder polycyclische Cycloalkylgruppe darstellt, vorausgesetzt, dass mindestens zwei von Rx₁ bis Rx₃ miteinander verbunden sind, um eine monocyclische Cycloalkylgruppe mit 5 bis 6 Kohlenstoffatomen zu bilden, 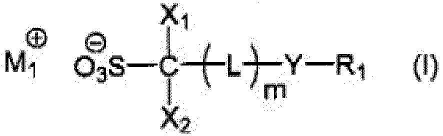
X₁ und X₂ jeweils unabhängig ein Fluoratom oder eine Fluoralkylgruppe darstellen,
jedes L unabhängig eine bivalente Verknüpfungsgruppe darstellt,
m eine ganze Zahl von 0 oder größer ist,
Y -CO-, -COO-, -OCO-, -CON(R₂)-, -O-, -S-, -SO-, -SO₂-, -OSO₂-, -SO₂O- oder eine Kombination von zwei oder mehreren von diesen darstellt,
R₁ und R₂ jeweils unabhängig ein Wasserstoffatom, eine Alkylgruppe oder eine Gruppe mit einer cyclischen Struktur darstellen, vorausgesetzt, dass R₁ und R₂ nicht beide Wasserstoffatome sind und vorausgesetzt, dass R₁ und R₂ aneinander zur Bildung eines Rings gebunden sein können, und
M₁* ein Kation darstellt und 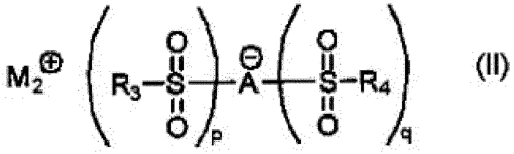
worin A ein Stickstoffatom oder ein Kohlenstoffatom darstellt, vorausgesetzt, dass wenn A ein Stickstoffatom ist, p+q=2 ist, p 1 oder 2 ist und q 0 oder 1 ist, und vorausgesetzt, dass, wenn A ein Kohlenstoffatom ist, p+q=3 ist, p eine ganze Zahl von 1 bis 3 ist und q eine ganze Zahl von 0 bis 2 ist,
R₃ eine monovalente organische Gruppe darstellt, die ein Fluoratom enthält, wobei die monovalente organische Gruppe einen Fluorgehalt von 0,35 oder niedriger, berechnet aus (Gesamtmasse aller enthaltenen Fluoratome)/(Gesamtmasse aller enthaltenen Atome), aufweist, vorausgesetzt, dass wenn p≥2 ist, eine mehrere R₃ identisch oder verschieden voneinander sein können, und vorausgesetzt, dass in diesem Fall eine mehrere R₃ miteinander zur Bildung eines Rings verbunden sein können, und vorausgesetzt, dass, wenn mehrere R₃ miteinander zur Bildung eines Rings verbunden sind, der obige Fluorgehalt sich auf einen Wert bezieht, der in Bezug auf eine bivalente Gruppe, die den Ring konstruiert, berechnet wird,
R₄ eine Gruppe darstellt, die eine Elektronen-ziehende Gruppe enthält, vorausgesetzt, dass, wenn q=2 ist, zwei R₄ identisch oder voneinander verschieden sein können, wenn q≥1 ist, R₃ und R₄ miteinander zur Bildung eines Rings verbunden sein können, vorausgesetzt, dass in diesem Fall der obige Fluorgehalt sich auf einen Wert bezieht, der in Bezug auf eine bivalente Gruppe, die den aus R₃ und R₄ gebildeten Ring konstruiert, berechnet wird, und
M₂⁺ ein Kation darstellt.

2. Zusammensetzung gemäß Anspruch 1, wobei Y -CON(R₂)- in der allgemeinen Formel (I) ist.

3. Zusammensetzung gemäß Anspruch 1, wobei das gemischte Lösungsmittel (D) ein Lösungsmittel gemäß irgendeiner der nachstehenden allgemeinen Formeln (S1) bis (S3) als Lösungsmittel enthält, das einen Normalsiedepunkt von 200°C oder höher aufweist, 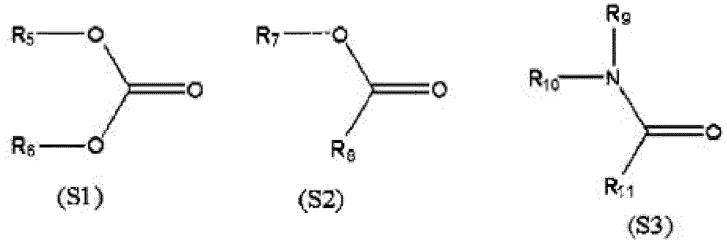 worin R₅ bis R₁₁ jeweils unabhängig eine Alkylgruppe, eine Cycloalkylgruppe oder eine Arylgruppe darstellen, vorausgesetzt, dass R₅ und R₆, R₇ und R₈ und R₁₀ und R₁₁ zur Bildung eines Rings miteinander verbunden sein können.

4. Zusammensetzung gemäß Anspruch 1, wobei das Harz (C) eine Widerholungseinheit enthält, die eine Gruppe enthält, die durch Einwirkung eines alkalischen Entwicklers abgebaut wird, um dadurch seine Löslichkeit in dem alkalischen Entwickler zu erhöhen.

5. Zusammensetzung gemäß Anspruch 1, wobei das Harz (C) eine Widerholungseinheit enthält, die eine Teilstruktur gemäß der allgemeinen Formel (KY-0) enthält: 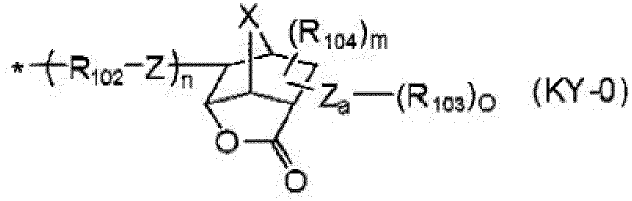
worin jedes R₁₀₂ unabhängig eine Alkylengruppe oder eine Cycloalkylengruppe darstellt,
jedes R₁₀₃ unabhängig eine Kohlenwasserstoffgruppe darstellt, deren Wasserstoffatome an den konstituierenden Kohlenstoffen teilweise oder gänzlich durch Fluoratome ersetzt sind,
jedes R₁₀₄ unabhängig ein Halogenatom, eine Cyanogruppe, eine Hydroxylgruppe, eine Amidogruppe, eine Alkylgruppe, eine Cycloalkylgruppe, eine Alkoxygruppe, eine Phenylgruppe, eine Acylgruppe, eine Alkoxycarbonylgruppe oder eine der Gruppen der Formel R-C(=O)- oder R-C(=O)O-, in der R eine Alkylgruppe oder eine Cycloalkylgruppe ist, darstellt, vorausgesetzt, dass, wenn m≥2 ist, zwei oder mehr R₁₀₄ zur Bildung eines Rings miteinander verbunden sein können,
X eine Alkylengruppe, eine Cycloalkylengruppe, ein Sauerstoffatom oder ein Schwefelatom darstellt,
Z und Za jeweils unabhängig eine Einfachbindung, eine Etherbindung, eine Esterbindung, eine Amidobindung, eine Urethanbindung oder eine Harnstoffbindung darstellen, vorausgesetzt, dass, wenn n≥2 ist, mehrere Z identisch oder voneinander verschieden sein können,
* einen Verknüpfungspunkt an die Hauptkette oder eine Seitenkette des Harzes (C) darstellt,
o eine ganze Zahl von 1 bis 7 ist,
m eine ganze Zahl von 0 bis 7 ist und
n eine ganze Zahl von 0 bis 5 ist.

6. Zusammensetzung gemäß Anspruch 1, wobei das Harz (A) eine Widerholungseinheit mit einer Lactonstruktur enthält, die mit einer Cyanogruppe substituiert ist.

7. Resistzusammensetzung gemäß Anspruch 1, wobei das Kation M₁⁺ oder M₂⁺ in der Verbindung (B) durch die allgemeine Formel (ZI-4) dargestellt ist: 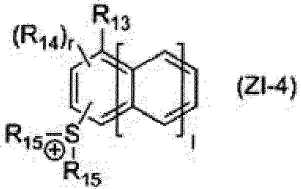
worin R₁₃ ein Wasserstoffatom, ein Fluoratom, eine Hydroxylgruppe, eine Alkylgruppe, eine Cycloalkylgruppe, eine Alkoxygruppe, eine Alkoxycarbonylgruppe oder eine Gruppe mit einem Cycloalkyl-Grundgerüst eines einzelnen Rings oder mehrerer Ringe darstellt,
jedes R₁₄ unabhängig eine Alkylgruppe, eine Cycloalkylgruppe, eine Alkoxygruppe, eine Alkoxycarbonylgruppe, eine Alkylcarbonylgruppe, eine Alkylsulfonylgruppe, eine Cycloalkylsulfonylgruppe oder eine Gruppe mit einem Cycloalkyl-Grundgerüst eines einzelnen Rings oder mehrerer Ringe darstellt,
jedes R₁₅ unabhängig eine Alkylgruppe, eine Cycloalkylgruppe oder eine Naphthylgruppe darstellt, vorausgesetzt, dass zwei R₁₅ aneinander gebunden sein können, um dadurch eine Ring zu bilden,
l eine ganze Zahl von 0 bis 2 ist und
r eine ganze Zahl von 0 bis 8 ist.

8. Resistfilm, der aus der Zusammensetzung gemäß Anspruch 1 gebildet ist.

9. Musterbildungsverfahren, umfassend:
Bilden der Zusammensetzung gemäß Anspruch 1 zu einem Film,
Belichten des Films und
Entwickeln des belichteten Films.

10. Verfahren gemäß Anspruch 9, wobei die Belichtung über eine Immersionsflüssigkeit durchgeführt wird.

11. Verfahren zur Herstellung einer elektronischen Vorrichtung, wobei das Verfahren das Musterbildungsverfahren gemäß Anspruch 9 umfasst.

## Revendications

1. Composition de réserve comprenant :
(A) une résine qui se décompose quand un acide agit dessus pour augmenter ainsi sa solubilité dans un révélateur alcalin, dans laquelle la résine présente un motif répétitif ayant un groupe décomposable par un acide selon la formule générale (AI) ci-dessous ;
(B) un composé selon les formules générales (I) ou (II) ci-dessous qui génère un acide quand il est exposé à un rayonnement ou des rayons actiniques, le composé présentant une teneur en fluor de 0,15 ou moins quand elle est calculée à partir de (masse totale de tous les atomes de fluor contenus)/(masse totale de tous les atomes contenus) ;
(C) une résine contenant au moins un atome de fluor ou un atome de silicium ; et
(D) un solvant mixte comprenant 5 à 20 % en masse, sur la base du solvant mixte, d'un solvant présentant un point d'ébullition normal de 200 °C ou plus ; 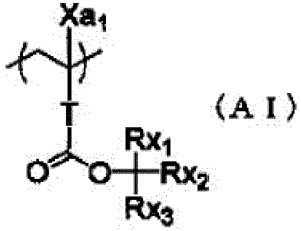
dans laquelle Xa₁ représente un atome d'hydrogène, un groupe méthyle facultativement substitué, ou un groupe représenté par -CH₂-R₉;
R₉ représente un groupe hydroxyle ou un groupe organique monovalent ;
T représente une liaison simple ou un groupe bivalent de liaison ;
chacun parmi Rx₁ à Rx₃ représente indépendamment un groupe alkyle linéaire ou ramifié ou un groupe cycloalkyle monocyclique ou polycyclique, à condition qu'au moins deux parmi Rx₁ à Rx₃ soient liés ensemble pour former un groupe cycloalkyle monocyclique ayant 5 ou 6 atomes de carbone ; 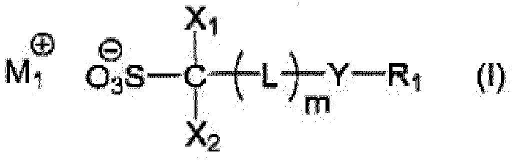
dans laquelle X₁ et X₂ représentent chacun indépendamment un atome de fluor ou un groupe fluoroalkyle ;
chaque L représente indépendamment un groupe bivalent de liaison ;
m est un nombre entier égal à 0 ou plus ;
Y représente -CO-, -COO-, -OCO-, -CON(R₂)-, -O-, -S-, -SO-, -SO₂-, -OSO₂-, -SO₂O- ou une combinaison de deux ou plus de deux de ceux-ci ;
R₁ et R₂ représentent chacun indépendamment un atome d'hydrogène, un groupe alkyle ou un groupe ayant une structure cyclique, à condition que R₁ et R₂ ne soient pas tous les deux des atomes d'hydrogène, et à condition que R₁ et R₂ puissent être liés l'un à l'autre pour former un cycle, et
M₁⁺ représente un cation ; et 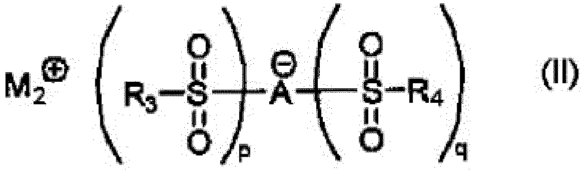
dans laquelle A représente un atome d'azote ou un atome de carbone, à condition que quand A est un atome d'azote, p+q = 2, p est 1 ou 2, et q est 0 ou 1, et à condition que quand A est un atome de carbone, p+q = 3, p est un nombre entier allant de 1 à 3, et q est un nombre entier allant de 0 à 2 ;
R₃ représente un groupe organique monovalent contenant un atome de fluor, le groupe organique monovalent présentant une teneur en fluor de 0,35 ou moins quand elle est calculée à partir de (masse totale de tous les atomes de fluor contenus)/(masse totale de tous les atomes contenus), à condition que quand p ≥ 2 une pluralité de R₃ puissent être identiques les uns aux autres ou différents les uns des autres, et à condition que dans ce cas, une pluralité de R₃ puissent être liés ensemble pour former un cycle, et à condition que quand une pluralité de R₃ sont liés ensemble pour former un cycle, la teneur en fluor ci-dessus fasse référence à une valeur calculée par rapport à un groupe bivalent construisant le cycle ;
R₄ représente un groupe contenant un groupe attracteur d'électrons, à condition que quand q = 2, deux R₄ puissent être identiques l'un à l'autre ou différents l'un de l'autre ;
quand q ≥ 1, R₃ et R₄ peuvent être liés ensemble pour former un cycle, à condition que dans ce cas, la teneur en fluor ci-dessus fasse référence à une valeur calculée par rapport à un groupe bivalent construisant le cycle formé par R₃ et R₄ ; et
M₂⁺ représente un cation.

2. Composition selon la revendication 1, dans laquelle Y est -CON(R₂)- dans la formule générale (I).

3. Composition selon la revendication 1, dans laquelle le solvant mixte (D) contient un solvant selon l'une quelconque des formules générales (S1) à (S3) ci-dessous en tant que solvant présentant un point d'ébullition normal de 200 °C ou plus, 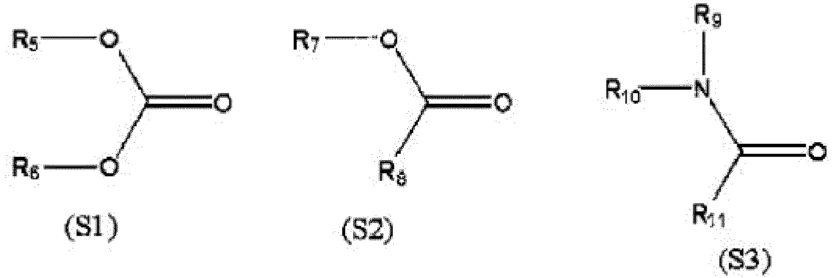 dans lesquelles R₅ à R₁₁ représentent chacun indépendamment un groupe alkyle, un groupe cycloalkyle ou un groupe aryle, à condition que R₅ et R₆, R₇ et R₈, et R₁₀ et R₁₁ puissent être liés ensemble pour former un cycle.

4. Composition selon la revendication 1, dans laquelle la résine (C) contient un motif répétitif contenant un groupe qui quand un révélateur alcalin agit dessus, est décomposé pour augmenter ainsi sa solubilité dans le révélateur alcalin.

5. Composition selon la revendication 1, dans laquelle la résine (C) contient un motif répétitif contenant une structure partielle selon la formule générale (KY-0) : 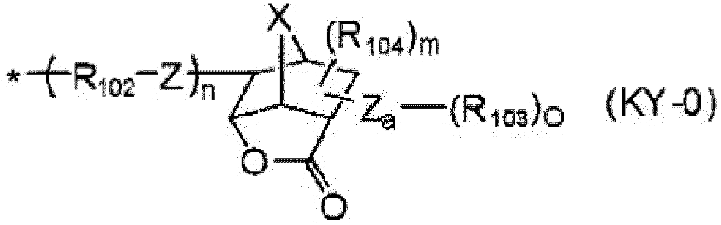
dans laquelle chaque R₁₀₂ représente indépendamment un groupe alkylène ou un groupe cycloalkylène ;
chaque R₁₀₃ représente indépendamment un groupe hydrocarboné dont les atomes d'hydrogène sur les carbones constitutifs sont partiellement ou entièrement remplacés par des atomes de fluor ;
chaque R₁₀₄ représente indépendamment un atome d'halogène, un groupe cyano, un groupe hydroxyle, un groupe amido, un groupe alkyle, un groupe cycloalkyle, un groupe alcoxy, un groupe phényle, un groupe acyle, un groupe alcoxycarbonyle ou l'un quelconque des groupes de formule R-C(=O)- ou R-C(=O)O- dans lesquelles R est un groupe alkyle ou un groupe cycloalkyle, à condition que quand m ≥ 2, deux ou plus de deux R₁₀₄ puissent être liés ensemble pour former un cycle ;
X représente un groupe alkylène, un groupe cycloalkylène, un atome d'oxygène ou un atome de soufre ;
Z et Za représentent chacun indépendamment une liaison simple, une liaison éther, une liaison ester, une liaison amido, une liaison uréthane ou une liaison urée, à condition que quand n ≥ 2, une pluralité de Z puissent être identiques les uns aux autres ou différents les uns des autres ;
* représente un point de fixation à la chaîne principale ou à une chaîne latérale de la résine (C) ;
o est un nombre entier allant de 1 à 7 ;
m est un nombre entier allant de 0 à 7; et
n est un nombre entier allant de 0 à 5.

6. Composition selon la revendication 1, dans laquelle la résine (A) contient un motif répétitif ayant une structure de lactone substituée avec un groupe cyano.

7. Composition de réserve selon la revendication 1, dans laquelle le cation M₁⁺ ou M₂⁺ dans le composé (B) est représenté par la formule générale (ZI-4): 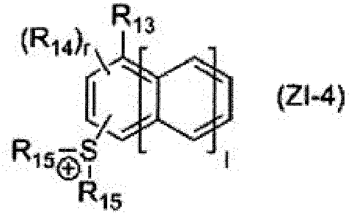
dans laquelle R₁₃ représente un atome d'hydrogène, un atome de fluor, un groupe hydroxyle, un groupe alkyle, un groupe cycloalkyle, un groupe alcoxy, un groupe alcoxycarbonyle ou un groupe ayant un squelette de cycloalkyle d'un seul cycle ou de multiples cycles ;
chaque R₁₄ représente indépendamment un groupe alkyle, un groupe cycloalkyle, un groupe alcoxy, un groupe alcoxycarbonyle, un groupe alkylcarbonyle, un groupe alkylsulfonyle, un groupe cycloalkylsulfonyle ou un groupe ayant un squelette de cycloalkyle d'un seul cycle ou de multiples cycles ;
chaque R₁₅ représente indépendamment un groupe alkyle, un groupe cycloalkyle ou un groupe naphtyle, à condition que deux R₁₅ puissent être liés l'un à l'autre pour former ainsi un cycle ;
I est un nombre entier allant de 0 à 2; et
r est un nombre entier allant de 0 à 8.

8. Film de réserve formé à partir de la composition selon la revendication 1.

9. Procédé de formation de motif comprenant :
la formation de la composition selon la revendication 1 en un film ;
l'exposition du film à une lumière ; et
le développement du film exposé.

10. Procédé selon la revendication 9, dans lequel l'exposition est effectuée par l'intermédiaire d'un liquide d'immersion.

11. Processus pour fabriquer un dispositif électronique, dans lequel le processus comprend le procédé de formation de motif selon la revendication 9.
